(19) Europäisches Patentamt
European Patent Office
Office européen des brevets

(11) **EP 4 778 950 A1**

(12) **EUROPEAN PATENT APPLICATION**
published in accordance with Art. 153(4) EPC

(43) Date of publication:
**22.07.2026 Bulletin 2026/30**

(21) Application number: **24865528.4**

(22) Date of filing: **12.09.2024**

(51) International Patent Classification (IPC):
***C08F 290/06*** (2006.01) ***B32B 15/08*** (2006.01)
***B32B 27/30*** (2006.01) ***C08F 257/00*** (2006.01)
***C08G 65/48*** (2006.01) ***C08J 5/24*** (2006.01)
***C08L 25/02*** (2006.01) ***C08L 101/00*** (2006.01)
***H05K 1/03*** (2006.01)

(52) Cooperative Patent Classification (CPC):
**B32B 15/08; B32B 27/30; C08F 257/00; C08F 290/06; C08G 65/48; C08J 5/24; C08L 25/02; C08L 101/00; H05K 1/03**

(86) International application number:
**PCT/JP2024/032726**

(87) International publication number:
**WO 2025/058028 (20.03.2025 Gazette 2025/12)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **13.09.2023 JP 2023148180**
**22.04.2024 JP 2024069053**

(71) Applicant: **MITSUBISHI GAS CHEMICAL COMPANY, INC.**
**Chiyoda-ku**
**Tokyo 100-8324 (JP)**

(72) Inventors:
- **MIYAMOTO Makoto**
  **Tokyo 125-8601 (JP)**
- **HIGASHITA Kazuyuki**
  **Tokyo 125-8601 (JP)**
- **FUTAMURA Keisuke**
  **Tokyo 125-8601 (JP)**
- **HORIE Shigeru**
  **Tokyo 100-8324 (JP)**
- **HIDA Kenji**
  **Tokyo 125-8601 (JP)**

(74) Representative: **Müller-Boré & Partner Patentanwälte PartG mbB**
**Friedenheimer Brücke 21**
**80639 München (DE)**

(54) **RESIN COMPOSITION, CURED PRODUCT, PREPREG, METAL-FOIL-CLAD LAMINATE, RESIN COMPOSITE SHEET, PRINTED CIRCUIT BOARD, AND SEMICONDUCTOR DEVICE**

(57) Disclosed is a resin composition including: a resin (A) having a terminal group represented by Formula (T1) and having an indane skeleton; a compound (B) having a polymerizable carbon-carbon unsaturated double bond and having a number average molecular weight of 400 or less; and a thermosetting compound (C) having a number average molecular weight of more than 400 (however, the compound (B) and the compound (C) are not compounds corresponding to the resin (A)). In Formula (T1), each Ma independently represents a hydrocarbon group having 1 to 12 carbon atoms, each carbon atom being substituted with a halogen atom, and x represents an integer of from 0 to 4. * represents a bonding position for another moiety. Disclosed are a cured product using the resin composition, a prepreg, a metal foil-clad laminate, a resin composite sheet, a printed wiring board, and a semiconductor device.

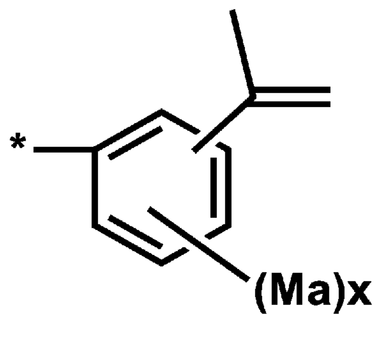
(T1)

EP 4 778 950 A1

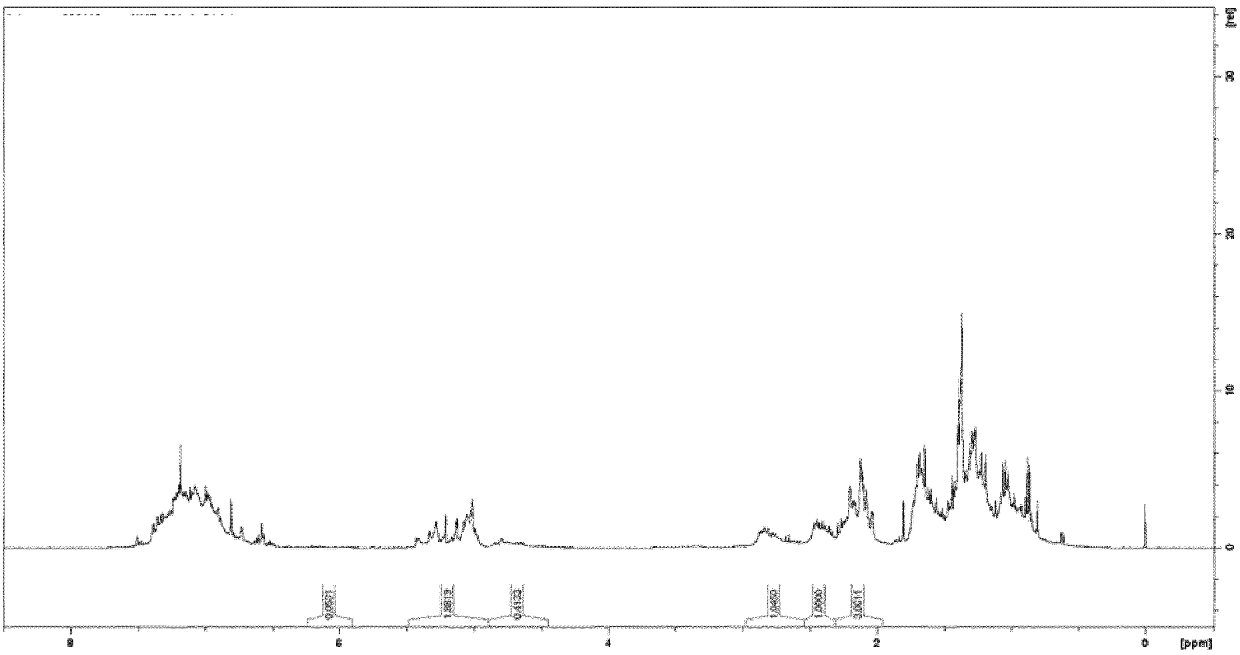

FIG. 1

## Description

### Technical Field

The present invention relates to a resin composition, a cured product, a prepreg, a metal foil-clad laminate, a resin composite sheet, a printed wiring board, and a semiconductor device.

### Background Art

In recent years, a trend for higher integration and finer configuration has been accelerated for semiconductor devices that are used in electronic devices and communication devices, including mobile terminals. Along with this trend, a technology that enables high-density mounting of semiconductor devices is required, and an improvement is also required for printed wiring boards, which hold an important role in the technology.

On the other hand, applications of electronic devices are diversified and continuously expanding. Accordingly, properties required for printed wiring boards, and metal foil-clad laminates, prepregs, and the like used in the printed wiring boards have also been diversified, and the requirements have become more demanding. To obtain improved printed wiring boards in consideration of such requirements, various materials and processing methods have been proposed. One of these includes development to improve a resin material included in a prepreg or a resin composite sheet.

Patent Document 1 discloses a resin having an isopropenylphenyl group at a terminal and an indane skeleton as a material suitable for a semiconductor sealing material and a printed wiring board.

### Citation List

### Patent Document

Patent Document 1: JP 2021-143333 A

### Summary of Invention

### Technical Problem

However, when the resin having an indane skeleton described in Patent Document 1 is used as it is, the resin is not sufficiently cured, and there is a problem in moldability of a cured product.

As a material suitable for the printed wiring board, excellent thermal resistance over time (maintenance of low dielectric properties) is required in addition to low dielectric properties (Dk and/or Df, in particular Df).

The present invention is intended to solve such an issue, and an object of the present invention is to provide a resin composition which is excellent in low dielectric properties (Dk and/or Df, in particular Df) and thermal resistance over time when formed into a cured product, a cured product, a prepreg, a metal foil-clad laminate, a resin composite sheet, a printed wiring board, and a semiconductor device.

### Solution to Problem

In view of the above problems, the present inventors have conducted studies, and resultantly found that the above problems can be solved by blending a compound having a polymerizable carbon-carbon unsaturated double bond and a number average molecular weight of 400 or less in addition to a resin having a predetermined indane skeleton and a thermosetting compound.

Specifically, the above-described problems have been solved by the following means.

<1> A resin composition including:

a resin (A) having a terminal group represented by Formula (T1) and having an indane skeleton;
a compound (B) having a polymerizable carbon-carbon unsaturated double bond and having a number average molecular weight of 400 or less;
a thermosetting compound (C) having a number average molecular weight of more than 400, the compound (B) and the compound (C) not being compounds corresponding to the resin (A),

[Chem.1]

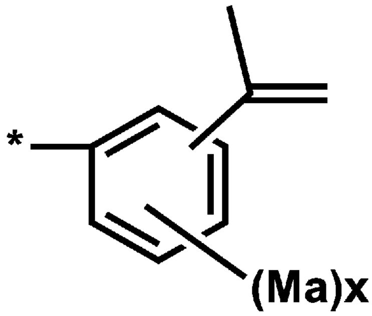

(T1)

(where each Ma independently represents a hydrocarbon group having 1 to 12 carbon atoms, each carbon atom being optionally substituted with a halogen atom, and x represents an integer of from 0 to 4, * represents a bonding position for another moiety.)

<2> The resin composition according to <1>, wherein the resin (A) includes a resin represented by Formula (T1-1):

[Chem.2]

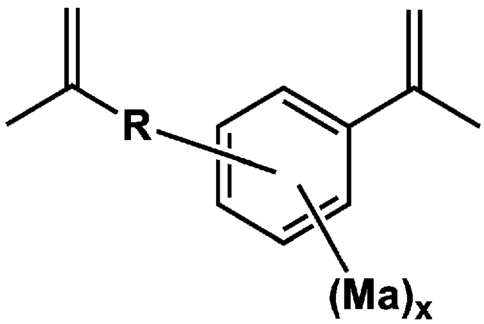

(T1-1)

(where R is a group including a structural unit represented by Formula (Tx), each Ma independently represents a hydrocarbon group having from 1 to 12 carbon atoms, each carbon atom being optionally substituted with a halogen atom, and x is an integer of from 0 to 4.)

[Chem.3]

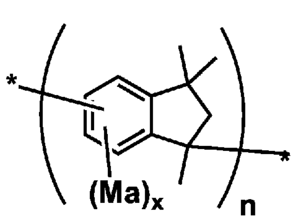

(a)

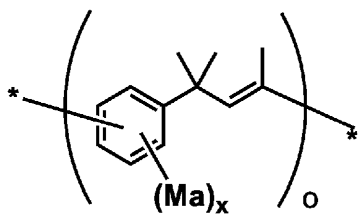

(b)

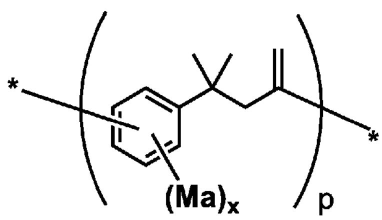

(c)

(Tx)

(where n, o, and p are average numbers of repeating units, n represents a number of more than 0 and 20 or less, o and p each independently represent a number of from 0 to 20, and $1.0 \leq n + o + p \leq 20.0$, each Ma independently represents a hydrocarbon group having from 1 to 12 carbon atoms, each carbon atom being optionally substituted with a halogen atom, x represents an integer of from 0 to 4, the structural units (a), (b), and (c) are each bonded at * to the structural unit (a), (b), or (c), or an additional group, and structural units are optionally randomly bonded.)

<3> The resin composition according to <1> or <2>, wherein an equivalent of the polymerizable carbon-carbon unsaturated double bond of the compound (B) is from 50 to 400 g/eq.

<4> The resin composition according to any one of <1> to <3>, wherein the number average molecular weight of the compound (B) is from 100 to 400, and the number of polymerizable carbon-carbon unsaturated double bonds in one molecule of the compound (B) is 1 or 2.

<5> The resin composition according to any one of <1> to <4>, wherein the polymerizable carbon-carbon unsaturated

double bond in the compound (B) is at least one selected from the group consisting of a vinyl group, a (meth)allyl group, a (meth)acryloyl group, a vinylene group, and a maleimide group.

<6> The resin composition according to any one of <1> to <5>, wherein the compound (B) includes at least one selected from the group consisting of divinylbenzene, acenaphthylene, dicyclopentadiene type bifunctional (meth) acrylate, 1,2-bis(4-vinylphenyl)ethane, 4-tert-butylstyrene, and 4-methylstyrene.

<7> The resin composition according to any one of <1> to <6>, wherein the compound (C) is a compound having a number average molecular weight of more than 400 and includes at least one selected from the group consisting of a maleimide compound, a polymer having a structural unit represented by Formula (V), a polyphenylene ether compound having a carbon-carbon unsaturated double bond at a terminal, an epoxy compound, a phenolic compound, a benzoxazine compound, and a cyanate ester compound,

[Chem.4]

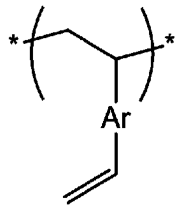

(V)

(where Ar represents an aromatic hydrocarbon linking group; and * represents a bonding position.)

<8> The resin composition according to any one of <1> to <6>, wherein the compound (C) is a compound having a number average molecular weight of more than 400 and includes at least one selected from the group consisting of a maleimide compound, a polymer having a structural unit represented by Formula (V), a polyphenylene ether compound having a carbon-carbon unsaturated double bond at a terminal, an epoxy compound, a phenolic compound, a benzoxazine compound, a cyanate ester compound, and a polyfunctional (meth)acrylate compound other than the polyphenylene ether compound having a carbon-carbon unsaturated double bond at a terminal,

[Chem.5]

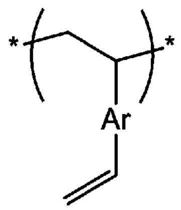

(V)

(where Ar represents an aromatic hydrocarbon linking group; and and * represents a bonding position.)

<9> The resin composition according to any one of <1> to <6>, wherein the compound (C) is a compound having a number average molecular weight of more than 400 and includes at least one selected from the group consisting of a compound represented by Formula (M0), a compound represented by Formula (M1), a compound represented by Formula (M3), a compound represented by Formula (M4), a compound represented by Formula (M5), a polymer having a structural unit represented by Formula (V), and a compound represented by Formula (OP),

[Chem.6]

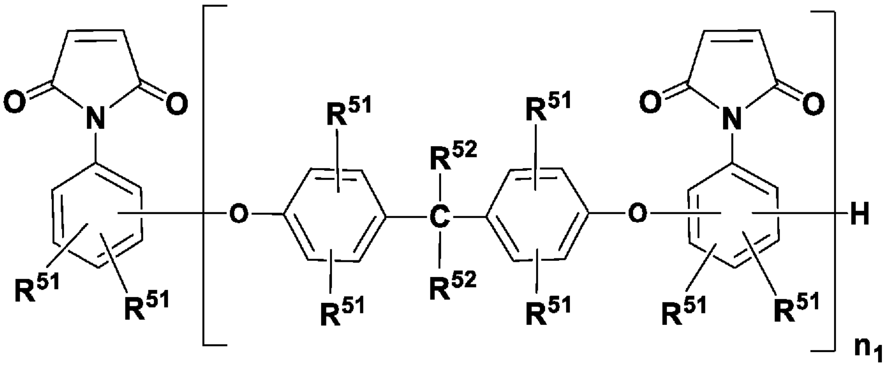

(M0)

(where each $R^{51}$ independently represents a hydrogen atom, an alkyl group having from 1 to 8 carbon atoms, or a phenyl group; each $R^{52}$ independently represents a hydrogen atom or a methyl group; and $n_1$ represents an integer of 1 or more.)

[Chem.7]

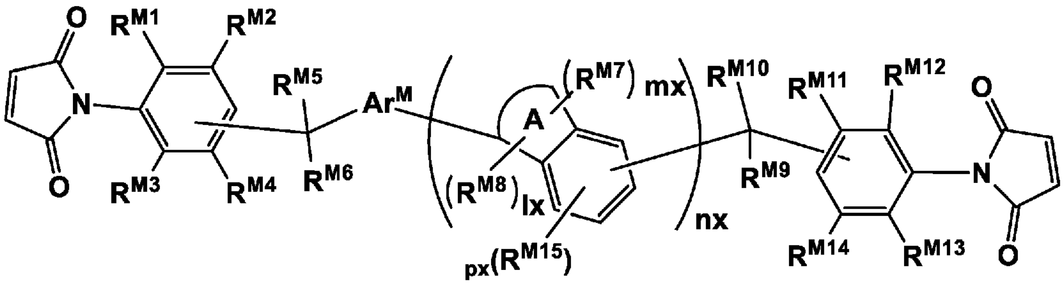

(M1)

(where $R^{M1}$, $R^{M2}$, $R^{M3}$, and $R^{M4}$ each independently represent a hydrogen atom or an organic group, $R^{M5}$ and $R^{M6}$ each independently represent a hydrogen atom or an alkyl group, $Ar^{M}$ represents a divalent aromatic group, A is a four- to six-membered alicyclic group, $R^{M7}$ and $R^{M8}$ are each independently an alkyl group, mx is 1 or 2, and lx is 0 or 1, $R^{M9}$ and $R^{M10}$ each independently represent a hydrogen atom or an alkyl group, $R^{M11}$, $R^{M12}$, $R^{M13}$, and $R^{M14}$ each independently represent a hydrogen atom or an organic group, each $R^{M15}$ independently represents an alkyl group having from 1 to 10 carbon atoms, an alkyloxy group having from 1 to 10 carbon atoms, an alkylthio group having from 1 to 10 carbon atoms, a cycloalkyl group having from 3 to 10 carbon atoms, an aryl group having from 6 to 10 carbon atoms, an aryloxy group having from 6 to 10 carbon atoms, an arylthio group having from 6 to 10 carbon atoms, a halogen atom, a hydroxyl group, or a mercapto group, px represents an integer of from 0 to 3, nx represents an integer of from 1 to 20.)

[Chem.8]

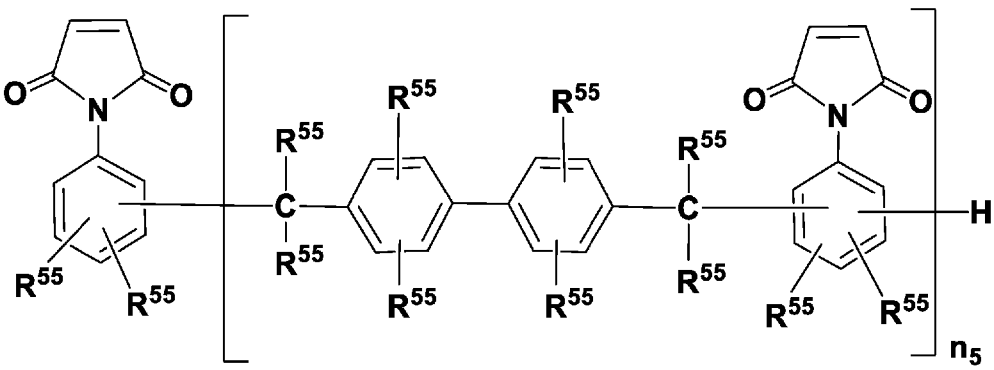

(M3)

(where each $R^{55}$ independently represents a hydrogen atom, an alkyl group having from 1 to 8 carbon atoms, or a phenyl group; and $n_5$ represents an integer of 1 or more and 10 or less.)

[Chem.9]

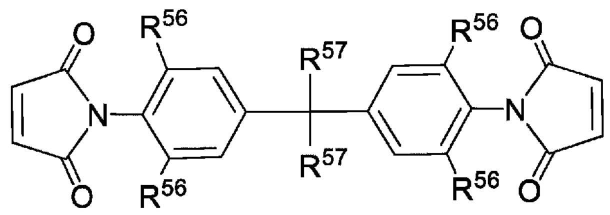

(M4)

(where each $R^{56}$ independently represents a hydrogen atom, a methyl group, or an ethyl group, and each $R^{57}$ independently represents a hydrogen atom or a methyl group.)

[Chem.10]

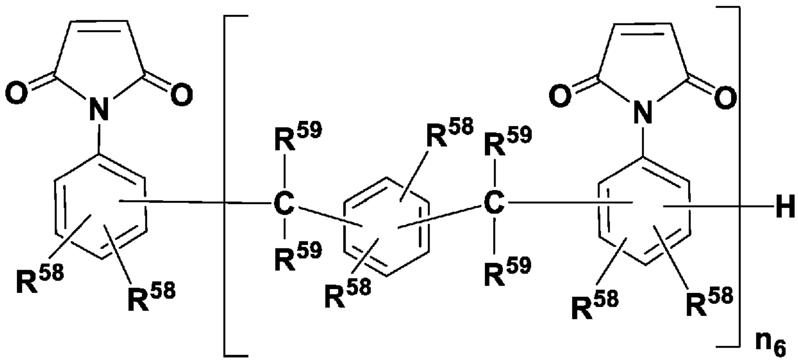

(M5)

(where each $R^{58}$ independently represents a hydrogen atom, an alkyl group having from 1 to 8 carbon atoms, or a phenyl group; each $R^{59}$ independently represents a hydrogen atom or a methyl group; and $n_6$ represents an integer of 1 or more.)

[Chem.11]

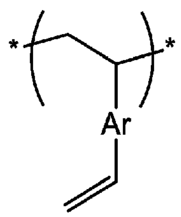

(V)

(where Ar represents an aromatic hydrocarbon linking group, and * represents a bonding position.)

[Chem.12]

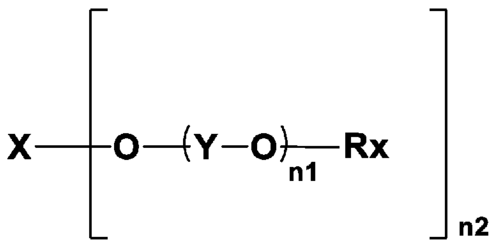

(OP)

(where X represents an aromatic group; $-(Y-O)_{n1}-$ represents a polyphenylene ether structure; $n_1$ represents an integer of from 1 to 100; n2 represents an integer of from 1 to 4; and Rx is a group represented by Formula (Rx-1) or Formula (Rx-2).)

[Chem.13]

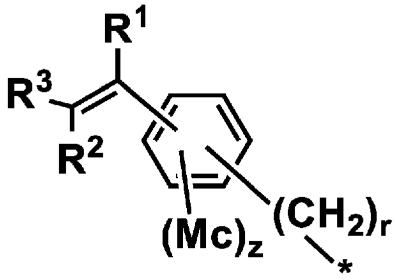

(Rx-1)

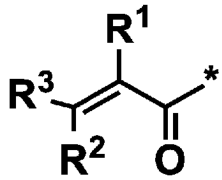

(Rx-2)

(where $R^1$, $R^2$, and $R^3$ each independently represent a hydrogen atom, an alkyl group, an alkenyl group, or an alkynyl group, * is a bonding position for an oxygen atom, each Mc independently represents a hydrocarbon group having from 1 to 12 carbon atoms, z represents an integer of from 0 to 4, and r represents an integer of from 0 to 6.)

<10> The resin composition according to any one of <1> to <9>, wherein with respect to 100 parts by mass of the resin (A), from 5 to 500 parts by mass of the compound (B) and from 10 to 1000 parts by mass of the compound (C) are included.

<11> The resin composition according to any one of <1> to <10>, wherein the resin (A) includes a resin represented by Formula (T1-1),

an equivalent of the polymerizable carbon-carbon unsaturated double bond of the compound (B) is from 50 to 400 g/eq.,

the number average molecular weight of the compound (B) is from 100 to 400,

the number of polymerizable carbon-carbon unsaturated double bonds in one molecule of the compound (B) is 1 or 2,

the compound (C) is a compound having a number average molecular weight of more than 400 and includes at least one selected from the group consisting of a maleimide compound, a polymer having a structural unit represented by Formula (V), a polyphenylene ether compound having a carbon-carbon unsaturated double bond at a terminal, an epoxy compound, a phenolic compound, a benzoxazine compound, and a cyanate ester compound, and

with respect to 100 parts by mass of the resin (A), from 5 to 500 parts by mass of the compound (B) and from 10 to 1000 parts by mass of the compound (C) are included,

[Chem.14]

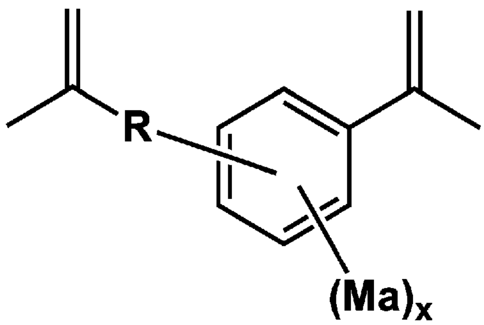

(T1-1)

(where R is a group including a structural unit represented by Formula (Tx), each Ma independently represents a hydrocarbon group having from 1 to 12 carbon atoms, each carbon atom being optionally substituted with a halogen atom, and x is an integer of from 0 to 4.)

[Chem.15]

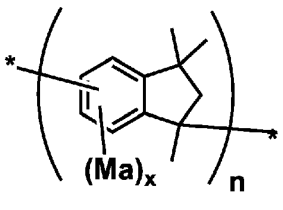
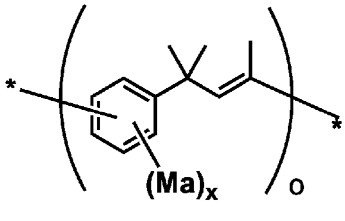
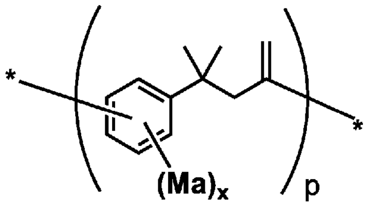

(Tx)

(a) (b) (c)

(where n, o, and p are average numbers of repeating units, n represents a number of more than 0 and 20 or less, o and p each independently represent a number of from 0 to 20, and $1.0 \leq n + o + p \leq 20.0$, each Ma independently represents a hydrocarbon group having from 1 to 12 carbon atoms, each carbon atom being optionally substituted with a halogen atom, x represents an integer of from 0 to 4, the structural units (a), (b), and (c) are each bonded at * to the structural unit (a), (b), or (c), or an additional group, and structural units are optionally randomly bonded.)

[Chem.16]

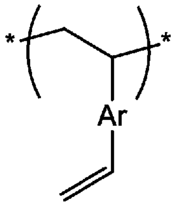

(V)

(where Ar represents an aromatic hydrocarbon linking group; and and * represents a bonding position.)

<12> The resin composition according to any one of <1> to <11>, wherein the compound (B) includes at least one selected from the group consisting of divinylbenzene, acenaphthylene, dicyclopentadiene type bifunctional (meth)acrylate, 1,2-bis(4-vinylphenyl)ethane, 4-tert-butylstyrene, and 4-methylstyrene.

<13> The resin composition according to any one of <1> to <12>, wherein the compound (C) is a compound having a number average molecular weight of more than 400 and includes at least one selected from the group consisting of a compound represented by Formula (M0), a compound represented by Formula (M1), a compound represented by Formula (M3), a compound represented by Formula (M4), a compound represented by Formula (M5), a polymer having a structural unit represented by Formula (V), and a compound represented by Formula (OP),

[Chem.17]

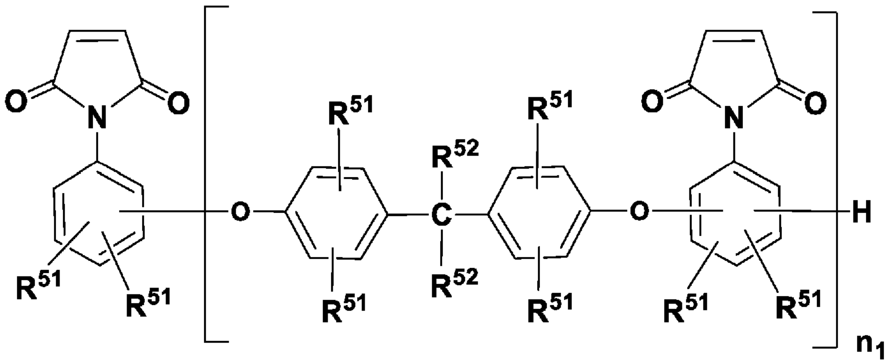

(M0)

(where each $R^{51}$ independently represents a hydrogen atom, an alkyl group having from 1 to 8 carbon atoms, or a phenyl group; each $R^{52}$ independently represents a hydrogen atom or a methyl group; and $n_1$ represents an integer of 1 or more.)

[Chem.18]

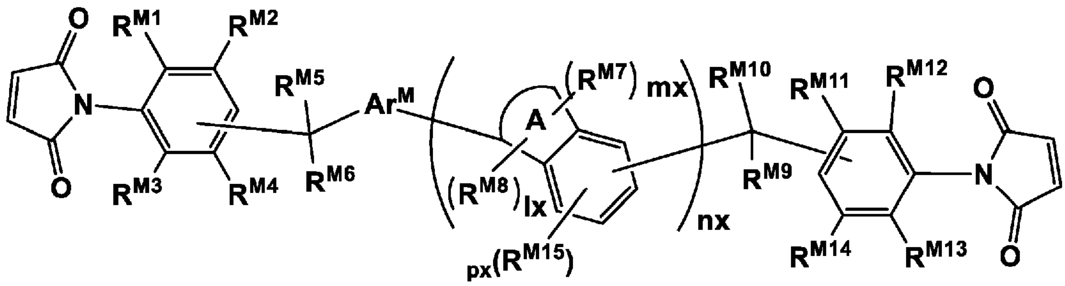

(M1)

(where $R^{M1}$, $R^{M2}$, $R^{M3}$, and $R^{M4}$ each independently represent a hydrogen atom or an organic group, $R^{M5}$ and $R^{M6}$ each independently represent a hydrogen atom or an alkyl group, $Ar^M$ represents a divalent aromatic group, A is a four- to six-membered alicyclic group, $R^{M7}$ and $R^{M8}$ are each independently an alkyl group, mx is 1 or 2, and lx is 0 or 1, $R^{M9}$ and $R^{M10}$ each independently represent a hydrogen atom or an alkyl group, $R^{M11}$, $R^{M12}$,$R^{M13}$, and $R^{M14}$ each independently represent a hydrogen atom or an organic group, each $R^{M15}$ independently represents an alkyl group having from 1 to 10 carbon atoms, an alkyloxy group having from 1 to 10 carbon atoms, an alkylthio group having from 1 to 10 carbon atoms, a cycloalkyl group having from 3 to 10 carbon atoms, an aryl group having from 6 to 10 carbon atoms, an aryloxy group having from 6 to 10 carbon atoms, an arylthio group having from 6 to 10 carbon atoms, a halogen atom, a hydroxyl group, or a mercapto group, px represents an integer of from 0 to 3, and nx represents an integer of from 1 to 20.)

[Chem.19]

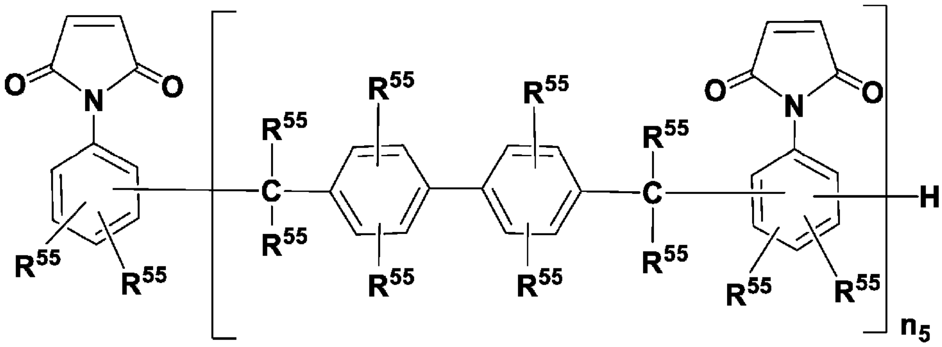

(M3)

(where each $R^{55}$ independently represents a hydrogen atom, an alkyl group having from 1 to 8 carbon atoms, or a phenyl group; and $n_5$ represents an integer of 1 or more and 10 or less.)

[Chem.20]

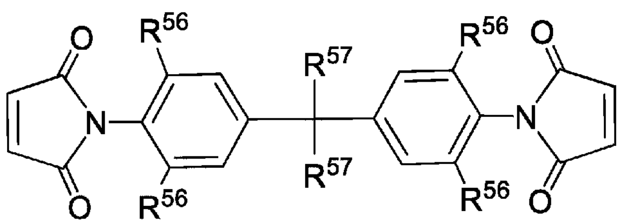

(M4)

(where each $R^{56}$ independently represents a hydrogen atom, a methyl group, or an ethyl group, and each $R^{57}$ independently represents a hydrogen atom or a methyl group.)

[Chem.21]

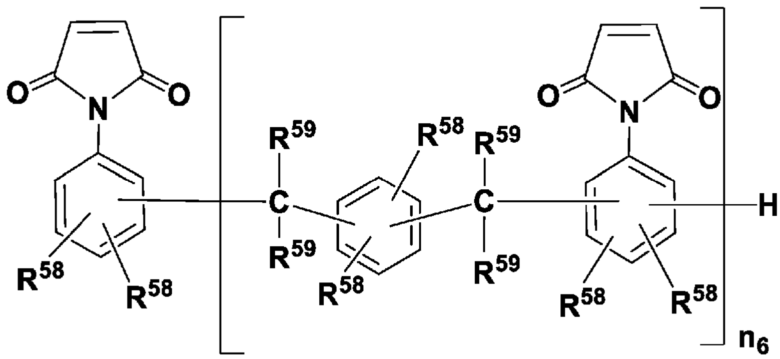

(M5)

(where each $R^{58}$ independently represents a hydrogen atom, an alkyl group having from 1 to 8 carbon atoms, or a phenyl group; each $R^{59}$ independently represents a hydrogen atom or a methyl group; and $n_6$ represents an integer of 1 or more.)

[Chem.22]

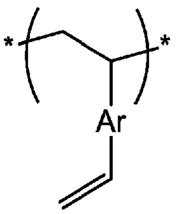

(V)

(where Ar represents an aromatic hydrocarbon linking group, and * represents a bonding position.)

[Chem.23]

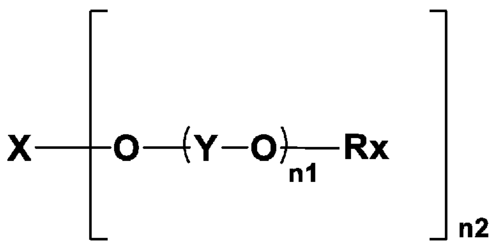

(OP)

(where X represents an aromatic group; $-(Y-O)_{n1}-$ represents a polyphenylene ether structure; $n_1$ represents an integer of from 1 to 100; n2 represents an integer of from 1 to 4; and Rx is a group represented by Formula (Rx-1) or Formula (Rx-2).)

[Chem.24]

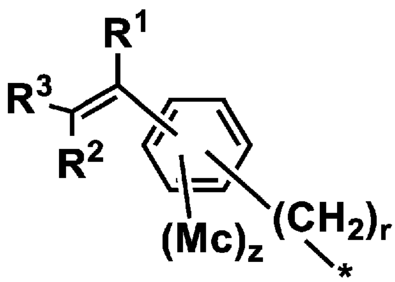

(Rx-1)

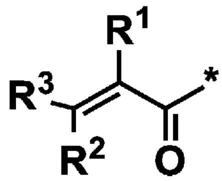

(Rx-2)

(where $R^1$, $R^2$, and $R^3$ each independently represent a hydrogen atom, an alkyl group, an alkenyl group, or an alkynyl group, * is a bonding position for an oxygen atom, each Mc independently represents a hydrocarbon group having

from 1 to 12 carbon atoms, z represents an integer of from 0 to 4, and r represents an integer of from 0 to 6.)
<14> The resin composition according to any one of <1> to <13>, further including an elastomer.
<15> The resin composition according to any one of <1> to <14>, further including a flame retardant.
<16> The resin composition according to any one of <1> to <15>, further including a filler.
<17> The resin composition according to <16>, wherein a content of the filler is from 10 to 1600 parts by mass with respect to 100 parts by mass of a resin solid content in the resin composition.
<18> The resin composition according to any one of <1> to <17>, further including a curing accelerator.
<19> The resin composition according to <18>, wherein a content of the curing accelerator is from 0.1 to 0.8 parts by mass with respect to 100 parts by mass of a resin solid content in the resin composition.
<20> A cured product of the resin composition described in any one of <1> to <19>.
<21> A prepreg formed from a substrate and the resin composition described in any one of <1> to <19>.
<22> A metal foil-clad laminate including:

at least one layer formed from the prepreg described in <21>; and
a metal foil disposed on one surface or both surfaces of the layer formed from the prepreg.

<23> A resin composite sheet including: a support; and a layer disposed on a surface of the support, the layer being formed from the resin composition described in any one of <1> to <19>.
<24> A printed wiring board including an insulating layer and a conductor layer disposed on a surface of the insulating layer, wherein the insulating layer includes a layer formed from the resin composition described in any one of <1> to <19>.
<25> A semiconductor device including the printed wiring board described in <24>.

## Advantageous Effects of Invention

The present invention has made it possible to provide a resin composition excellent in low dielectric properties (Dk and/or Df, in particular Df) and thermal resistance over time, a cured product, a prepreg, a metal foil-clad laminate, a resin composite sheet, a printed wiring board, and a semiconductor device.

## Brief Description of Drawings

[FIG. 1] illustrates an NMR chart of a resin obtained in Synthesis Example 1.

## Description of Embodiments

Embodiments for carrying out the present invention (hereinafter referred to simply as "the present embodiment") will next be described in detail. The present embodiment described below is an example for describing the present invention, and the present invention is not limited only to the present embodiment.
In the present specification, numerical values described before and after the term "to" are respectively the lower limit and the upper limit of a range including the numerical values.
In the present specification, various physical property values and characteristic values are those at 23°C unless otherwise noted.
In a description of a group (atomic group) in the present specification, a description not specifying whether the group is a substituted group or an unsubstituted group is meant to include a group (atomic group) having a substituent as well as a group (atomic group) having no substituent. For example, an "alkyl group" includes not only an alkyl group having no substituent (unsubstituted alkyl group) but also an alkyl group having a substituent (substituted alkyl group). In the present specification, a description not specifying whether the group is a substituted group or an unsubstituted group means that the group is preferably an unsubstituted group.
In the present specification, a (meth)allyl group represents both or either of allyl and methallyl, a "(meth)acrylate" represents both or either of acrylate and methacrylate, a "(meth)acryl" represents both or either of acryl and methacryl, and a "(meth)acryloyl" represents both or either of acryloyl and methacryloyl.
The term "step" as used herein includes not only an independent step but also a step that cannot be clearly distinguished from other steps as long as an intended action of the step is achieved.
When the measurement methods or the like described in the standards described in the present specification differ depending on the year, the measurement methods or the like are based on the standards as of January 1, 2023, unless otherwise noted.
In the present specification, the resin solid content refers to components excluding a filler and a solvent, and is intended to include a resin (A) having a terminal group represented by Formula (T1) and having an indane skeleton, a

compound (B) having a polymerizable carbon-carbon unsaturated double bond and having a number average molecular weight of 400 or less, a thermosetting compound (C) having a number average molecular weight of more than 400, and an additional compound blended as necessary, an elastomer, and a resin additive component (an additive, such as a curing accelerator or a flame retardant).

As used herein, the terms "relative permittivity" and "permittivity" are used with the same meaning.

A resin composition of the present embodiment is characterized by containing a resin (A) having a terminal group represented by Formula (T1) and an indane skeleton (hereinafter, it may be simply referred to as "resin (A) having an indane skeleton" or "resin (A)"), a compound (B) having a polymerizable carbon-carbon unsaturated double bond and having a number average molecular weight of 400 or less (hereinafter, it may be simply referred to as "compound (B)"), and a thermosetting compound (C) having a number average molecular weight of more than 400 (hereinafter, it may be simply referred to as "thermosetting compound (C)" or "compound (C)") (however, the compound (B) and the compound (C) are not compounds corresponding to the resin (A)).

[Chem.25]

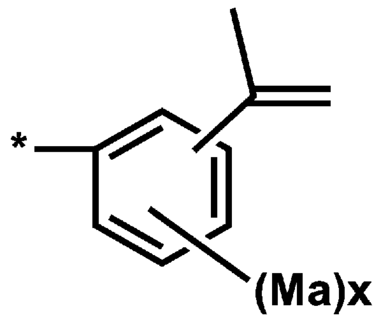

(T1)

(In Formula (T1), each Ma independently represents a hydrocarbon group having 1 to 12 carbon atoms, each carbon atom being optionally substituted with a halogen atom, and x represents an integer of from 0 to 4. * represents a bonding position for another moiety.)

With such a structure, a resin composition capable of providing a cured product excellent in low dielectric properties (Dk and/or Df, in particular Df) and thermal resistance over time (maintenance of the low dielectric properties, in particular suppression of increase in Df) is obtained.

The present inventors have found the possibility that the resin (A) having an indane skeleton can provide a cured product excellent in low dielectric properties (Dk and/or Df), and have also found that the resin (A) having an indane skeleton alone is not sufficiently cured. In the present embodiment, by blending the thermosetting compound (C), the curing of the resin composition containing the resin (A) having an indane skeleton and the thermosetting compound (C) can be effectively advanced. However, even when the resin composition containing the resin (A) having an indane skeleton and the thermosetting compound (C) is cured, an unreacted carbon-carbon unsaturated double bond (polymerizable group) derived from the resin (A) having an indane skeleton and/or the thermosetting compound (C) remains in the cured product. In addition, it has been found that there is a case where the dielectric properties, particularly the value of Df, are increased by the heat treatment (for example, when heat treatment is performed at 130°C for 150 hours) over time.

Thus, in the present embodiment, the compound (B) having a polymerizable carbon-carbon unsaturated double bond and a number average molecular weight of 400 or less is blended. Since the compound (B) has a polymerizable carbon-carbon unsaturated double bond, it is possible to cap an unreacted polymerizable group derived from the resin (A) having an indane skeleton and/or the thermosetting compound (C) in the resin composition containing the resin (A) having an indane skeleton and the thermosetting compound (C). Furthermore, since the compound (B) has a low molecular weight, the compound (B) has a small functional group equivalent, and many polymerizable carbon-carbon unsaturated double bonds can be blended in the resin composition with respect to a total amount of the resin (A) having an indane skeleton. As a result, it is presumed that a resin composition excellent in low dielectric properties (Dk and/or Df, in particular Df) over time in addition to low dielectric properties (Dk and/or Df) is obtained.

Hereinafter, details of the present embodiment will be described.

<Resin (A) having terminal group represented by Formula (T1) and having indane skeleton>

The resin composition of the present embodiment contains the resin (A) having a terminal group represented by Formula (T1) and having an indane skeleton.

[Chem.26]

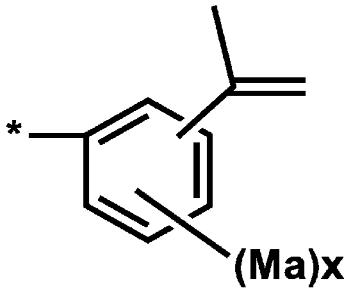

(T1)

(In Formula (T1), each Ma independently represents a hydrocarbon group having 1 to 12 carbon atoms, each carbon atom being optionally substituted with a halogen atom, and x represents an integer of from 0 to 4. * represents a bonding position for another moiety.)

In Formula (T1), each Ma is independently preferably a hydrocarbon group having from 1 to 10 carbon atoms optionally substituted with a halogen atom, more preferably a hydrocarbon group having from 1 to 5 carbon atoms optionally substituted with a halogen atom, and still more preferably a hydrocarbon group having from 1 to 3 carbon atoms, each carbon atom being optionally substituted with a halogen atom. Examples of the halogen atom include a fluorine atom, a chlorine atom, and a bromine atom. A fluorine atom or a chlorine atom is preferred. Each Ma is preferably independently a hydrocarbon group having from 1 to 12 carbon atoms, which are not substituted with halogen atoms. The hydrocarbon group is preferably an alkyl group, and more preferably a linear alkyl group. Ma is particularly preferably a methyl group or an ethyl group.

x is preferably an integer from 0 to 3, more preferably an integer from 0 to 2, still more preferably 0 or 1, and yet still more preferably 0.

The resin (A) may have the terminal group represented by Formula (T1) at all terminals or only at some terminals for each resin molecule.

The number of terminal groups represented by Formula (T1) in the resin molecule of the resin (A) is preferably two.

The resin (A) has an indane skeleton. There is no particular limitation as long as at least one molecule among the resin molecules contained in the resin (A) has at least one indane skeleton, and the number of indane skeletons in the resin molecule of the resin (A) is preferably 1 or more, and more preferably from 1 to 20 per molecule. With such a structure, the effect of the present invention tends to be more effectively exhibited.

The resin (A) preferably contains a structural unit represented by Formula (Txn).

[Chem.27]

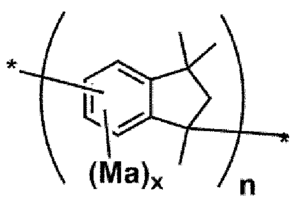

(Txn)

(where n represents an average number of repeating units and represents a number more than 0 and 20 or less, each Ma independently represents a hydrocarbon group having 1 to 12 carbon atoms, each carbon atom optionally substituted with a halogen atom. x represents an integer from 0 to 4.)

In Formula (Txn), each Ma is independently preferably a hydrocarbon group having from 1 to 10 carbon atoms which may be substituted with a halogen atom, more preferably a hydrocarbon group having from 1 to 5 carbon atoms which may be substituted with a halogen atom, and still more preferably a hydrocarbon group having from 1 to 3 carbon atoms, each carbon atom being optionally substituted with a halogen atom. Examples of the halogen atom include a fluorine atom, a chlorine atom, and a bromine atom. A fluorine atom or a chlorine atom is preferred. Each Ma is preferably independently a hydrocarbon group having from 1 to 12 carbon atoms, which are not substituted with halogen atoms. The hydrocarbon group is preferably an alkyl group, and more preferably a linear alkyl group. Ma is particularly preferably a methyl group or an ethyl group.

x is preferably an integer from 0 to 3, more preferably an integer from 0 to 2, still more preferably 0 or 1, and yet still more preferably 0.

The resin (A) more preferably contains a resin represented by Formula (T1-1), and more preferably contains a resin represented by Formula (T1-1-2).

[Chem.28]

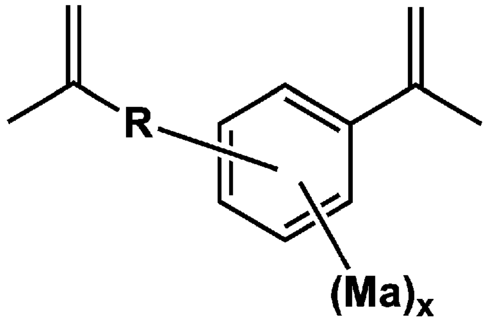

(T1-1)

(In Formula (T1-1) R is a group containing a structural unit represented by Formula (Tx), each Ma independently represents a hydrocarbon group having from 1 to 12 carbon atoms, each carbon atom being optionally substituted with a halogen atom, and x is an integer of from 0 to 4.)

In Formula (T1-1), Ma and x have the same meanings as Ma and x in Formula (T1), and preferred ranges thereof are also the same.

[Chem.29]

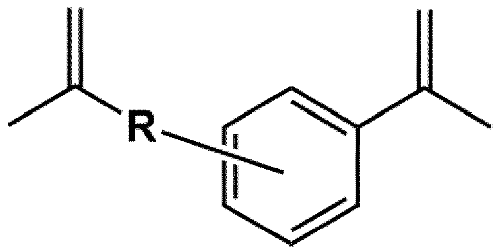

(T1-1-2)

(In Formula (T1-1-2), R is a group containing a structural unit represented by Formula (Tx).)

[Chem.30]

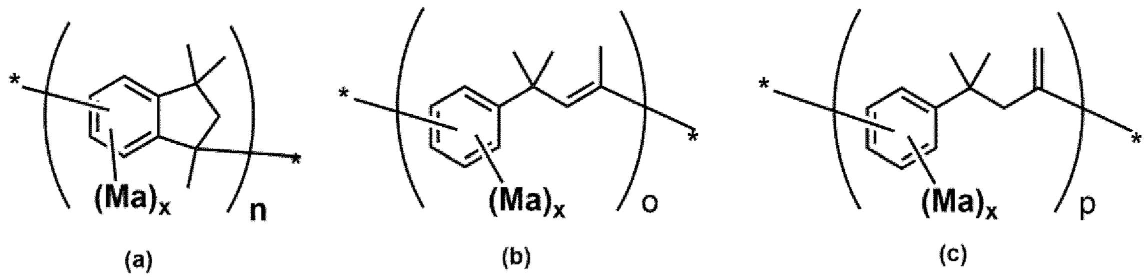

(Tx)

(In Formula (Tx), n, o, and p are average numbers of repeating units, n represents a number of more than 0 and 20 or less, o and p each independently represent a number of from 0 to 20, and $1.0 \leq n + o + p \leq 20.0$. each Ma independently represents a hydrocarbon group having from 1 to 12 carbon atoms, each carbon atom being optionally substituted with a halogen atom. x represents an integer of from 0 to 4. the structural units (a), (b), and (c) are each bonded at * to the structural unit (a), (b), or (c), or an additional group, and structural units may be randomly bonded.)

In Formula (Tx), n, o, and p each mean an average number of repeating units in all molecules in the resin.

In Formula (Tx), the sum of n, o, and p is preferably $1.1 \leq n + o + p$, more preferably $1.2 \leq n + o + p$, still more preferably $1.5 \leq n + o + p$, even more preferably $2.0 \leq n + o + p$, further more preferably $2.5 \leq n + o + p$, still further more preferably $3.0 \leq n + o + p$, and particularly preferably $3.3 \leq n + o + p$. In Formula (Tx), the sum of n, o, and p is preferably $n + o + p \leq 20.0$, more preferably $n + o + p \leq 10.0$, still more preferably $n + o + p \leq 8.0$, even more preferably $n + o + p \leq 7.0$, and further more preferably $n + o + p \leq 6.4$. The sum of n, o, and p can be calculated by the method described in Examples

described later.

In Formula (Tx), Ma and x have the same meanings as Ma and x in Formula (Txn), respectively, and preferred ranges thereof are also the same.

The resin (A) may contain a structural unit represented by Formula (Ty).

[Chem.31]

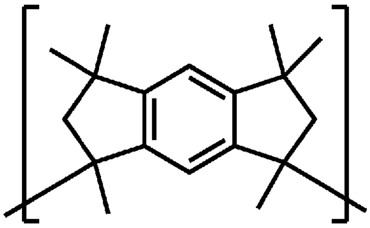

**(Ty)**

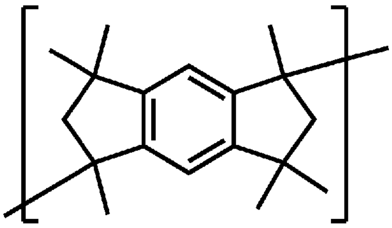

As the resin (A), in addition to the above, the resin described in paragraphs 0011 to 0025 of WO 2023/176766, the resin described in paragraphs 0012 to 0033 of WO 2023/176763, the resin described in paragraphs 0026 to 0043 of WO 2023/176765, the compound described in JP 2023-104785 A, and the composition described in JP 2024-007493 A can be taken into consideration, the contents of which are incorporated herein by reference.

The resin represented by Formula (T1-1) (preferably, the resin represented by Formula (T1-1-2)) preferably has a parameter $\alpha$ calculated from Equation ($\alpha$) of 0.30 or more and 1.00 or less. Furthermore, the resin represented by Formula (T1-1) (preferably, the resin represented by Formula (T1-1-2)) preferably has a parameter $\beta$ calculated from Formula ($\beta$) of 0.20 or more and 3.00 or less. By setting the parameters $\alpha$ and $\beta$ within the above ranges, the resulting cured product tends to have excellent low dielectric properties (Dk and/or Df) and excellent thermal resistance.

[Num.1]

$$\text{PARAMETER } \alpha = \frac{(2.55 \text{ ppm to } 2.31 \text{ ppm})}{(6.24 \text{ ppm to } 5.91 \text{ ppm}) + (2.98 \text{ ppm to } 2.55 \text{ ppm})/2 + (2.55 \text{ ppm to } 2.31 \text{ ppm})} \quad (\alpha)$$

$$\text{PARAMETER } \beta = \frac{\{(5.49 \text{ ppm to } 4.89 \text{ ppm}) - (4.89 \text{ ppm to } 4.45 \text{ ppm})\} \times 1.5}{(2.31 \text{ ppm to } 1.96 \text{ ppm}) - (2.55 \text{ ppm to } 2.31 \text{ ppm})} \quad (\beta)$$

(Expressions in parentheses in Equations ($\alpha$) and ($\beta$) indicate integral values between corresponding chemical shift values in $^1$H-NMR.)

Here, $\alpha$ represents a proportion of the structural unit having an indane skeleton (the structural unit (a) in Formula (Tx)) in the resin represented by Formula (T1-1) (preferably, the resin represented by Formula (T1-1-2)). More specifically, it is presumed that rigidity of the resulting resin molecule is high and a glass transition temperature can be increased by adjusting the structural unit having an indane skeleton so as to satisfy the range of the parameter $\alpha$. In addition, it is presumed that since a molecule having high rigidity has lower mobility than a molecule having low rigidity, a relaxation time at the time of dielectric relaxation becomes longer, and Df can be lowered. When the resin represented by Formula (T1-1) is synthesized, $\alpha$ can be increased by conditions such as decreasing the concentration of a raw material, using a high-polarity solvent, increasing the catalyst amount, and increasing reaction temperature.

Meanwhile, $\beta$ defines the proportion of terminal double bonds in the resin represented by Formula (T1-1) (preferably, the resin represented by Formula (T1-1-2)). More specifically, for example, it is presumed that the number of

crosslinking points with a functional group of the additional compound (C) (particularly, a thermosetting compound) described below increases, a network is easily formed at the time of thermal curing, and a cured product having a high glass transition temperature and a low Df is obtained. When the resin represented by Formula (T1-1) is synthesized, β can be increased by controlling conditions, such as decreasing the catalyst amount, decreasing reaction temperature, and using a low-polarity solvent.

In synthesizing the resin represented by Formula (T1-1) (preferably, the resin represented by Formula (T1-1-2)), the parameters α and β of the resin represented by Formula (T1-1) (preferably, the resin represented by Formula (T1-1-2)) can be adjusted using the method of increasing the parameters α and β described above. Needless to say, the parameters α and β may be adjusted by a method other than that described above.

The parameter α is preferably 0.35 or more, more preferably 0.40 or more, still more preferably 0.45 or more, even more preferably 0.50 or more, further more preferably 0.55 or more, and may be 0.57 or more, 0.59 or more, 0.60 or more, 0.62 or more, 0.65 or more, 0.70 or more, 0.75 or more, or 0.80 or more. When the parameter α is the above lower limit or more, the thermal resistance of the resulting cured product tends to be further improved. Practically, the parameter α preferably is large from the viewpoint that the low dielectric properties (Dk and/or Df) and the thermal resistance of the resulting cured product tend to be excellent. However, the parameter α may be 0.95 or less, 0.90 or less, 0.85 or less, 0.82 or less, 0.80 or less, 0.77 or less, 0.75 or less, or 0.74 or less.

The parameter β is preferably 0.25 or more, more preferably 0.30 or more, still more preferably 0.35 or more, yet still more preferably 0.40 or more, yet still more preferably 0.43 or more, and yet still more preferably 0.50 or more, and may be 0.60 or more, 0.65 or more, 0.70 or more, 0.77 or more, 0.80 or more, 0.90 or more, or 0.95 or more. When the parameter is the above lower limit or more, the thermal resistance of the resulting cured product tends to be improved, and Df tends to be lowered. The parameter β is preferably 2.50 or less, more preferably 2.00 or less, still more preferably 1.50 or less, yet still more preferably 1.30 or less, yet still more preferably 1.20 or less, yet still more preferably 1.10 or less, and may be 1.00 or less, 0.95 or less, 0.90 or less, 0.85 or less, 0.83 or less, or 0.80 or less. When the parameter β is the above upper limit or less, the resulting cured product tends to have improved thermal resistance and a low Df.

The number average molecular weight (Mn) of the resin (A) measured by the GPC (gel permeation chromatography) method calibrated with polystyrene standards (the details are according to the method described in Examples described later) is preferably 400 or more, more preferably 500 or more, still more preferably 550 or more, yet still more preferably 600 or more, and yet still more preferably 650 or more. When the number average molecular weight is the above lower limit or more, the thermal resistance of the resulting cured product tends to be improved, and Df tends to be lowered. The upper limit of the number average molecular weight (Mn) of the resin (A) measured by the GPC (gel permeation chromatography) method calibrated with polystyrene standards is preferably 3000 or less, more preferably 2500 or less, still more preferably 2000 or less, even more preferably 1500 or less, and further more preferably 1250 or less, and the upper limit may be 1000 or less or 800 or less depending on the intended use and the like. When the number average molecular weight is the above upper limit or less, the thermal resistance of the resulting cured product tends to be improved, and the relative permittivity (Dk) and the dielectric loss tangent (Df) tend to be lowered.

The weight average molecular weight (Mw) of the resin (A) measured by GPC calibrated with polystyrene standards (the details are according to the method described in Examples described later) is preferably 500 or more, more preferably 800 or more, still more preferably 900 or more, and even more preferably 1000 or more. When the weight average molecular weight is the above lower limit or more, the thermal resistance of the resulting cured product tends to be improved, and Df tends to be lowered. The upper limit of the weight average molecular weight (Mw) of the resin (A) measured by GPC calibrated with polystyrene standards (the details are according to the method described in Examples described later) is preferably 6000 or less, more preferably 5000 or less, still more preferably 4000 or less, even more preferably 3000 or less, and further more preferably 2800 or less, and the upper limit may be 2500 or less, 2000 or less, or 1500 or less depending on the intended use and the like. When the weight average molecular weight is the above upper limit or less, the resulting cured product tends to have improved thermal resistance, a low relative permittivity (Dk), and a low dielectric loss tangent (Df).

The resin (A) preferably has a Mw/Mn, which is the ratio of the weight average molecular weight to the number average molecular weight, from 1.1 to 3.0. The Mw/Mn of the resin (A) is more preferably 1.2 or more, still more preferably 1.3 or more, even more preferably 1.4 or more, further more preferably 1.5 or more, and still further more preferably 1.6 or more. The Mw/Mn of the resin (A) is more preferably 2.5 or less, still more preferably 2.4 or less, and may be 2.3 or less, 2.0 or less, or 1.8 or less.

The weight average molecular weight and the number average molecular weight are measured in accordance with methods described in Examples described later.

In the present embodiment, the functional group equivalent (isopropenyl group equivalent) of the resin (A) is preferably 100 g/eq. or more, more preferably 150 g/eq. or more, still more preferably 200 g/eq. or more, yet still more preferably 250 g/eq. or more, yet still more preferably 275 g/eq. or more, yet still more preferably 300 g/eq. or more, and is preferably 7500 eq. or less, more preferably 5000 eq. or less, still more preferably 4000 eq. or less, yet still more preferably 3000 g/eq. or less, yet still more preferably 2000 g/eq. or less, yet still more preferably 1500 g/eq. or less, particularly

preferably 1000 g/eq., and further, it may be 800 g/eq. or less, 750 g/eq. or less, 700 g/eq. or less, or 500 g/eq or less. When the functional group equivalent of the resin (A) is the above lower limit or more, the resulting cured product has more excellent low dielectric properties (Dk and/or Df, in particular Df), and the thermal resistance (low dielectric properties (Dk and/or Df, in particular Df) after heating) over time of the resulting cured product can be more effectively maintained. When the functional group equivalent of the resin (A) is the above upper limit or less, the resulting cured product tends to have more excellent low dielectric properties (Dk and/or Df, in particular Df) and more excellent thermal resistance (in particular, the glass transition temperature). The functional group equivalent (isopropenyl group equivalent) of the resin (A) is determined according to the method described in Examples described later.

The content of the resin (A) in the resin composition of the present embodiment is preferably 5 parts by mass or more, more preferably 8 parts by mass or more, and may be 10 parts by mass or more, with respect to 100 parts by mass of the resin solid content in the resin composition, or may be 15 parts by mass or more, 20 parts by mass or more, or 25 parts by mass or more, depending on the intended use and the like. When the content of the resin (A) is the above lower limit or more, the resulting cured product tends to have a low Df. The upper limit value of the content of the resin (A) is preferably 70 parts by mass or less, more preferably 55 parts by mass or less, still more preferably 50 parts by mass or less, even more preferably 45 parts by mass or less, even more preferably 40 parts by mass or less, and particularly preferably 35 parts by mass or less with respect to 100 parts by mass of the resin solid content in the resin composition. When the content of the resin (A) is the above upper limit or less, the moldability of the resin composition and the thermal resistance of the resulting cured product tend to improve.

The resin composition of the present embodiment may contain only one type of resin (A) or may contain two or more types of resins (A). When two or more types of resins (A) are contained, the total amount is preferably in the range described above.

The method for producing the resin (A) of the present embodiment is not particularly limited, and a resin produced by a known production method can be used. When the resin (A) is synthesized, the raw material, the reaction temperature, the catalyst type, the catalyst amount, the reaction solvent, and the raw material concentration are not particularly limited, and they can be appropriately selected or controlled depending on the desired physical properties described above.

In the present embodiment, the raw material that can be used for synthesizing the resin (A) is, for example, m-bis($\alpha$-hydroxyisopropyl) benzene, p-bis($\alpha$-hydroxyisopropyl)benzene, 1,3-diisopropenylbenzene, and 1,4-diisopropenylbenzene.

<Compound (B) having polymerizable carbon-carbon unsaturated double bond and a number average molecular weight of 400 or less>

The resin composition of the present embodiment contains the compound (B) having a polymerizable carbon-carbon unsaturated double bond and a number average molecular weight of 400 or less (compound (B)). The compound (B) reacts with an unreacted carbon-carbon unsaturated double bond (polymerizable group) derived from the resin (A) in the resin composition to achieve the low dielectric properties (Dk and/or Df, in particular Df) of the resulting cured product, and a resin composition capable of more effectively maintaining the thermal resistance (low dielectric properties (Dk and/or Df, in particular Df) after heating) over time of the resulting cured product is obtained.

The polymerizable carbon-carbon unsaturated double bond of the compound (B) means a carbon-carbon unsaturated double bond capable of reacting with a carbon-carbon unsaturated double bond of the resin (A) during thermal curing, and may be a compound having a carbon-carbon unsaturated double bond at a terminal, or may be a compound having a group (for example, a vinylene group and a maleimide group) capable of opening a ring to react with a carbon-carbon unsaturated double bond of the resin (A) during curing of the resin composition and the like.

The polymerizable carbon-carbon unsaturated double bond in the compound (B) is preferably at least one selected from the group consisting of a vinyl group, a (meth)allyl group, a (meth)acryloyl group, a vinylene group, and a maleimide group, more preferably contains at least one of a vinyl group and a vinylene group, and still more preferably contains a vinyl group.

In the present embodiment, the number average molecular weight of the compound (B) is preferably 350 or less, more preferably 300 or less, still more preferably 280 or less, and even more preferably 250 or less, and may be 245 or less, 230 or less, 190 or less, 170 or less, 165 or less, 160 or less, 155 or less, or 150 or less depending on the intended use and the like. The number average molecular weight of the compound (B) is preferably 100 or more. When the number average molecular weight is the above lower limit or more, the resin composition tends to have improved moldability, and the resulting cured product tends to have further improved low dielectric properties (Dk and/or Df, in particular Df). When the number average molecular weight is the above upper limit or less, the thermal resistance (low dielectric properties (Dk and/or Df, in particular Df) after heating) over time of the resulting cured product can be more effectively maintained.

When the resin composition of the present embodiment contains two or more compounds (B), the number average molecular weight of the compound (B) is a value (weighted average value) obtained by multiplying the molecular weight of each of the compounds (B) by its mass fraction.

In the present embodiment, the equivalent of the polymerizable carbon-carbon unsaturated double bond of the compound (B) is preferably 50 g/eq. or more, more preferably 55 g/eq. or more, still more preferably 60 g/eq. or more, even more preferably 62 g/eq. or more, and is preferably 400 g/eq. or less, more preferably 300 g/eq. or less, still more preferably 200 g/eq. or less, even more preferably 180 g/eq. or less, further more preferably 150 g/eq. or less, still further more preferably 145 g/eq. or less. When the equivalent of the polymerizable carbon-carbon unsaturated double bond of the compound (B) is the above lower limit or more, the moldability of the resin composition tends to be excellent, and the low dielectric properties (Dk and/or Df, in particular Df) of the resulting cured product tend to be more excellent. When the equivalent of the polymerizable carbon-carbon unsaturated double bond of the compound (B) is the above upper limit or less, the thermal resistance (low dielectric properties (Dk and/or Df, in particular Df) after heating) over time of the resulting cured product can be more effectively maintained.

In the present embodiment, the number of polymerizable carbon-carbon unsaturated double bonds in one molecule of the compound (B) is preferably 1 or 2.

Examples of the compound (B) having a vinyl group include an aromatic vinyl compound (preferably a styrene-based compound), a saturated fatty acid vinyl compound, a vinyl cyanide compound, an unsaturated epoxy compound having a vinyl group, and a vinylsilane-based compound, an aromatic vinyl compound and/or a saturated fatty acid vinyl compound are preferable, and an aromatic vinyl compound is more preferable.

Specific examples of the aromatic vinyl compound include methylstyrene (for example, 4-methylstyrene), ethylvinylbenzene, diethyl 4-vinylbenzylphosphonate, 4-vinylbenzyl glycidyl ether, α-methylstyrene, 4-tert-butylstyrene, divinylbenzene, 1,2-bis(4-vinylphenyl)ethane (BVPE), and vinyl benzyl ether, and at least one selected from the group consisting of 4-methylstyrene, 4-tert-butylstyrene, divinylbenzene, 1,2-bis(4-vinylphenyl)ethane, 1,3-diisopropenylbenzene, and 1,4-diisopropenylbenzene is more preferable.

Examples of the vinyl benzyl ether include a reaction product of 2,6-dihydroxynaphthalene and vinylbenzyl chloride and/or vinylbenzyl bromide.

Furthermore, examples of the vinyl benzyl ether include vinyl benzyl ether produced from the reaction of resorcinol, catechol, hydroquinone, 2,7-dihydroxynaphthalene, or the like with vinylbenzyl chloride and/or vinylbenzyl bromide.

In addition to the above, the vinyl benzyl ether as the compound (B) also includes a compound having a number average molecular weight of 400 or less among the vinyl benzyl ethers described in paragraph 0041 of JP 2019-194312 A, the contents of which are incorporated herein by reference.

The vinylsilane-based compound is preferably at least one selected from the group consisting of vinyltrimethoxysilane, vinyltriethoxysilane, tetravinylsilane, triethylvinylsilane, vinylphenylsilane (styrylsilane), and 1,3-vinyltetramethylsiloxane, and more preferably at least one selected from the group consisting of vinyltrimethoxysilane, vinyltriethoxysilane, and vinylphenylsilane. Examples of the vinylphenylsilane include 4-vinylphenyltrimethoxysilane.

Examples of the compound (B) having a (meth)allyl group include a (meth)allyl isocyanurate compound, a (meth)allyl compound having a glycoluril structure, and a di(meth)allyl phthalate compound, and a (meth)allyl isocyanurate compound and/or a (meth)allyl compound having a glycoluril structure are preferable.

When the compound (B) has a (meth)allyl group, an allyl group is preferably contained.

The (meth)allyl isocyanurate compound is preferably a compound represented by Formula (TA).

Formula (TA)

[Chem.32]

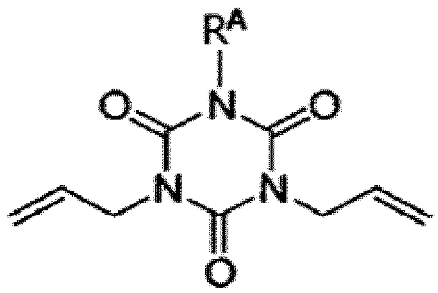

(In Formula (TA), $R^A$ represents a substituent.)

In Formula (TA), $R^A$ represents a substituent, and is preferably a substituent having a formula weight of from 15 to 193, more preferably a substituent having a formula weight of from 1 to 50, more preferably an alkyl group having from 1 to 13 carbon atoms or an alkenyl group having from 2 to 13 carbon atoms, and still more preferably an allyl group.

As another example of $R^A$, a phosphorus-based substituent is also exemplified.

Specific examples of the compound represented by Formula (TA) include triallyl isocyanurate, 5-octyl-1,3-diallyl

isocyanurate, and 5-dodecyl-1,3-diallyl isocyanurate. One of these may be used, or two or more may be used in combination.

As the compound represented by Formula (TA), a commercially available product can also be used. Examples of the commercially available product include, but are not particularly limited to, L-DAIC available from Shikoku Chemicals Corporation and TAIC available from Shinryo Corporation.

The (meth)allyl compound having a glycoluril structure is preferably a compound represented by Formula (GU). Formula (GU)

[Chem.33]

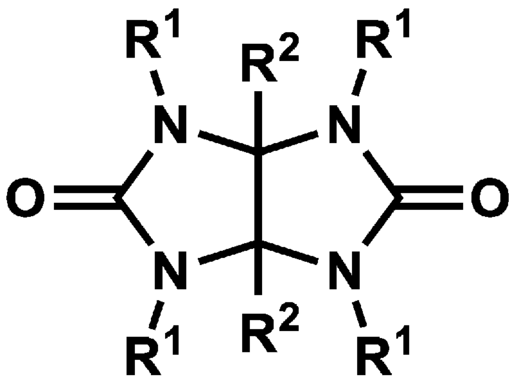

(In Formula (GU), each $R^1$ is independently a hydrogen atom or a substituent, and at least two of $R^1$ are groups containing a (meth)allyl group. each $R^2$ independently represents a hydrogen atom, an alkyl group, or an aryl group.)

In Formula (GU), it is preferable that each $R^1$ is independently a hydrogen atom, an alkyl group having from 1 to 4 carbon atoms, or an alkenyl group having from 2 to 4 carbon atoms, preferably an alkenyl group having from 2 to 4 carbon atoms, more preferably a (meth)allyl group, and still more preferably an allyl group.

In Formula (GU), preferably, three or four of $R^1$ are groups containing a (meth)allyl group, and more preferably, four of R are groups containing a (meth)allyl group.

In Formula (GU), each $R^2$ is independently preferably a hydrogen atom, an alkyl group having from 1 to 4 carbon atoms, or a phenyl group, and more preferably a hydrogen atom or a methyl group.

Specific examples of the compound represented by Formula (GU) include 1,3,4,6-tetraallylglycoluril (a compound where R is all allyl groups in Formula (GU)).

As the (meth)allyl compound having a glycoluril structure, a commercially available product can also be used. The commercially available compound is not particularly limited, and examples thereof include TA-G available from Shikoku Chemicals Corporation.

Examples of the compound (B) having a (meth)acryloyl group include a monofunctional (meth)acrylate compound and a polyfunctional (meth)acrylate compound. The compound having a (meth)acryloyl group is preferably a compound having a methacrylic group.

Examples of the monofunctional (meth)acrylate compound include a silane coupling agent having a (meth) acryloyloxy group (for example, 3-acryloxypropyltrimethoxysilane).

The polyfunctional (meth)acrylate compound is preferably a compound having three to five (meth)acryloyloxy groups, more preferably a compound having three or four (meth)acryloyloxy groups, and still more preferably a compound having three (meth)acryloyloxy groups.

A second preferred example of the polyfunctional (meth)acrylate compound is dicyclopentadiene type bifunctional (meth)acrylate. Specific examples of the dicyclopentadiene type bifunctional (meth)acrylate include dicyclopentenyl (meth)acrylate, dicyclopentenyloxyethyl (meth)acrylate, and dicyclopentanyl (meth)acrylate.

Since the polyfunctional (meth)acrylate compound has a large number of (meth)acrylate groups as crosslinking points, the polyfunctional (meth)acrylate compound is firmly cured together with the resin (A), so that a cured product having excellent low dielectric properties (Dk and/or Df) and thermal resistance is produced. The polyfunctional (meth) acrylate compound is preferably a compound represented by Formula (MA). Formula (MA)

[Chem.34]

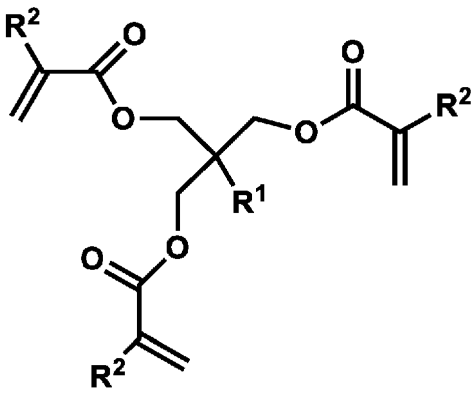

(In Formula (MA), $R^1$ represents a hydrogen atom or a substituent, and each $R^2$ independently represents a hydrogen atom or a methyl group.)

In addition to the above, as a specific example of the compound having a (meth)acryloyl group, a compound having a number average molecular weight of 400 or less described in paragraph 0049 of JP 2019-194312 A can be taken into consideration, and the contents thereof are incorporated herein.

In Formula (MA), $R^1$ represents a hydrogen atom or a substituent, and is preferably a substituent having a formula weight from 15 to 91, more preferably a substituent having a formula weight from 15 to 75, still more preferably a substituent having a formula weight from 15 to 55, and even more preferably a substituent having a formula weight from 15 to 40.

$R^1$ is preferably a hydrocarbon group or a (meth)acryloyloxy group. The hydrocarbon group is preferably a hydrocarbon group having 6 or less carbon atoms, and more preferably an alkyl group having from 1 to 6 carbon atoms or an alkenyl group having from 2 to 6 carbon atoms. By using a compound having an alkyl group having from 1 to 6 carbon atoms or an alkenyl group having from 2 to 6 carbon atoms, it is possible to provide a resin composition capable of obtaining a cured product having excellent crosslinkability and high toughness. Thus, even when a substrate, such as glass cloth, is not included in the resin composition, cracking during etching treatment or the like can be suppressed.

The number of carbon atoms in the alkyl group and/or the alkenyl group is preferably 2 or more, and may be 4 or more or 3 or less from the viewpoint of improving handleability. Accordingly, it is considered that the resin flowability of the resin composition is improved, and the resin composition is more excellent in circuit filling properties and the like when a multilayer circuit board or the like is produced using the resin composition of the present embodiment.

The alkyl group having from 1 to 6 carbon atoms is preferably a linear alkyl group having from 1 to 6 carbon atoms, or a branched alkyl group having from 3 to 6 carbon atoms, and examples thereof include a methyl group, an ethyl group, a propyl group, a butyl group, a pentyl group, and a hexyl group. The alkenyl group having from 2 to 6 carbon atoms is preferably an alkenyl group having from 2 to 6 carbon atoms, and examples thereof include an allyl group.

Specific examples of the compound represented by Formula (MA) include trimethylolpropane trimethacrylate, trimethylolpropane triacrylate, and pentaerythritol tetra(meth)acrylate. For these, one type may be used, or two or more types may be used in combination. These may be used as prepolymers.

As the compound represented by Formula (MA), a commercially available product can also be used. The commercially available product is not particularly limited, and examples of trimethylolpropane trimethacrylate include "NK Ester TMPT" available from Shin-Nakamura Chemical Co., Ltd.

Examples of the compound (B) having a vinylene group include a compound containing one or two or more -CH=CH- in the molecule, and a compound containing one -CH=CH- in the molecule is preferable. The vinylene group in the compound (B) is intended to exclude a maleimide group.

When the compound (B) has a vinylene group, acenaphthylene and pyrazylene are preferred as specific examples, and acenaphthylene is more preferred.

In the present specification, a compound that corresponds to the compound (B), such as an imidazole compound to be described later, and that is explicitly described as a component (for example, a curing accelerator) other than the compound (B) does not correspond to the compound (B).

Examples of the compound (B) having a maleimide group include a monofunctional maleimide compound and a polyfunctional maleimide compound.

Examples of the maleimide compound include N-phenylmaleimide, N-cyclohexylmaleimide, m-phenylenebismaleimide, 4-methyl-1,3-phenylenebismaleimide, 1,6-bismaleimide-(2,2,4-trimethyl)hexane, 4,4'-diphenyl ether bismaleimide, and 4,4'-diphenylmethane bismaleimide.

In the present embodiment, in particular, the compound (B) preferably contains at least one selected from the group consisting of divinylbenzene, acenaphthylene, dicyclopentadiene type bifunctional (meth)acrylate, 1,2-bis(4-vinylphenyl)ethane, 4-tert-butylstyrene, and 4-methylstyrene, more preferably contains at least one selected from the

group consisting of divinylbenzene and acenaphthylene, and still more preferably contains divinylbenzene.

The content of the compound (B) in the resin composition of the present embodiment is preferably 5 parts by mass or more, more preferably 7 parts by mass or more, still more preferably 10 parts by mass or more, even more preferably 12 parts by mass or more, further more preferably 15 parts by mass or more, and is preferably 500 parts by mass or less, more preferably 300 parts by mass or less, still more preferably 100 parts by mass or less, even more preferably 80 parts by mass or less, further more preferably 60 parts by mass or less, and still further more preferably 25 parts by mass or less, with respect to 100 parts by mass of the resin (A). When the content of the compound (B) is the above lower limit or more, the thermal resistance (low dielectric properties (Dk and/or Df, in particular Df) after heating) over time of the resulting cured product can be more effectively maintained. When the content of the compound (B) is the above upper limit or less, the resulting cured product has more excellent low dielectric properties (Dk and/or Df, in particular Df), and the thermal resistance (low dielectric properties (Dk and/or Df, in particular Df) after heating) over time of the resulting cured product can be more effectively maintained.

The resin composition of the present embodiment may contain only one, or two or more compounds (B). When two or more aliphatic polyamide resins are contained, the total amount is preferably in the range described above.

<Thermosetting compound (C) having number average molecular weight of more than 400>

The resin composition of the present embodiment contains the thermosetting compound (C) (compound (C)) having a number average molecular weight of more than 400. The number average molecular weight of the compound (C) is preferably from more than 400 to 100000. The number average molecular weight is a number average molecular weight (Mn) measured by the GPC (gel permeation chromatography) method calibrated with polystyrene standards, and is determined by the method described in Examples described later.

In the present embodiment, the functional group equivalent of the compound (C) is preferably more than 145 g/eq., more preferably 160 g/eq. or more, still more preferably more than 200 g/eq, and is preferably 3000 g/eq. or less, more preferably 2000 g/eq. or less. When the functional group equivalent of the compound (C) is the above lower limit or more, the resulting cured product has more excellent low dielectric properties (Dk and/or Df, in particular Df), and the thermal resistance (low dielectric properties (Dk and/or Df, in particular Df) after heating) over time of the resulting cured product can be more effectively maintained. When the functional group equivalent of the compound (C) is the above upper limit or less, the resulting cured product tends to have more excellent low dielectric properties (Dk and/or Df, in particular Df), and the thermal resistance (in particular, the glass transition temperature) tends to be further improved.

In the present embodiment, the functional group equivalent of the resin (A) > the functional group equivalent of the compound (B) is preferable, and a difference between the functional group equivalent of the resin (A) and the functional group equivalent of the compound (B) is preferably 50 g/eq. or more, more preferably 80 g/eq. or more, still more preferably 100 g/eq. or more, and is preferably 500 g/eq. or less, more preferably 300 g/eq. or less. When the value is the above lower limit or more, the thermal resistance (low dielectric properties (Dk and/or Df, in particular Df) after heating) over time of the resulting cured product can be more effectively maintained. When the value is the above upper limit or less, the moldability of the resin composition tends to be improved, and the resulting cured product tends to have further improved low dielectric properties (Dk and/or Df, in particular Df).

In the present embodiment, the functional group equivalent of the compound (C) > the functional group equivalent of the compound (B) is preferable, and a difference between the functional group equivalent of the compound (C) and the functional group equivalent of the compound (B) is preferably 100 g/eq. or more, more preferably 150 g/eq. or more, still more preferably 200 g/eq. or more, and is preferably 1500 g/eq. or less, more preferably 1200 g/eq. or less. When the maleimide group equivalent is the above lower limit or more, the resulting cured product tends to have further improved low dielectric properties (Dk and/or Df, in particular Df). When the value is the above upper limit or less, the thermal resistance (low dielectric properties (Dk and/or Df, in particular Df) after heating) over time of the resulting cured product can be more effectively maintained, and the resulting cured product tends to have more excellent thermal resistance (in particular, the glass transition temperature).

Examples of the functional group of the compound (C) include a maleimide group of the maleimide compound, a vinylphenyl group of the polymer having a structural unit represented by Formula (V), and a carbon-carbon unsaturated double bond group (a vinylbenzyl group, a (meth)acryloyloxy group, or the like) at the terminal of the polyphenylene ether compound having a carbon-carbon unsaturated double bond at the terminal.

The compound (C) is preferably a compound having a number average molecular weight of more than 400 and contains one or more selected from the group consisting of a maleimide compound, a polymer having a structural unit represented by Formula (V), a polyphenylene ether compound having a carbon-carbon unsaturated double bond at a terminal, cyanate ester compound, an epoxy compound, a phenolic compound, a polyfunctional (meth)allyl compound, a benzoxazine compound, an aryl cyclobutene resin, a polyamide compound, a polyimide compound, a perfluorovinyl ether resin, a compound having an isopropenyl group other than the resin (A), a polyfunctional (meth)acrylate compound other than the polyphenylene ether compound having a carbon-carbon unsaturated double bond at a terminal, and an additional

compound having a carbon-carbon unsaturated double bond at a terminal, more preferably a compound having a number average molecular weight of more than 400 and contains at least one selected from the group consisting of a maleimide compound, a polymer having a structural unit represented by Formula (V), a polyphenylene ether compound having a carbon-carbon unsaturated double bond at a terminal, an epoxy compound, a phenolic compound, a benzoxazine compound, a cyanate ester compound, and a polyfunctional (meth)acrylate compound other than a polyphenylene ether compound having a carbon-carbon unsaturated double bond at a terminal, still more preferably a compound having a number average molecular weight of more than 400 and contains at least one selected from the group consisting of a maleimide compound, a polymer having a structural unit represented by Formula (V), a polyphenylene ether compound having a carbon-carbon unsaturated double bond at a terminal, an epoxy compound, a phenolic compound, a benzoxazine compound, and cyanate ester compound, even more preferably a compound having a number average molecular weight of more than 400 and contains one or more selected from the group consisting of a maleimide compound, a polymer having a structural unit represented by Formula (V), and a polyphenylene ether compound having a carbon-carbon unsaturated double bond at a terminal, and further more preferably a compound having a number average molecular weight of more than 400 and contains at least one selected from the group consisting of a compound represented by Formula (M0), a compound represented by Formula (M1), a compound represented by Formula (M3), a compound represented by Formula (M4), a compound represented by Formula (M5), a polymer having a structural unit represented by Formula (V), and a compound represented by Formula (OP).

[Chem.35]

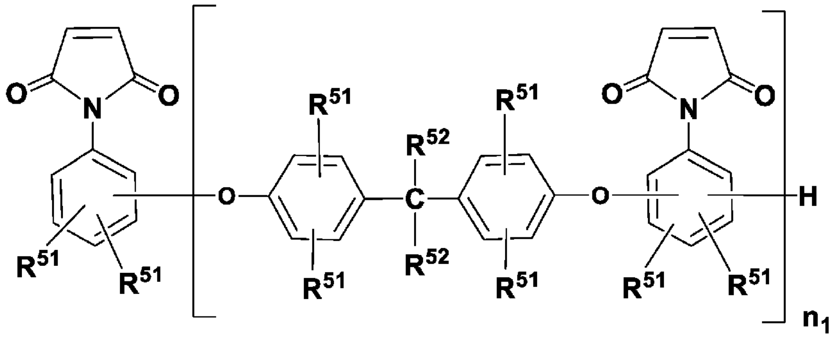

(M0)

(In Formula (M0), each $R^{51}$ independently represents a hydrogen atom, an alkyl group having from 1 to 8 carbon atoms, or a phenyl group; each $R^{52}$ independently represents a hydrogen atom or a methyl group; and $n_1$ represents an integer of 1 or more.)

[Chem.36]

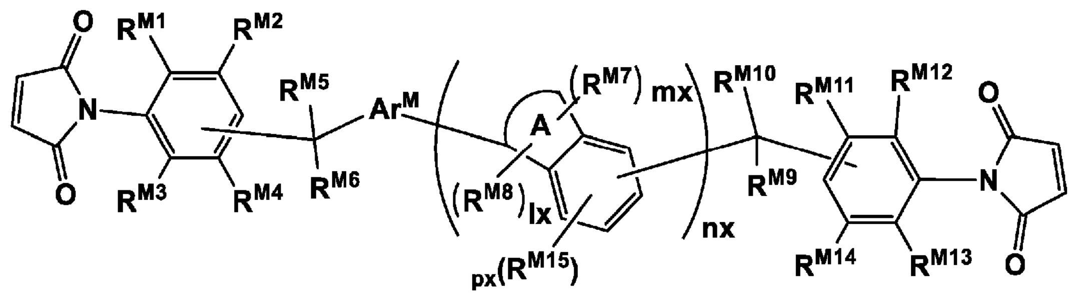

(M1)

(where $R^{M1}$, $R^{M2}$, $R^{M3}$, and $R^{M4}$ each independently represent a hydrogen atom or an organic group, $R^{M5}$ and $R^{M6}$ each independently represent a hydrogen atom or an alkyl group, $Ar^M$ represents a divalent aromatic group, A is a four- to six-membered alicyclic group, $R^{M7}$ and $R^{M8}$ are each independently an alkyl group, mx is 1 or 2, and lx is 0 or 1, $R^{M9}$ and $R^{M10}$ each independently represent a hydrogen atom or an alkyl group, $R^{M11}$, $R^{M12}$, $R^{M13}$, and $R^{M14}$ each independently represent a hydrogen atom or an organic group, each $R^{M15}$ independently represents an alkyl group having from 1 to 10 carbon atoms, an alkyloxy group having from 1 to 10 carbon atoms, an alkylthio group having from 1 to 10 carbon atoms, a cycloalkyl group having from 3 to 10 carbon atoms, an aryl group having from 6 to 10 carbon atoms, an aryloxy group having from 6 to 10 carbon atoms, an arylthio group having from 6 to 10 carbon atoms, a halogen atom, a hydroxyl group, or a mercapto group, px represents an integer of from 0 to 3, nx represents an integer of from 1 to 20.)

[Chem.37]

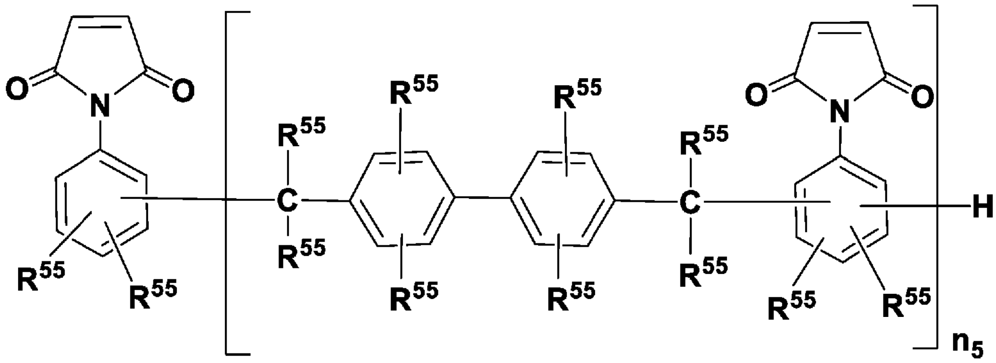

(M3)

(where each $R^{55}$ independently represents a hydrogen atom, an alkyl group having from 1 to 8 carbon atoms, or a phenyl group; and $n_5$ represents an integer of 1 or more and 10 or less.)

[Chem.38]

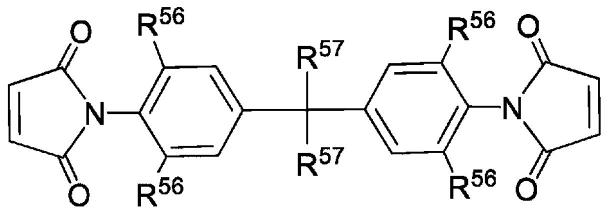

(M4)

(where each $R^{56}$ independently represents a hydrogen atom, a methyl group, or an ethyl group, and each $R^{57}$ independently represents a hydrogen atom or a methyl group.)

[Chem.39]

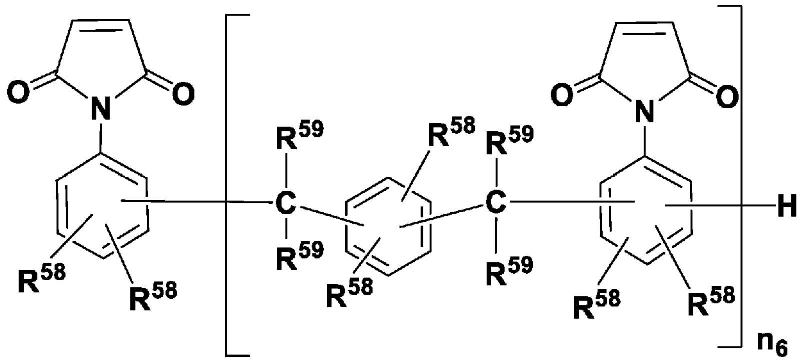

(M5)

(where each $R^{58}$ independently represents a hydrogen atom, an alkyl group having from 1 to 8 carbon atoms, or a phenyl group; each $R^{59}$ independently represents a hydrogen atom or a methyl group; and $n_6$ represents an integer of 1 or more.)

[Chem.40]

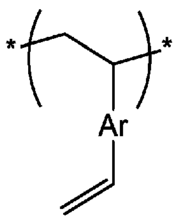

(V)

(where Ar represents an aromatic hydrocarbon linking group, and * represents a bonding position.)

[Chem. 41]

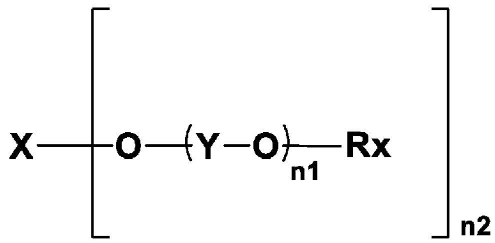

(OP)

(where X represents an aromatic group; $-(Y-O)_{n1}-$ represents a polyphenylene ether structure; $n_1$ represents an integer of from 1 to 100; n2 represents an integer of from 1 to 4; and Rx is a group represented by Formula (Rx-1) or Formula (Rx-2).)

[Chem. 42]

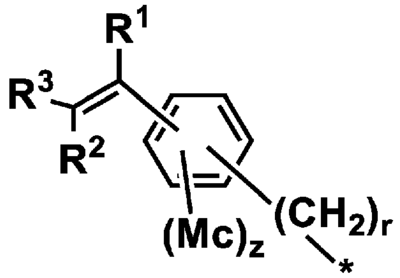

(Rx-1)

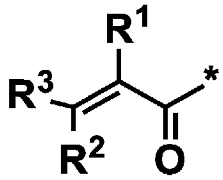

(Rx-2)

(where $R^1$, $R^2$, and $R^3$ each independently represent a hydrogen atom, an alkyl group, an alkenyl group, or an alkynyl group, * is a bonding position for an oxygen atom, each Mc independently represents a hydrocarbon group having from 1 to 12 carbon atoms, z represents an integer of from 0 to 4, and r represents an integer of from 0 to 6.)

<<Maleimide compound>>

The maleimide compound is not particularly limited as long as it is a compound containing one or more (preferably 2 or more, more preferably from 2 to 12, still more preferably from 2 to 6, even more preferably from 2 to 4, further more preferably 2 or 3, and still further more preferably 2) maleimide groups per molecule, and a compound commonly used in the field of printed wiring board can be used widely.

In the present embodiment, the maleimide compound is preferably a compound having a number average molecular weight of more than 400 and includes one or more selected from the group consisting of: a compound represented by Formula (M0); a compound represented by Formula (M1); a compound represented by Formula (M2); a compound represented by Formula (M3); a compound represented by Formula (M4); a compound represented by Formula (M5); a maleimide compound (M6); and a maleimide compound (M7), is more preferably a compound having a number average molecular weight of more than 400 and includes one or more selected from the group consisting of: a compound represented by Formula (M0); a compound represented by Formula (M1); a compound represented by Formula (M3); a compound represented by Formula (M4); a compound represented by Formula (M5); and a maleimide compound (M7), is still more preferably a compound having a number average molecular weight of more than 400 and includes one or more selected from the group consisting of: a compound represented by Formula (M0); a compound represented by Formula (M1); a compound represented by Formula (M3); a compound represented by Formula (M4); and a compound represented by Formula (M5), is even more preferably a compound having a number average molecular weight of more than 400 and includes one or more selected from the group consisting of: a compound represented by Formula (M1); a compound represented by Formula (M3); and a compound represented by Formula (M5), is further more preferably a compound having a number average molecular weight of more than 400 and includes a compound represented by Formula (M1) and/or a compound represented by Formula (M3), and is still further more preferably a compound having a number average molecular weight of more than 400 and includes a compound represented by Formula (M1). Using such a maleimide compound in a printed wiring board material (for example, metal foil-clad laminate) or the like can impart excellent thermal resistance to the material.

[Chem. 43]

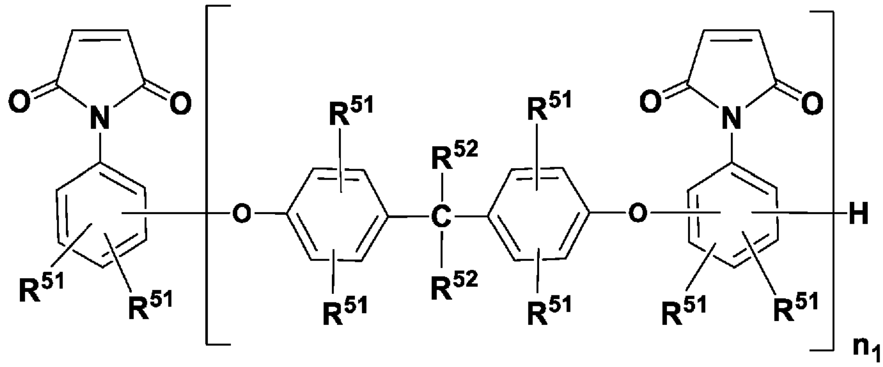

(M0)

(In Formula (M0), each $R^{51}$ independently represents a hydrogen atom, an alkyl group having from 1 to 8 carbon atoms, or a phenyl group; each $R^{52}$ independently represents a hydrogen atom or a methyl group; and $n_1$ represents an integer of 1 or more.)

It is preferable that each $R^{51}$ is, independently one selected from the group consisting of a hydrogen atom, a methyl group, an ethyl group, a n-propyl group, an isopropyl group, a n-butyl group, an isobutyl group, a t-butyl group, a n-pentyl group, and a phenyl group, more preferably a hydrogen atom and/or a methyl group, and still more preferably a hydrogen atom.

$R^{52}$ is preferably a methyl group.

$n_1$ is preferably an integer of from 1 to 10, more preferably an integer of from 1 to 5, still more preferably an integer of from 1 to 3, even more preferably 1 or 2, and further more preferably 1.

Specifically, preferred examples of Formula (M0) include the following compounds.

[Chem.44]

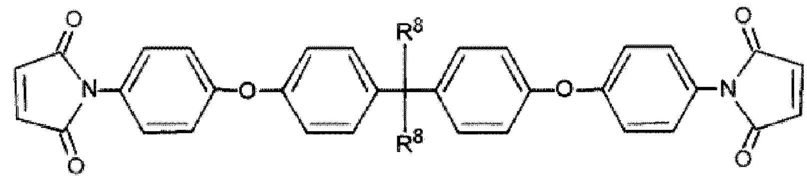

In the above formula, each $R^8$ independently represents a hydrogen atom, a methyl group, or an ethyl group, and a methyl group is preferred.

The compound represented by Formula (M0) may be one type, or a mixture of two or more types. Examples of the mixture include: a mixture of compounds having different $n_1$; a mixture of compounds having different types of substituents of $R^{51}$ and/or $R^{52}$; a mixture of compounds in which maleimide groups and oxygen atoms are bonded to benzene rings at different positions (meta positions, para positions, and ortho positions); and a mixture of compounds in which two or more different points described above are combined. Hereinafter, the same applies to the compounds represented by Formulas (M1) to (M7).

[Chem.45]

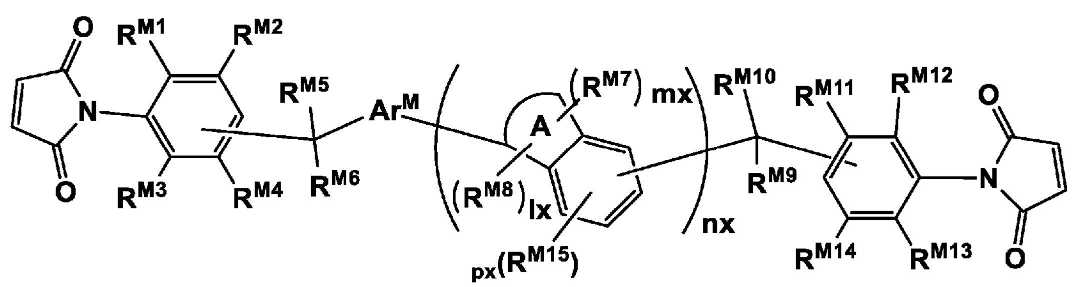

(M1)

(where $R^{M1}$, $R^{M2}$, $R^{M3}$, and $R^{M4}$ each independently represent a hydrogen atom or an organic group; $R^{M5}$ and $R^{M6}$ each independently represent a hydrogen atom or an alkyl group, $Ar^M$ represents a divalent aromatic group, A is a four- to six-membered alicyclic group, $R^{M7}$ and $R^{M8}$ are each independently an alkyl group, mx is 1 or 2, and lx is 0 or 1, $R^{M9}$ and $R^{M10}$ each independently represent a hydrogen atom or an alkyl group, $R^{M11}$, $R^{M12}$, $R^{M13}$, and $R^{M14}$ each independently

represent a hydrogen atom or an organic group, each $R^{M15}$ independently represents an alkyl group having from 1 to 10 carbon atoms, an alkyloxy group having from 1 to 10 carbon atoms, an alkylthio group having from 1 to 10 carbon atoms, a cycloalkyl group having from 3 to 10 carbon atoms, an aryl group having from 6 to 10 carbon atoms, an aryloxy group having from 6 to 10 carbon atoms, an arylthio group having from 6 to 10 carbon atoms, a halogen atom, a hydroxyl group, or a mercapto group, px represents an integer of from 0 to 3, nx represents an integer of from 1 to 20.)

$R^{M1}$, $R^{M2}$, $R^{M3}$, and $R^{M4}$ in the formula each independently represent a hydrogen atom or an organic group. The organic group here is preferably an alkyl group, more preferably an alkyl group having from 1 to 12 carbon atoms, still more preferably an alkyl group having from 1 to 6 carbon atoms, even more preferably a methyl group, an ethyl group, a propyl group, or a butyl group, and particularly preferably a methyl group among them. $R^{M1}$ and $R^{M3}$ each independently are preferably alkyl groups, and $R^{M2}$ and $R^{M4}$ are preferably hydrogen atoms.

$R^{M5}$ and $R^{M6}$ each independently represent a hydrogen atom or an alkyl group and are preferably alkyl groups. The alkyl group here is preferably an alkyl group having from 1 to 12 carbon atoms, more preferably an alkyl group having from 1 to 6 carbon atoms, still more preferably a methyl group, an ethyl group, a propyl group, or a butyl group, and particularly preferably a methyl group.

$Ar^M$ represents a divalent aromatic group and is preferably a phenylene group, a naphthalenediyl group, a phenanthrenediyl group, or an anthracenediyl group, more preferably a phenylene group, and even more preferably a m-phenylene group. $Ar^M$ may have a substituent, and the substituent is preferably an alkyl group, more preferably an alkyl group having from 1 to 12 carbon atoms, still more preferably an alkyl group having from 1 to 6 carbon atoms, even more preferably a methyl group, an ethyl group, a propyl group, or a butyl group, and particularly preferably a methyl group. However, $Ar^M$ is preferably unsubstituted.

A is a four- to six-membered alicyclic group and more preferably a five-membered alicyclic group (preferably a group to form an indane ring with a benzene ring). $R^{M7}$ and $R^{M8}$ each independently are alkyl groups, preferably alkyl groups having from 1 to 6 carbon atoms, more preferably alkyl groups having from 1 to 3 carbon atoms, and particularly preferably methyl groups.

mx is 1 or 2 and preferably 2.

lx is 0 or 1 and preferably 1.

$R^{M9}$ and $R^{M10}$ each independently represent a hydrogen atom or an alkyl group and are more preferably alkyl groups. The alkyl group here is preferably an alkyl group having from 1 to 12 carbon atoms, more preferably an alkyl group having from 1 to 6 carbon atoms, still more preferably a methyl group, an ethyl group, a propyl group, or a butyl group, and particularly preferably a methyl group.

$R^{M11}$,$R^{M12}$, $R^{M13}$, and $R^{M14}$ each independently represent a hydrogen atom or an organic group. The organic group here is preferably an alkyl group, more preferably an alkyl group having from 1 to 12 carbon atoms, still more preferably an alkyl group having from 1 to 6 carbon atoms, even more preferably a methyl group, an ethyl group, a propyl group, or a butyl group, and particularly preferably a methyl group among them. $R^{M12}$ and $R^{M13}$ each independently are preferably alkyl groups, and $R^{M11}$ and $R^{M14}$ are preferably hydrogen atoms.

Each $R^{M15}$ independently represents an alkyl group having from 1 to 10 carbon atoms, an alkyloxy group having from 1 to 10 carbon atoms, an alkylthio group having from 1 to 10 carbon atoms, a cycloalkyl group having from 3 to 10 carbon atoms, an aryl group having from 6 to 10 carbon atoms, an aryloxy group having from 6 to 10 carbon atoms, an arylthio group having from 6 to 10 carbon atoms, a halogen atom, a hydroxyl group, or a mercapto group, and is preferably an alkyl group having from 1 to 4 carbon atoms, a cycloalkyl group having from 3 to 6 carbon atoms, or an aryl group having from 6 to 10 carbon atoms.

px represents an integer of from 0 to 3, and is preferably an integer of from 0 to 2, more preferably 0 or 1, and still more preferably 0.

nx represents an integer of from 1 to 20. nx may be an integer of 10 or less.

The resin composition of the present embodiment may contain only one compound represented by Formula (M1) differing in the value of at least nx or may contain two or more of such compounds. When the resin composition contains the two or more compounds, the average value (average number of repeating units) n of nx in the compound represented by Formula (M1) in the resin composition is preferably 0.92 or more, more preferably 0.95 or more, still more preferably 1.0 or more, and still further more preferably 1.1 or more in order to lower the melting point (softening point), reduce the melt viscosity, and provide excellent handling properties. Also, n is preferably 10.0 or less, more preferably 8.0 or less, still more preferably 7.0 or less, and even more preferably 6.0 or less, and may be 5.0 or less. The same applies to compounds represented by Formula (M1-2) and Formula (M1-3) described later.

The compound represented by Formula (M1) is preferably a compound represented by the following Formula (M1-1).

[Chem. 46]

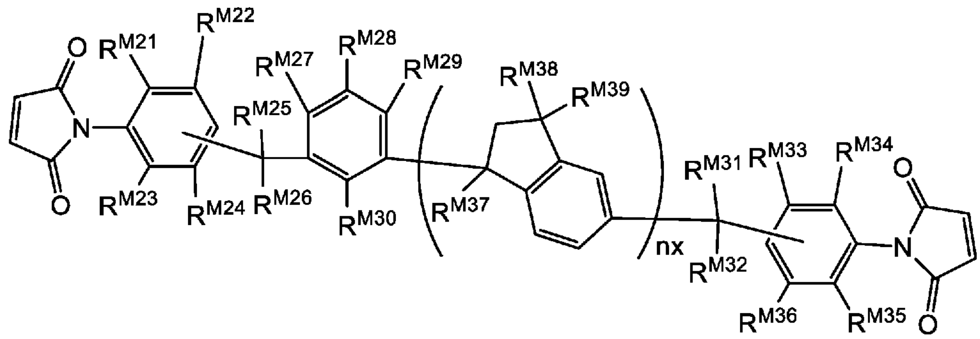

(M1-1)

(In Formula (M1-1), $R^{M21}$, $R^{M22}$, $R^{M23}$, and $R^{M24}$ each independently represent a hydrogen atom or an organic group. $R^{M25}$ and $R^{M26}$ each independently represent a hydrogen atom or an alkyl group. $R^{M27}$, $R^{M28}$, $R^{M29}$, and $R^{M30}$ each independently represent a hydrogen atom or an organic group. $R^{M31}$ and $R^{M32}$ each independently represent a hydrogen atom or an alkyl group. $R^{M33}$, $R^{M34}$, $R^{M35}$, and $R^{M36}$ each independently represent a hydrogen atom or an organic group. $R^{M37}$, $R^{M38}$, and $R^{M39}$ each independently represent a hydrogen atom or an alkyl group. nx represents an integer of 1 or more and 20 or less.)

$R^{M21}$,$R^{M22}$, $R^{M23}$, and $R^{M24}$ in the formula each independently represent a hydrogen atom or an organic group. The organic group here is preferably an alkyl group, more preferably an alkyl group having from 1 to 12 carbon atoms, still more preferably an alkyl group having from 1 to 6 carbon atoms, even more preferably a methyl group, an ethyl group, a propyl group, or a butyl group, and particularly preferably a methyl group. $R^{M21}$ and $R^{M23}$ are preferably an alkyl group, and $R^{M22}$ and $R^{M24}$ are preferably a hydrogen atom.

$R^{M25}$ and $R^{M26}$ each independently represent a hydrogen atom or an alkyl group and are preferably alkyl groups. The alkyl group here is preferably an alkyl group having from 1 to 12 carbon atoms, more preferably an alkyl group having from 1 to 6 carbon atoms, still more preferably a methyl group, an ethyl group, a propyl group, or a butyl group, and particularly preferably a methyl group.

$R^{M27}$, $R^{M28}$, $R^{M29}$, and $R^{M30}$ each independently represent a hydrogen atom or an organic group and are preferably hydrogen atoms. The organic group here is preferably an alkyl group, more preferably an alkyl group having from 1 to 12 carbon atoms, still more preferably an alkyl group having from 1 to 6 carbon atoms, even more preferably a methyl group, an ethyl group, a propyl group, or a butyl group, and particularly preferably a methyl group.

$R^{M31}$ and $R^{M32}$ each independently represent a hydrogen atom or an alkyl group and are preferably alkyl groups. The alkyl group here is preferably an alkyl group having from 1 to 12 carbon atoms, more preferably an alkyl group having from 1 to 6 carbon atoms, still more preferably a methyl group, an ethyl group, a propyl group, or a butyl group, and particularly preferably a methyl group.

$R^{M33}$, $R^{M34}$, $R^{M35}$, and $R^{M36}$ each independently represent a hydrogen atom or an organic group. The organic group here is preferably an alkyl group, more preferably an alkyl group having from 1 to 12 carbon atoms, still more preferably an alkyl group having from 1 to 6 carbon atoms, even more preferably a methyl group, an ethyl group, a propyl group, or a butyl group, and particularly preferably a methyl group.

$R^{M33}$ and $R^{M36}$ are preferably hydrogen atoms, and $R^{M34}$ and $R^{M35}$ are preferably alkyl groups.

$R^{M37}$, $R^{M38}$, and $R^{M39}$ each independently represent a hydrogen atom or an alkyl group and are preferably alkyl groups. The alkyl group here is preferably an alkyl group having from 1 to 12 carbon atoms, more preferably an alkyl group having from 1 to 6 carbon atoms, still more preferably a methyl group, an ethyl group, a propyl group, or a butyl group, and particularly preferably a methyl group.

nx represents an integer of 1 or more and 20 or less. nx may be an integer of 10 or less.

The compound represented by Formula (M1-1) is preferably a compound represented by Formula (M1-2) below.

[Chem.47]

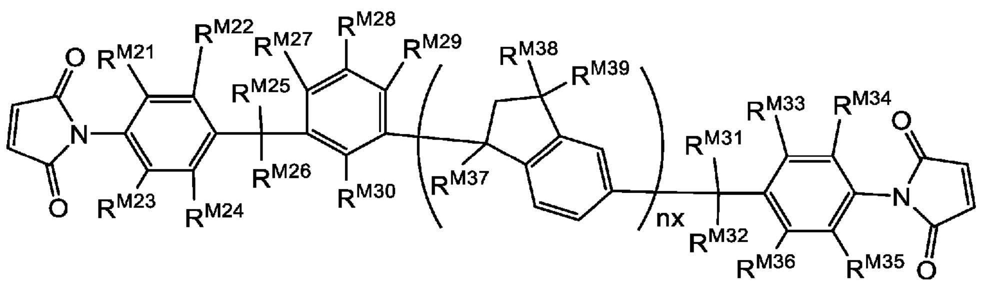

(M1-2)

(In Formula (M1-2), $R^{M21}$, $R^{M22}$, $R^{M23}$, and $R^{M24}$ each independently represent a hydrogen atom or an organic group. $R^{M25}$ and $R^{M26}$ each independently represent a hydrogen atom or an alkyl group. $R^{M27}$, $R^{M28}$, $R^{M29}$, and $R^{M30}$ each independently represent a hydrogen atom or an organic group. $R^{M31}$ and $R^{M32}$ each independently represent a hydrogen atom or an alkyl group. $R^{M33}$, $R^{M34}$, $R^{M35}$, and $R^{M36}$ each independently represent a hydrogen atom or an organic group. $R^{M37}$, $R^{M38}$, and $R^{M39}$ each independently represent a hydrogen atom or an alkyl group. nx represents an integer of 1 or more and 20 or less.)

In Formula (M1-2), $R^{M21}$, $R^{M22}$, $R^{M23}$, $R^{M24}$, $R^{M25}$, $R^{M26}$, $R^{M27}$, $R^{M28}$, $R^{M29}$, $R^{M30}$, $R^{M31}$, $R^{M32}$, $R^{M33}$, $R^{M34}$, $R^{M35}$, $R^{M36}$, $R^{M37}$, $R^{M38}$, $R^{M39}$, and nx have the same meanings as those of $R^{M21}$, $R^{M22}$, $R^{M23}$,$R^{M24}$,$R^{M25}$, $R^{M26}$, $R^{M27}$, $R^{M28}$, $R^{M29}$, $R^{M30}$, $R^{M31}$, $R^{M32}$, $R^{M33}$, $R^{M34}$, $R^{M35}$, $R^{M36}$, $R^{M37}$, $R^{M38}$, $R^{M39}$, and nx in Formula (M1-1), respectively, and preferred ranges thereof are also the same.

The compound represented by Formula (M1-1) is preferably a compound represented by Formula (M1-3) below, and more preferably a compound represented by Formula (M1-4) below.

[Chem.48]

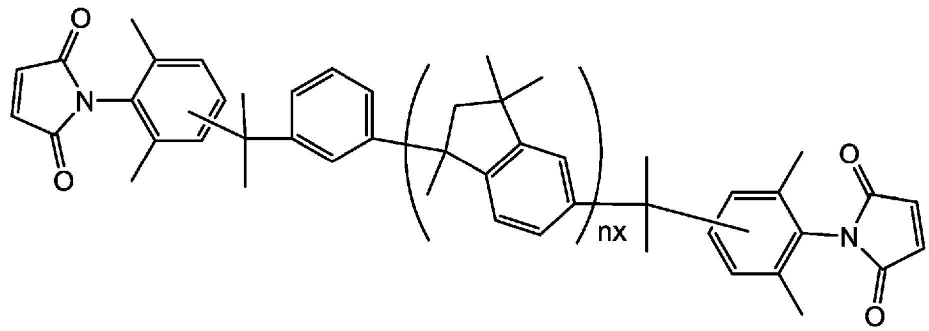

(M1-3)

(In Formula (M1-3), nx represents an integer of 1 or more and 20 or less.)

nx may be an integer of 10 or less.

[Chem.49]

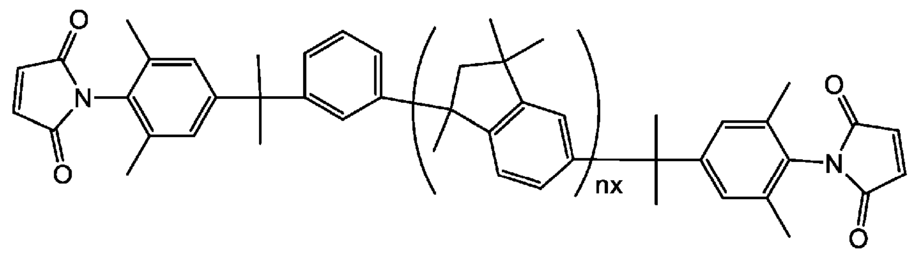

(M1-4)

(In Formula (M1-4), nx represents an integer of 1 or more and 20 or less.)

nx may be an integer of 10 or less.

The molecular weight of the compound represented by Formula (M1) is preferably 500 or more, more preferably 600 or more, and still more preferably 700 or more. When the molecular weight has a value equal to or more than the above-described lower limit value, the resulting cured product tends to have further improved low dielectric properties (Dk and/or Df) and the low water absorption. The molecular weight of the compound represented by Formula (M1) is preferably 10000 or less, more preferably 9000 or less, still more preferably 7000 or less, even preferably 5000 or less, and further more preferably 4000 or less. When the molecular weight is the above upper limit or less, the resulting cured product tends to have further improved thermal resistance and handleability.

In the compound represented by Formula (M1), a maleimide group equivalent is preferably 50 g/eq. or more, more preferably 100 g/eq. or more, and still more preferably 200 g/eq. or more. The upper limit of the maleimide group equivalent is preferably 2000 g/eq. or less, more preferably 1000 g/eq. or less, and still more preferably 800 g/eq. or less. Here, the maleimide group equivalent represents the mass of the maleimide compound per equivalent of the maleimide group. When the maleimide group equivalent of the compound represented by Formula (M1) is in the above range, the low dielectric properties (Dk and/or Df), low water absorption, thermal resistance and handleability of the resulting cured product tend to further improve.

In the compound represented by Formula (M1), the molecular weight distribution Mw/Mn calculated by gel permeation chromatography (GPC) measurement is preferably 1.0 to 4.0, more preferably 1.1 to 3.8, still more preferably

1.2 to 3.6, and even more preferably 1.3 to 3.4. When Mw/Mn of the compound represented by Formula (M1) is in the above range, the low dielectric properties (Dk and/or Df), low water absorption, thermal resistance and handleability of the resulting cured product tend to further improve.

In addition, for details of the compound represented by Formula (M1), reference can be made to the description of WO 2020-217679, the contents of which are incorporated herein by reference.

[Chem.50]

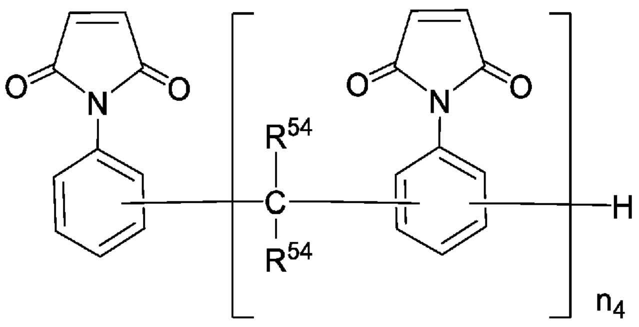

(M2)

(In Formula (M2), each $R^{54}$ independently represents a hydrogen atom or a methyl group; and $n_4$ represents an integer of 1 or more.)

$n_4$ is preferably an integer of from 1 to 10, more preferably an integer of from 1 to 5, still more preferably an integer of from 1 to 3, further preferably 1 or 2, and it may be 1.

The compound represented by Formula (M2) may be a mixture of compounds differing in $n_4$, and is preferably a mixture. In addition, as described in the section of the compound represented by Formula (M0), a mixture of compounds having different other moieties may be used.

[Chem.51]

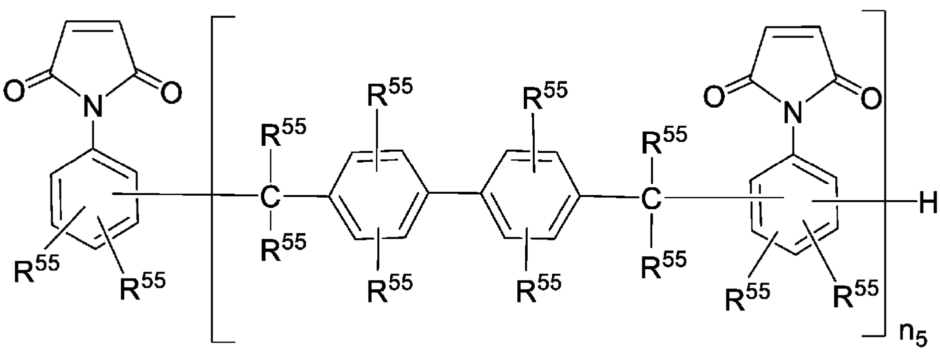

(M3)

(In Formula (M3), each $R^{55}$ independently represents a hydrogen atom, an alkyl group with 1 to 8 carbon atoms, or a phenyl group; and $n_5$ represents an integer of 1 or more and 10 or less.)

It is preferable that each $R^{55}$ is independently one selected from the group consisting of a hydrogen atom, a methyl group, an ethyl group, a n-propyl group, an isopropyl group, a n-butyl group, an isobutyl group, a t-butyl group, a n-pentyl group, or a phenyl group, more preferably a hydrogen atom and/or a methyl group, and still more preferably a hydrogen atom.

$n_5$ is preferably an integer of 1 or more and 5 or less, more preferably an integer of from 1 to 3, and still more preferably 1 or 2.

The compound represented by Formula (M3) may be a mixture of compounds differing in $n_5$, and is preferably a mixture. In addition, as described in the section of the compound represented by Formula (M0), a mixture of compounds having different other moieties may be used.

[Chem.52]

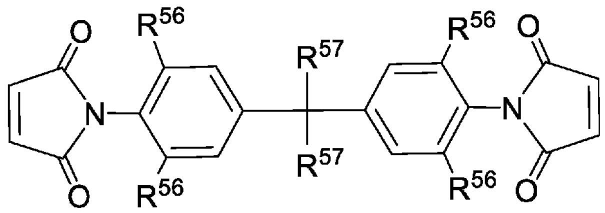

(M4)

(In Formula (M4), each $R^{56}$ independently represents a hydrogen atom, a methyl group, or an ethyl group, and each $R^{57}$ independently represents a hydrogen atom or a methyl group.)

It is preferable that each $R^{56}$ is independently a methyl group or an ethyl group, more preferably a methyl group or an ethyl group in each of the two benzene rings, and $R^{57}$ is preferably a methyl group.

[Chem.53]

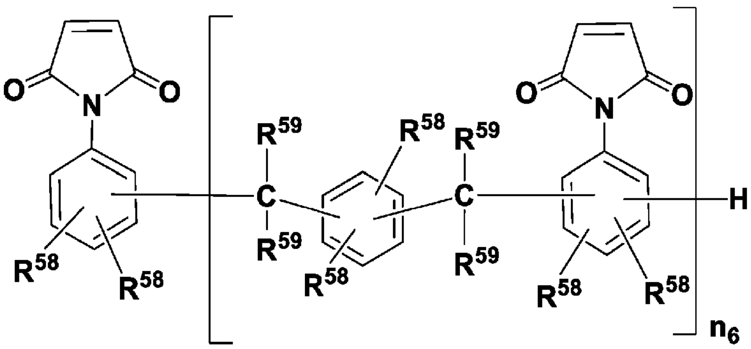

(M5)

(In Formula (M5), each $R^{58}$ independently represents a hydrogen atom, an alkyl group having from 1 to 8 carbon atoms, or a phenyl group; each $R^{59}$ independently represents a hydrogen atom or a methyl group; and $n_6$ represents an integer of 1 or more.)

It is preferable that each $R^{58}$ is independently one selected from the group consisting of a hydrogen atom, a methyl group, an ethyl group, a n-propyl group, an isopropyl group, a n-butyl group, an isobutyl group, a t-butyl group, a n-pentyl group, and a phenyl group, more preferably a hydrogen atom and/or a methyl group, and still more preferably a hydrogen atom.

$R^{59}$ is preferably a methyl group.

$n_6$ is preferably an integer of from 1 to 10, more preferably an integer of from 1 to 5, still more preferably an integer of from 1 to 3, and even more preferably 1 or 2, and may be 1.

The compound represented by Formula (M5) may be a mixture of compounds differing in $n_6$, and is preferably a mixture. In addition, as described in the section of the compound represented by Formula (M0), a mixture of compounds having different other moieties may be used.

The maleimide compound (M6) is a compound having a structural unit represented by Formula (M6) and maleimide groups at both terminals of the molecular chain and having a number average molecular weight of more than 400.

[Chem.54]

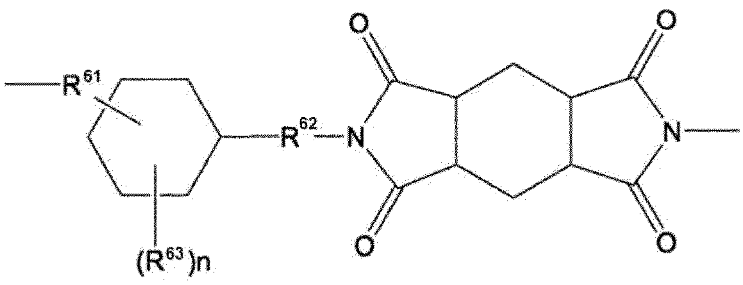

(M6)

(In Formula (M6), $R^{61}$ represents a linear or branched alkylene group having from 1 to 16 carbon atoms, or a linear or

branched alkenylene group having from 2 to 16 carbon atoms. $R^{62}$ represents a linear or branched alkylene group having from 1 to 16 carbon atoms, or a linear or branched alkenylene group having from 2 to 16 carbon atoms. each $R^{63}$ independently represents a linear or branched alkyl group having from 1 to 16 carbon atoms or a linear or branched alkenyl group having from 2 to 16 carbon atoms. each n independently represents an integer of from 0 to 10.)

For the details of the maleimide compound (M6) and a method for producing the maleimide compound, reference can be made to the description of paragraphs [0061] to [0066] of WO 2020/262577, the contents of which are incorporated herein by reference.

The maleimide compound (M7) is a maleimide compound formed from reaction raw materials (1), that are, an aromatic amine compound (a1) having one or more and three or less alkyl groups in an aromatic ring, an aromatic divinyl compound (a2) having two ethenyl groups, and maleic anhydride, and having a number average molecular weight of more than 400.

The maleimide compound (M7) is preferably a compound represented by Formula (M7).

[Chem.55]

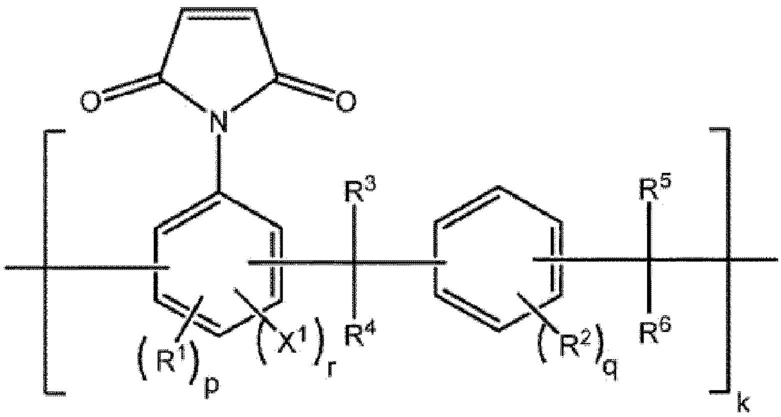

(M7)

(In Formula (M7) above, each $R^1$ independently represents an alkyl group having from 1 to 10 carbon atoms, each $R^2$ independently represents an alkyl group, an alkoxy group, or an alkylthio group each having from 1 to 10 carbon atoms; an aryl group, an aryloxy group, or an arylthio group each having from 6 to 10 carbon atoms; a cycloalkyl group having from 3 to 10 carbon atoms; a halogen atom; a hydroxyl group; or a mercapto group, $R^3$, $R^4$, $R^5$, and $R^6$ each independently represent a hydrogen atom or a methyl group, for $R^3$ and $R^4$, one is a hydrogen atom and the other is a methyl group, for $R^5$ and $R^6$, one is a hydrogen atom and the other is a methyl group,

$X^1$ represents a substituent represented by Formula (x) described below:

[Chem.56]

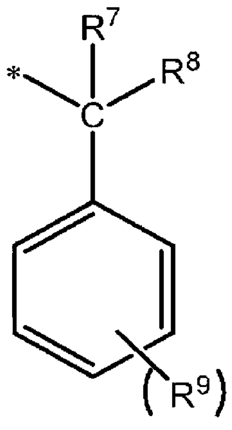

(x)

(In Formula (x), $R^7$ and $R^8$ each independently represent a hydrogen atom or a methyl group, for $R^7$ and $R^8$, one is a hydrogen atom and the other is a methyl group, each $R^9$ independently represents an alkyl group, an alkoxy group, or an alkylthio group each having from 1 to 10 carbon atoms; an aryl group, an aryloxy group, or an arylthio group each having

from 6 to 10 carbon atoms; a cycloalkyl group having from 3 to 10 carbon atoms; a halogen atom; a hydroxyl group; or a mercapto group, and t represents an integer from 0 to 4), and
r is an average value of the numbers of $X^1$ substituents per benzene ring to which $X^1$ is bonded and represents a number from 0 to 4, p represents an integer from 1 to 3, q represents an integer from 0 to 4, and k represents an integer from 1 to 100.)

For details of the maleimide compound (M7) used in the present embodiment, reference can be made to the description of JP 7160151 B, the contents of which are incorporated herein by reference.

The maleimide compound may be produced by a known method, or a commercially available product may be used. For the commercially available product, examples of the compound represented by Formula (M0) include "BMI-80" available from K-I Chemical Industry Co., Ltd., examples of the compound represented by Formula (M1) include "NE-X-9470S" and "NE-X-9480S" available from DIC Corporation, examples of the compound represented by Formula (M2) include "BMI-2300" available from Daiwa Kasei Industry Co., Ltd., examples of the compound represented by Formula (M3) include "MIR-3000" available from Nippon Kayaku Co., Ltd., examples of the compound represented by Formula (M4) include "BMI-70" available from K·I Chemical Industry Co., Ltd., examples of the compound represented by Formula (M5) include "MIR-5000" available from Nippon Kayaku Co., Ltd., examples of the maleimide compound (M6) include "MIZ-001" available from Nippon Kayaku Co., Ltd., and examples of the maleimide compound (M7) include "NE-X-9500" available from DIC Corporation.

Examples of the maleimide compound other than those described above include 4,4'-diphenylsulfone bismaleimide, 1,3-bis(3-maleimidophenoxy)benzene, and 1,3-bis(4-maleimidophenoxy) benzene.

The maleimide compound other than those described above may be a prepolymer of the maleimide compound and examples thereof include oligomers of N-phenylmaleimide, N-cyclohexylmaleimide, and phenylmethane maleimide, prepolymers of m-phenylene bismaleimide, 4-methyl-1,3-phenylene bismaleimide, 1,6-bismaleimide-(2,2,4-trimethyl) hexane, 4,4'-diphenylether bismaleimide, 4,4'-diphenylsulfone bismaleimide, 1,3-bis(3-maleimidophenoxy)benzene, 1,3-bis(4-maleimidophenoxy)benzene, and the like, and prepolymers of the maleimide compound and an amine.

<<Polymer having structural unit represented by Formula (V)>>

The resin composition of the present embodiment is a compound having a number average molecular weight of more than 400 and may contain a polymer having a structural unit represented by Formula (V). Inclusion of the resin composition contains a polymer having a structural unit represented by Formula (V) can provide a resin composition excellent in low dielectric properties (low permittivity and low dielectric loss tangent).

[Chem.57]

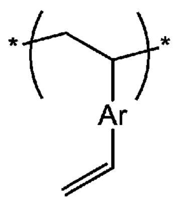

(V)

(In Formula (V), Ar represents an aromatic hydrocarbon linking group. * represents a bonding position.)

The aromatic hydrocarbon linking group may be a group including only an aromatic hydrocarbon that may have a substituent, or a group inducing a combination of an aromatic hydrocarbon that may have a substituent and any other linking group. The aromatic hydrocarbon linking group is preferably a group consisting only of an aromatic hydrocarbon that may have a substituent. Examples of the substituent which may be possessed by the aromatic hydrocarbon include a substituent Z (for example, an alkyl group having from 1 to 6 carbon atoms, an alkenyl group having from 2 to 6 carbon atoms, an alkynyl group having from 2 to 6 carbon atoms, an alkoxy group having from 1 to 6 carbon atoms, a hydroxy group, an amino group, a carboxy group, or a halogen atom). In addition, the aromatic hydrocarbon preferably has no substituent.

The aromatic hydrocarbon linking group is typically a divalent linking group.

Examples of the aromatic hydrocarbon linking group specifically include a phenylene group, a naphthalenediyl group, an anthracenediyl group, a phenanthrenediyl group, a biphenyldiyl group, and a fluorenediyl group, all of which may have a substituent. Among these, a phenylene group that may have a substituent is preferred. The substituent is exemplified by the substituent Z described above, while the group described above such as a phenylene group preferably has no substituent.

The polymer having the structural unit represented by Formula (V) more preferably contains at least one selected from a structural unit represented by Formula (V1) below, a structural unit represented by Formula (V2) below, and a

structural unit represented by Formula (V3) below. In formulas below, * represents a bonding position. Hereinafter, structural units represented by Formulas (V1) to (V3) may be collectively referred to as "structural unit (a)".

[Chem.58]

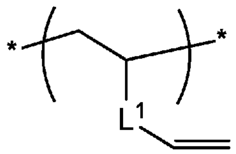

(V1)

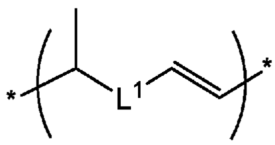

(V2)

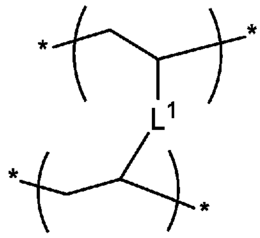

(V3)

In Formulas (V1) to (V3), $L^1$ is an aromatic hydrocarbon linking group (having preferably from 6 to 22, more preferably from 6 to 18, and still more preferably from 6 to 10 carbon atoms. Specifically, examples of the aromatic hydrocarbon linking group include a phenylene group, a naphthalenediyl group, an anthracenediyl group, a phenanthrenediyl group, a biphenyldiyl group, and a fluorenediyl group, all of which may have a substituent. Among these, a phenylene group that may have a substituent is preferred. The substituent is exemplified by the substituent Z described above, while the group described above such as a phenylene group preferably has no substituent.

A compound for forming the structural unit (a) is preferably a divinyl aromatic compound. That is, the polymer having the structural unit represented by Formula (V) preferably includes the structural unit (a) derived from a divinyl aromatic compound. Examples of the divinyl aromatic compound include divinylbenzene, bis(1-methylvinyl)benzene, divinylnaphthalene, divinylanthracene, divinylbiphenyl, and divinylphenanthrene. Among these, divinylbenzene is particularly preferred. One type of these divinyl aromatic compounds may be used, and two or more types thereof may be used as necessary.

As described above, the polymer having a structural unit represented by Formula (V) may be a homopolymer of the structural unit (a), or may be a copolymer with a structural unit derived from another monomer.

When the polymer having a structural unit represented by Formula (V) is a copolymer, the copolymerization ratio of the structural unit (a) is preferably 3 mol% or higher, more preferably 5 mol% or higher, still more preferably 10 mol% or higher, and may be 15 mol% or higher. The upper limit is preferably 90 mol% or less, more preferably 85 mol% or less, still more preferably 80 mol% or less, yet still more preferably 70 mol% or less, yet still more preferably 60 mol% or less, yet still more preferably 50 mol% or less, yet still more preferably 40 mol% or less, particularly preferably 30 mol% or less, and may be 25 mol% or less or 20 mol% or less.

Examples of the structural unit derived from another monomer include a structural unit (b) derived from an aromatic compound having one vinyl group (monovinyl aromatic compound).

The structural unit (b) derived from the monovinyl aromatic compound preferably includes a structural unit represented by Formula (V4) below.

[Chem.59]

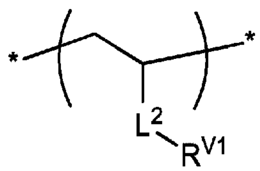

(V4)

In Formula (V4), $L^2$ is an aromatic hydrocarbon linking group, and preferred specific examples include the above-exemplified ones for $L^1$. * represents a bonding position.

$R^{V1}$ is a hydrogen atom or a hydrocarbon group having from 1 to 12 carbon atoms (preferably an alkyl group). When $R^{V1}$ is a hydrocarbon group, the number of its carbon atoms is preferably from 1 to 6 and more preferably from 1 to 3. $R^{V1}$ and $L^2$ may have the substituent Z described above.

When the polymer having the structural unit represented by Formula (V) is a copolymer containing the structural unit (b) derived from a monovinyl aromatic compound, examples of the monovinyl aromatic compound include: vinyl aromatic compounds such as styrene, vinylnaphthalene, and vinylbiphenyl; and nucleophilic alkyl-substituted vinyl aromatic compounds such as o-methylstyrene, m-methylstyrene, p-methylstyrene, o,p-dimethylstyrene, o-ethylvinylbenzene, m-ethylvinylbenzene, p-ethylvinylbenzene, methylvinylbiphenyl, and ethylvinylbiphenyl. The monovinyl aromatic compound exemplified here may have the substituent Z described above as appropriate. In addition, one, or two or more of these monovinyl aromatic compounds may be used. Among them, the structural unit (b) preferably includes a structural unit derived from at least one selected from the group consisting of o-ethylvinylbenzene, m-ethylvinylbenzene, and p-ethylvinylbenzene, and more preferably further includes a structural unit derived from styrene in addition to the structural unit derived from at least one selected from the group consisting of o-ethylvinylbenzene, m-ethylvinylbenzene, and p-ethylvinylbenzene.

When the polymer having the structural unit represented by Formula (V) is a copolymer containing the structural unit (b), the copolymerization ratio of the structural unit (b) is preferably 10 mol% or higher, and more preferably 15 mol% or higher, and further, may be 20 mol% or higher, 30 mol% or higher, 40 mol% or higher, 50 mol% or higher, 60 mol% or higher, 70 mol% or higher, or 75 mol% or higher. The upper limit thereof is preferably 98 mol% or less, more preferably 90 mol% or less, and still more preferably 85 mol% or less.

The polymer having the structural unit represented by Formula (V) may have an additional structural unit other than the structural unit (a) or the structural unit (b). Examples of the additional structural unit include a structural unit (c) derived from a cycloolefin compound. Examples of the cycloolefin compound include hydrocarbon atoms having a double bond in the ring structure. Specifically, examples include monocyclic olefins, such as cyclobutene, cyclopentene, cyclohexene, and cyclooctene; additionally, compounds having a norbornene ring structure, such as norbornene and dicyclopentadiene; and cycloolefin compounds in which an aromatic ring is fused, such as indene and acenaphthylene. Examples of the norbornene compounds include those described in paragraphs [0037] to [0043] of JP 2018-039995 A, the contents of which are incorporated herein by reference. The cycloolefin compounds exemplified here may further include the substituent Z described above.

When the polymer having the structural unit represented by Formula (V) is a copolymer containing the structural unit (c), the copolymerization ratio of the structural unit (c) is preferably 10 mol% or higher, more preferably 20 mol% or higher, and still more preferably 30 mol% or higher. The upper limit thereof is preferably 90 mol% or less, more preferably 80 mol% or less, still more preferably 70 mol% or less, and may be 50 mol% or less or 30 mol% or less.

The polymer having the structural unit represented by Formula (V) may further contain a structural unit (d) derived from yet another polymerizable compound (hereinafter may be referred to as the additional polymerizable compound). Examples of the additional polymerizable compound (monomer) include compounds containing three vinyl groups. Specific examples include 1,3,5-trivinylbenzene, 1,3,5-trivinylnaphthalene, and 1,2,4-trivinylcyclohexane. Alternatively, examples thereof include ethylene glycol diacrylate, 1,3-butadiene, and isoprene. A copolymerization ratio (d) of the structural unit (d) derived from the additional polymerizable compound is preferably 30 mol% or less, more preferably 20 mol% or less, and still more preferably 10 mol% or less.

An embodiment of the polymer having the structural unit represented by Formula (V) is exemplified by a polymer containing the structural unit (a) as an essential unit and at least one of the structural units (b) to (d). Furthermore, an aspect in which the total of the structural units (a) to (d) accounts for 95 mol% or higher or even 98 mol% or higher of all the structural units is exemplified.

Another embodiment of the polymer having the structural unit represented by Formula (V) is preferably a polymer having the structural unit (a) as an essential unit, in which a structural unit containing an aromatic ring accounts for 90 mol% or higher, more preferably account for 95 mol% or higher, or may account for 100 mol%, of all the structural units excluding the terminal.

When calculating the mol% per all the structural units, one structural unit is defined as a unit derived from one molecule of a monomer (such as a divinyl aromatic compound, a monovinyl aromatic compound, or the like) used for producing the polymer having the structural unit represented by Formula (V).

The method for producing the polymer having the structural unit represented by Formula (V) is not particularly limited, and a common method can be used. Examples include a method in which a raw material containing a divinyl aromatic compound is polymerized in the presence of a Lewis acid catalyst (as needed, in the coexistence of a monovinyl aromatic compound, a cycloolefin compound, or the like). As the Lewis acid catalyst, a metal fluoride, such as boron trifluoride, or a complex thereof can be used.

The chain end structure of the polymer having the structural unit represented by Formula (V) is not particularly limited; however, regarding the chain end structure of the group derived from the divinyl aromatic compound, examples of the chain end include a structure of Formula (E1) described below. In Formula (E1), $L^1$ is the same as that defined for Formula (V1) above, and * * represents a bonding position.

$$*\text{-CH} = \text{CH-}L^1\text{-CH} = \text{CH}_2 \qquad \text{(E1)}$$

When the group derived from the monovinyl aromatic compound is at a chain end, examples of the chain end structure include a structure of Formula (E2) below. In the formula, $L^2$ and $R^{V1}$ each have the same meaning as that defined for Formula (V4) above. * represents a bonding position.

$$*\text{-CH} = \text{CH-L}^2\text{-R}^{V1} \qquad (E2)$$

The molecular weight of the polymer having the structural unit represented by Formula (V) is more than 400, more preferably 500 or more, still more preferably 1000 or more, and even more preferably 1500 or more as the number average molecular weight Mn. The upper limit of the number average molecular weight Mn is preferably 130000 or less, more preferably 120000 or less, still more preferably 110000 or less, and yet still more preferably 100000 or less, and it may be 30000 or less, 10000 or less, or 5000 or less.

The molecular weight of the polymer having the structural unit represented by Formula (V) in terms of weight average molecular weight Mw is preferably 3000 or more, more preferably 5000 or more, and still more preferably 10000 or more. When the molecular weight is the above lower limit or more, a cured product of the resin composition is enabled to effectively exhibit the excellent low dielectric properties possessed by the polymer having the structural unit represented by Formula (V), particularly the Df and the dielectric properties after moisture absorption. The upper limit of the weight average molecular weight Mw is preferably 130000 or less, more preferably 100000 or less, still more preferably 80000 or less, and even more preferably 50000 or less. When the molecular weight is the above upper limit or less, an embedding defect tends to hardly occur when the prepreg or the resin sheet is laminated on a circuit-forming substrate.

A monodispersity (Mw/Mn) represented by a ratio of the weight average molecular weight Mw to the number average molecular weight Mn is preferably 100 or less, more preferably 50 or less, and still more preferably 20 or less, and may be 15 or less or 12 or less. The lower limit is practically 1.1 or more, preferably 2.0 or more, more preferably 4 or more, still more preferably 5 or more, even more preferably 7 or more, and further more preferably 8 or more.

The Mw and Mn are measured in accordance with the description in Examples to be described later.

When the resin composition of the present embodiment contains two or more polymers having the structural unit represented by Formula (V), the Mw, Mn, and Mw/Mn of the mixture are preferably within the respective ranges described above.

The equivalent of the vinyl group of the polymer having the structural unit represented by Formula (V) is preferably 200 g/eq. or more, more preferably 230 g/eq. or more, still more preferably 250 g/eq. or more, and may be 300 g/eq. or more, or 350 g/eq. or more. The equivalent of the vinyl group is preferably 1200 g/eq. or less, and more preferably 1000 g/eq. or less, and further may be 800 g/eq. or less, 600 g/eq. or less, 500 g/eq. or less, 400 g/eq. or less, or 350 g/eq. or less. When the vinyl group equivalent is the above lower limit or more, the storage stability of the resin composition tends to improve, and the fluidity of the resin composition tends to improve. Thus, there is a tendency that moldability is improved, voids are less likely to occur at the time of forming a prepreg, and a printed wiring board having higher reliability is obtained. Meanwhile, when the vinyl group equivalent is the above upper limit or less, the thermal resistance of the resulting cured product tends to improve.

The glass transition temperature of the polymer having the structural unit represented by Formula (V) is preferably 170°C or more, more preferably 180°C or more, still more preferably 190°C or more, and yet still more preferably 200°C or more. The upper limit of the glass transition temperature is preferably 350°C or less, and may be 300°C or less. The glass transition temperature can be determined by measuring a dynamic viscoelasticity of a measurement sample with a starting temperature of 30°C, an ending temperature of 400°C, a temperature rise rate of 5°C/min, and a measurement frequency of 1 Hz under a nitrogen atmosphere in accordance with JIS K 7244-4: 1999 (Plastics-Test Methods for Dynamic Mechanical Properties-Part 4: Tensile Vibration-Non-Resonant Method) using a dynamic viscoelasticity analyzer, and taking the maximum value of the loss tangent (tan$\sigma$) obtained in the measurement as the glass transition temperature. For the dynamic viscoelasticity analyzer, EXSTAR 6000 DMS6100 available from Seiko Instruments Inc. can be used.

A cured product of the polymer having the structural unit represented by Formula (V) preferably has excellent low dielectric properties. For example, the cured product of the polymer having the structural unit represented by Formula (V) used in the present embodiment has a relative permittivity (Dk), measured at 10 GHz in accordance with a cavity resonator perturbation method, of preferably 2.80 or less, more preferably 2.60 or less, still more preferably 2.50 or less, and yet still more preferably 2.40 or less. The lower limit of the relative permittivity is practically, for example, 1.80 or more. The cured product of the polymer having the structural unit represented by Formula (V) has a dielectric loss tangent (Df) measured at 10 GHz in accordance with the cavity resonator perturbation method of preferably 0.0030 or less, more preferably 0.0020 or less, and still more preferably 0.0010 or less. The lower limit of the dielectric loss tangent is practically, for example, 0.0001 or more.

The relative permittivity (Dk) and the dielectric loss tangent (Df) are measured by the following method.

4.5 g of the resin powder was spread in a stainless steel mold frame of 100 mm × 30 mm × 1.0 mm in height, set in a vacuum press machine (available from KITAGAWA SEIKI CO., LTD.), held at 200°C, 220°C, and 240°C for 1.5 hours, and pressed at a surface pressure of 1.9 MPa to produce a cured plate.

The cured plate was downsized to a width of 1.0 mm and then dried at 120°C for 60 minutes, and the relative permittivity (Dk) and the dielectric loss tangent (Df) at 10 GHz after drying were measured using a cavity resonator based

on the perturbation method. The measurement is conducted at a temperature of 23°C.

As the cavity resonator based on the perturbation method, P5005A available from Keysite Technologies was used.

For the polymer having the structural unit represented by Formula (V) in the present specification, reference can be made to compounds, their synthesis conditions, and the like described in paragraphs [0029] to [0058] of WO 2017/115813, compounds, their synthesis conditions, and the like described in paragraphs [0013] to [0058] of JP 2018-039995 A, compounds, their synthesis conditions, and the like described in paragraphs [0008] to [0043] of JP 2018-168347 A, compounds, their synthesis conditions, and the like described in paragraphs [0014] to [0042] of JP 2006-070136 A, compounds, their synthesis conditions, and the like described in paragraphs [0014] to [0061] of JP 2006-089683 A, and compounds, their synthesis conditions, and the like described in paragraphs [0008] to [0036] of JP 2008-248001 A, the contents of which are incorporated herein by reference.

<<Polyphenylene ether compound having carbon-carbon unsaturated double bond at terminal>>

The resin composition of the present embodiment may be a compound having a number average molecular weight of more than 400 and contain a polyphenylene ether compound having a carbon-carbon unsaturated double bond at a terminal.

The polyphenylene ether compound having a carbon-carbon unsaturated double bond at the terminal is more preferably a polyphenylene ether compound having two or more carbon-carbon unsaturated double bonds at the terminal.

In the present embodiment, the carbon-carbon unsaturated double bond is more preferably a polyphenylene ether compound including one or more groups selected from the group consisting of a (meth)acryloyl group and a vinylbenzyl group. When the polyphenylene ether compound including these groups is used, dielectric properties of a printed wiring board and the like and low water absorption tend to be more effectively improved.

In the present embodiment, it is also preferable to contain both a polyphenylene ether compound having a group represented by Formula (Rx-1) at the terminal and a polyphenylene ether compound having a group represented by Formula (Rx-2) at the terminal, which will be described later. With such a structure, the resulting cured product has more excellent low dielectric properties (Dk and/or Df, in particular Df), and the thermal resistance (low dielectric properties (Dk and/or Df, in particular Df) after heating) over time of the resulting cured product can be more effectively maintained.

Hereinafter, these details will be described.

Examples of the polyphenylene ether compound having a carbon-carbon unsaturated double bond at the terminal include a compound having a phenylene ether skeleton represented by Formula (X1) below.

[Chem.60]

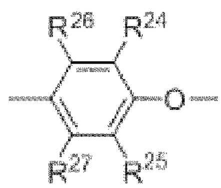

(X1)

(In Formula (X1), $R^{24}$, $R^{25}$, $R^{26}$, and $R^{27}$ may be the same or different, and each represent an alkyl group having 6 or fewer carbon atoms, an aryl group, a halogen atom, or a hydrogen atom.)

The polyphenylene ether compound containing a carbon-carbon unsaturated double bond at a terminal may further include a repeating unit represented by Formula (X2):

[Chem.61]

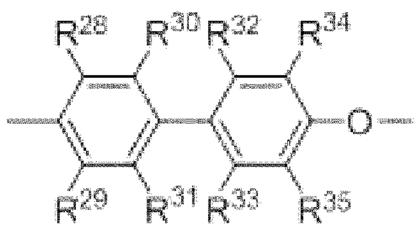

(X2)

(In Formula (X2), $R^{28}$, $R^{29}$, $R^{30}$, $R^{34}$, and $R^{35}$ may be the same or different, and each represents an alkyl group having 6 or fewer carbon atoms or a phenyl group, $R^{31}$, $R^{32}$, and $R^{33}$ may be the same or different, and each represent a hydrogen atom, an alkyl group having 6 or less carbon atoms, or a phenyl group.), and/or a repeating unit represented by Formula

(X3):

[Chem.62]

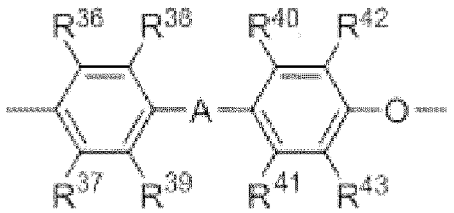

(X3)

(In Formula (X3), $R^{36}$, $R^{37}$, $R^{38}$, $R^{39}$, $R^{40}$, $R^{41}$, $R^{42}$, and $R^{43}$ may be the same or different, and each represent a hydrogen atom, an alkyl group having 6 or less carbon atoms, or a phenyl group; and -A- is a linear, branched, or cyclic divalent hydrocarbon group having 20 or fewer carbon atoms.)

The polyphenylene ether compound having a carbon-carbon unsaturated double bond at a terminal is preferably a modified polyphenylene ether compound (which may be hereinafter referred to as a "modified polyphenylene ether compound (g)") in which some or all terminals are functionalized with an ethylenically unsaturated group and more preferably a modified polyphenylene ether compound having two or more groups selected from the group consisting of (meth)acryloyl groups and vinylbenzyl groups at a terminal. Employing such a modified polyphenylene ether compound (g) enables the cured product of the resin composition to have further reduced dielectric loss tangent (Df) and to exhibit enhanced low water absorption and increased the peel strength. One type of the modified polyphenylene ether compounds (g) may be used alone, or two or more types thereof may be used in combination.

Examples of the modified polyphenylene ether compound (g) include a polyphenylene ether compound that is a compound having a number average molecular weight of more than 400 and is represented by Formula (OP).

[Chem.63]

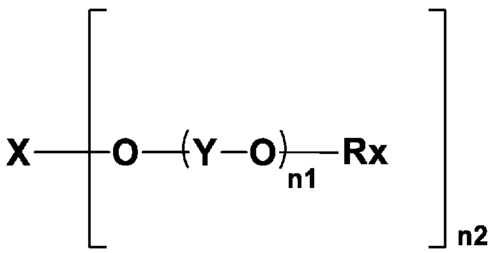

(OP)

(In Formula (OP), X represents an aromatic group; $-(Y-O)_{n1}-$represents a polyphenylene ether structure; n1 represents an integer from 1 to 100; n2 represents an integer from 1 to 4. and Rx is a group represented by Formula (Rx-1) or Formula (Rx-2).)

[Chem.64]

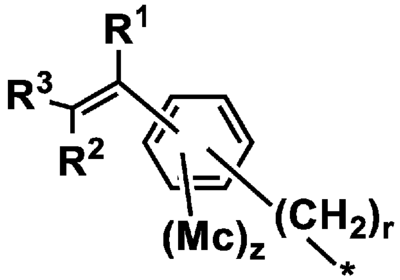

(Rx-1)

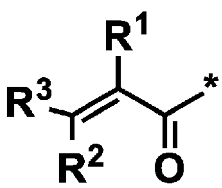

(Rx-2)

(where $R^1$, $R^2$, and $R^3$ each independently represent a hydrogen atom, an alkyl group, an alkenyl group, or an alkynyl group, * is a bonding position for an oxygen atom, each Mc independently represents a hydrocarbon group having from 1 to 12 carbon atoms, z represents an integer of from 0 to 4, and r represents an integer of from 0 to 6.)

The aromatic group represented by X may or may not have a substituent on the benzene ring, yet preferably has a substituent. In the case of having a substituent, the above-described substituent can be exemplified, and the substituent is preferably at least one selected from the group consisting of an alkyl group having 6 or less carbon atoms, an aryl group,

and a halogen atom, more preferably an alkyl group having 3 or less carbon atoms, and still more preferably a methyl group.

The polyphenylene ether structure represented by -(Y-O)$n_1$-may or may not have a substituent on the benzene ring, yet preferably has a substituent. In the case of having a substituent, the above-described substituent can be exemplified, and the substituent is preferably an alkyl group having 6 or less carbon atoms or a phenyl group, more preferably an alkyl group having 3 or less carbon atoms, and still more preferably a methyl group.

When $n_1$ and/or $n_2$ are/is each an integer of 2 or more, $n_1$ structural units (Y-O) and/or $n_2$ structural units may be the same as or different from each other. $n_2$ is preferably 2 or more and more preferably 2.

In Formula (Rx-1) and Formula (Rx-2), $R^1$, $R^2$, and $R^3$ each independently represent a hydrogen atom, an alkyl group, an alkenyl group, or an alkynyl group.

$R^1$ is preferably a hydrogen atom or an alkyl group, more preferably a hydrogen atom or a methyl group, and still more preferably a hydrogen atom.

$R^2$ and $R^3$ are each independently preferably a hydrogen atom or an alkyl group, more preferably a hydrogen atom or a methyl group, and still more preferably a hydrogen atom.

The number of carbon atoms of the alkyl group, the alkenyl group, and the alkynyl group as $R^1$, $R^2$, and $R^3$ is each preferably 5 or less, and more preferably 3 or less.

In Formula (Rx-1), r represents an integer of from 0 to 6, and may be an integer of 1 or more, and preferably an integer of 5 or less, more preferably an integer of 4 or less, still more preferably an integer of 3 or less, yet still more preferably 1 or 2, and yet still more preferably 1.

In Formula (Rx-1), each Mc independently represents a hydrocarbon group having from 1 to 12 carbon atoms, and is preferably a hydrocarbon group having from 1 to 10 carbon atoms, more preferably a linear or branched alkyl group having from 1 to 10 carbon atoms, still more preferably a methyl group, an ethyl group, an isopropyl group, an isobutyl group, a t-butyl group, a pentyl group, an octyl group, or a nonyl group, and even more preferably a methyl group, an ethyl group, an isopropyl group, an isobutyl group, or a t-butyl group.

In Formula (Rx-1), z represents an integer of from 0 to 4, and is preferably an integer of from 0 to 3, more preferably an integer of from 0 to 2, still more preferably 0 or 1, and even more preferably 0.

A specific example of the group represented by Formula (Rx-1) is a vinylbenzyl group, and a specific example of the group represented by Formula (Rx-2) is a (meth)acryloyl group.

It is also preferable that the resin composition of the present embodiment contains, as the polyphenylene ether compound having a carbon-carbon unsaturated double bond at the terminal, both a polyphenylene ether compound that is a compound represented by Formula (OP) and has a group represented by Formula (Rx-1) and a compound having a polyphenylene ether group having a group represented by Formula (Rx-2).

Examples of the modified polyphenylene ether compound (g) include a compound having a number average molecular weight of more than 400 and represented by Formula (OP-1).

[Chem. 65]

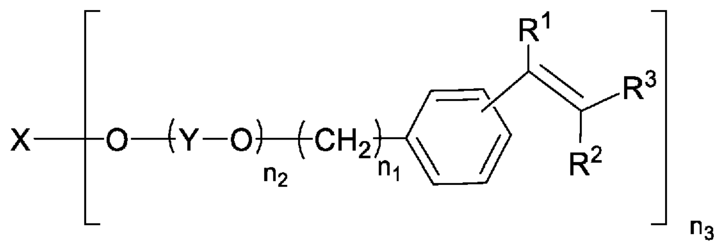

(OP-1)

(In Formula (OP-1), X represents an aromatic group; -(Y-O)$n_2$-represents a polyphenylene ether structure; $R^1$, $R^2$, and $R^3$ each independently represent a hydrogen atom, an alkyl group, an alkenyl group, or an alkynyl group; $n_1$ represents an integer of from 0 to 6; $n_2$ represents an integer of from 1 to 100; and $n_3$ represents an integer of from 1 to 4.)

The aromatic group represented by X may or may not have a substituent on the benzene ring, yet preferably has a substituent. In the case of having a substituent, the above-described substituent can be exemplified, and the substituent is preferably at least one selected from the group consisting of an alkyl group having 6 or less carbon atoms, an aryl group, and a halogen atom, more preferably an alkyl group having 3 or less carbon atoms, and still more preferably a methyl group.

The polyphenylene ether structure represented by -(Y-O)$n_2$-may or may not have a substituent in the benzene ring, yet preferably has a substituent. In the case of having a substituent, the above-described substituent can be exemplified, and the substituent is preferably an alkyl group having 6 or less carbon atoms or a phenyl group, more preferably an alkyl group having 3 or less carbon atoms, and still more preferably a methyl group.

When $n_2$ and/or $n_3$ is an integer of 2 or more, $n_2$ pieces of structural units (Y-O) and/or $n_3$ pieces of structural units

may each be the same or different. $n_3$ is preferably 2 or more and more preferably 2.

The modified polyphenylene ether compound (g) in the present embodiment is preferably a compound represented by Formula (OP-2).

[Chem.66]

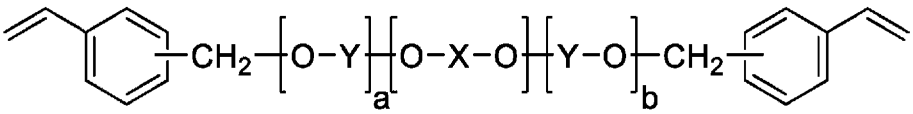

(OP-2)

In this case, -(O-X-O)- is preferably represented by Formula (OP-3):

[Chem.67]

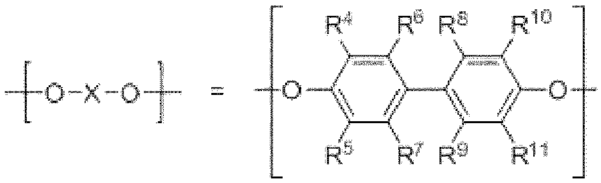

(OP-3)

(In Formula (OP-3), $R^4$, $R^5$, $R^6$, $R^{10}$, and $R^{11}$ may be the same or different, and are each an alkyl group having 6 or less carbon atoms or a phenyl group; and $R^7$, $R^8$, and $R^9$ may be the same or different, and are each a hydrogen atom, an alkyl group having 6 or less carbon atoms, or a phenyl group.)

and/or Formula (OP-4):

[Chem.68]

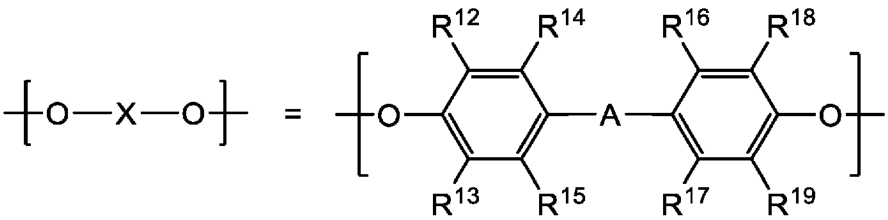

(OP-4)

(In Formula (OP-4), $R^{12}$, $R^{13}$, $R^{14}$, $R^{15}$, $R^{16}$, $R^{17}$, $R^{18}$, and $R^{19}$ may be the same or different, and are each a hydrogen atom, an alkyl group having 6 or less carbon atoms, or a phenyl group; and -A-is a linear, branched, or cyclic divalent hydrocarbon group having 20 or fewer carbon atoms.)

Moreover, -(Y-O)- is preferably represented by Formula (OP-5) :

[Chem.69]

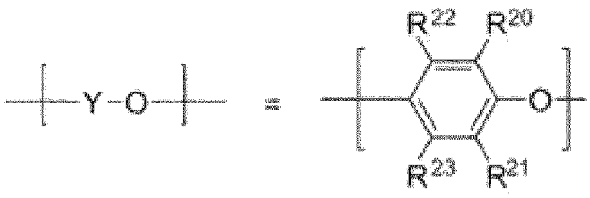

(OP-5)

(In Formula (OP-5), $R^{20}$ and $R^{21}$ may be the same or different, and are each an alkyl group having 6 or less carbon atoms or a phenyl group; $R^{22}$ and $R^{23}$ may be the same or different, and are each a hydrogen atom, an alkyl group having 6 or fewer carbon atoms, or a phenyl group.)

In particular, when $R^{20}$ and $R^{21}$ are each independently a group having one or more methyl groups and/or cyclohexyl groups, the rigidity of the resulting resin molecule is increased, and a molecule having high rigidity has lower mobility than a molecule having low rigidity, so that a relaxation time during dielectric relaxation is lengthened, and the low dielectric properties (Dk and/or Df, in particular Dk) are excellent, which is preferred.

An example of Formula (OP-5) is the following structure.

[Chem.70]

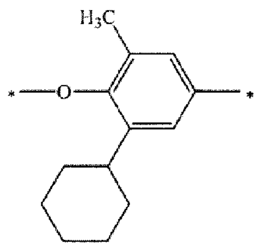

For the polyphenylene ether compound having the above-described structure, reference can be made to the description of JP 2019-194312 A, the contents of which are incorporated herein by reference.

In Formula (OP-2), a and b each independently represent an integer of from 0 to 100, and at least one of a and b is an integer of from 1 to 100. a and b are each independently preferably an integer of from 0 to 50, more preferably an integer of from 1 to 30, and preferably an integer of from 1 to 10. When a and/or b is an integer of 2 or more, two or more -(Y-O) - may each independently have one type of structure that is arranged sequentially, or two or more types of structures that are arranged in blocks or randomly.

When a plurality of compounds represented by Formula (OP-2) are contained, an average value of a is preferably $1 < a < 10$, and an average value of b is preferably $1 < b < 10$.

Examples of -A- in Formula (OP-4) include, but are not limited to, divalent organic groups such as a methylene group, an ethylidene group, a 1-methylethylidene group, 1,1-propylidene group, 1,4-phenylene bis(1-methylethylidene) group, 1,3-phenylene bis(1-methylethylidene) group, a cyclohexylidene group, a phenylmethylene group, a naphthylmethylene group, and 1-phenylethylidene group.

Among the compounds represented by Formula (OP-2), preferred is a polyphenylene ether compound in which $R^4$, $R^5$, $R^6$, $R^{10}$, $R^{11}$, $R^{20}$, and $R^{21}$ are each an alkyl group having 3 or fewer carbon atoms, and $R^7$, $R^8$, $R^9$, $R^{12}$, $R^{13}$, $R^{14}$, $R^{15}$, $R^{16}$, $R^{17}$, $R^{18}$, $R^{19}$, $R^{22}$, and $R^{23}$ are each a hydrogen atom or an alkyl group having 3 or fewer carbon atoms, and in particular, -(O-X-O)- represented by Formula (OP-3) or Formula (OP-4) is preferably Formula (OP-9), Formula (OP-10), and/or Formula (OP-11), and -(Y-O)-represented by Formula (OP-5) is preferably Formula (OP-12) or Formula (OP-13). When a and/or b are/is each an integer of 2 or more, two or more -(Y-O)- may each independently have a structure in which two or more of Formula (OP-12) and/or Formula (OP-13) are arranged, or a structure in which Formula (OP-12) and Formula (OP-13) are arranged in blocks or randomly.

[Chem.71]

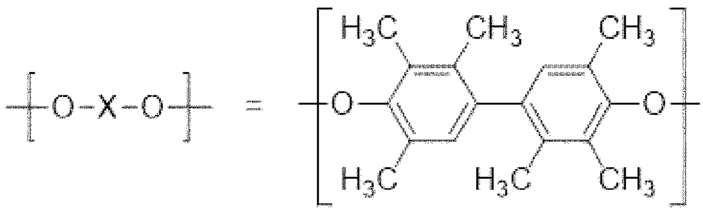

(OP-9)

[Chem.72]

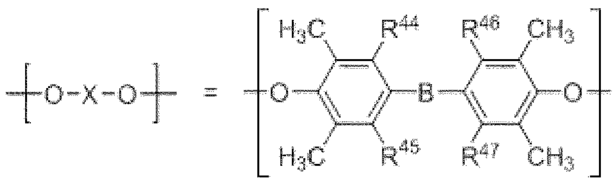

(OP-10)

(In Formula (OP-10), $R^{44}$, $R^{45}$, $R^{46}$, and $R^{47}$ may be the same or different, and are hydrogen atoms or methyl groups. -B- is a linear, branched, or cyclic divalent hydrocarbon group having 20 or fewer carbon atoms.)

Specific examples of -B- include the same as those for the specific examples of -A- in Formula (OP-4).

[Chem.73]

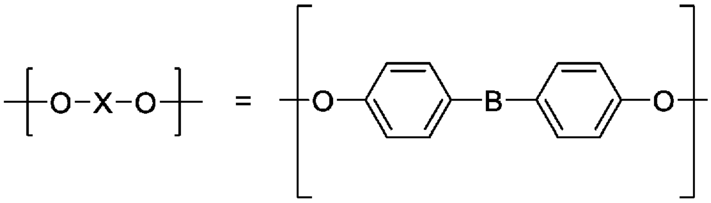

(OP-11)

(In Formula (OP-11), -B- is a linear, branched, or cyclic divalent hydrocarbon group having 20 or fewer carbon atoms.)

Specific examples of -B- include the same as those for the specific examples of -A- in Formula (OP-4).

[Chem.74]

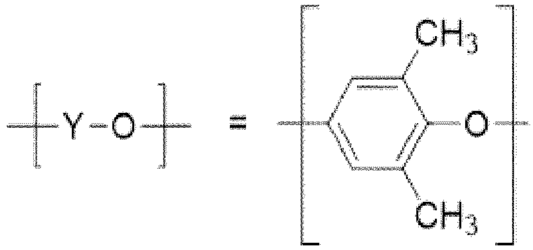

(OP-12)

[Chem.75]

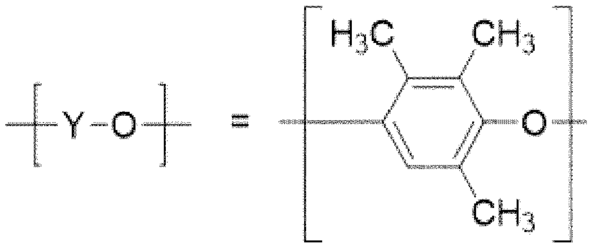

(OP-13)

The modified polyphenylene ether compound (g) is more preferably a compound represented by Formula (OP-14) and/or a compound represented by Formula (OP-15), and still more preferably the compound represented by Formula (OP-15).

[Chem.76]

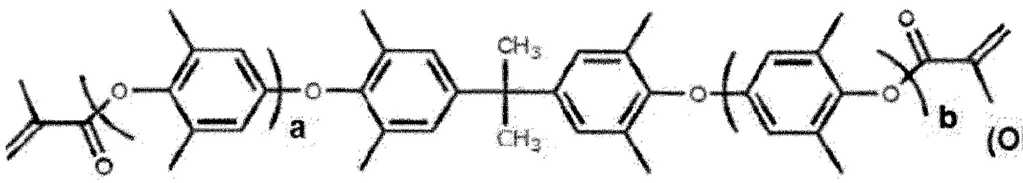

(OP-14)

(In Formula (OP-14), a and b each independently represent an integer of from 0 to 100, and at least one of a or b is an integer of from 1 to 100.)

In Formula (OP-14), a and b are independently synonymous with a and b in Formula (OP-2), respectively, and preferred ranges thereof are also the same.

[Chem.77]

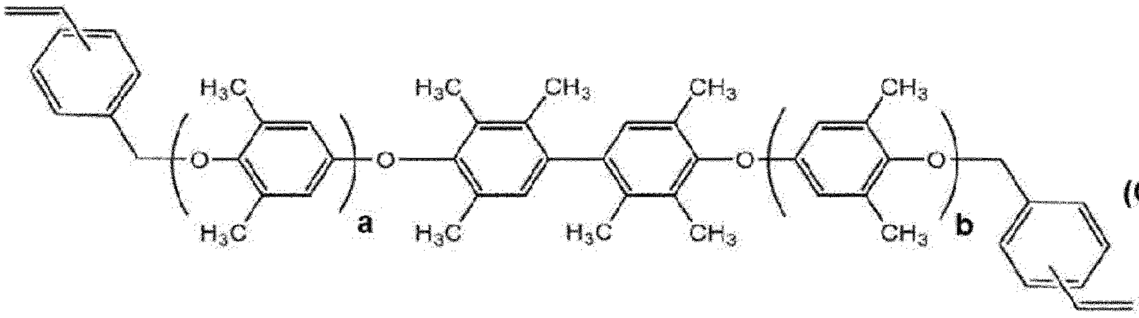

(OP-15)

(In Formula (OP-15), a and b each independently represent an integer of from 0 to 100, and at least one of a or b is an integer of from 1 to 100.)

a and b in Formula (OP-15) each independently have the same meaning as a and b in Formula (OP-2), and preferred ranges thereof are also the same.

The polyphenylene ether compound having a carbon-carbon unsaturated double bond at the terminal may be produced by a known method, or a commercially available product thereof may be used. Examples of the commercially available product include "SA9000" available from SABIC Innovative Plastics as a modified polyphenylene ether compound whose terminal is a methacryloyl group. Examples of the modified polyphenylene ether compound whose terminal is a vinylbenzyl group include "OPE-2St1200" and "OPE-2St2200" available from MITSUBISHI GAS CHEMICAL COMPANY, INC. As the modified polyphenylene ether compound whose terminal is a vinylbenzyl group, a compound, obtained by modifying the hydroxyl group at the terminal of a polyphenylene ether compound, such as "SA90" available from SABIC Innovative Plastics, to a vinylbenzyl group using vinylbenzyl chloride or the like, can also be used.

In addition to the above description, regarding details of the polyphenylene ether compound having a carbon-carbon unsaturated double bond at a terminal, reference can be made to the description of JP 2006-028111 A, JP 2018-131519 A, WO 2019/138992, and WO 2022/054303, the contents of which are incorporated herein by reference.

The polyphenylene ether compound having a carbon-carbon unsaturated double bond at a terminal (preferably, the modified polyphenylene ether compound (g)) preferably has a number average molecular weight of from 500 to 3000 measured by the GPC (gel permeation chromatography) method calibrated with polystyrene standards (the details are according to the method described in Examples described later). When the number average molecular weight is 500 or more, stickiness tends to be further prevented when the resin composition of the present embodiment is formed into a coating film. When the number average molecular weight is 3000 or less, solubility in a solvent tends to be further improved.

A weight average molecular weight of the polyphenylene ether compound having a carbon-carbon unsaturated double bond at a terminal (preferably, the modified polyphenylene ether compound (g)) measured by GPC calibrated with polystyrene standards (the details are according to the method described in Examples described later) is preferably from 800 to 10000 and more preferably from 800 to 5000. When the weight average molecular weight is the above lower limit or more, the relative permittivity (Dk) and dielectric loss tangent (Df) of a cured product of the resin composition tend to further decrease, whereas when the weight average molecular weight is the above upper limit or less, the solubility of the resin composition in a solvent, and the low viscosity properties and the moldability of the resin composition tend to further improve during production of the below-described varnish.

Furthermore, in the polyphenylene ether compound (preferably, the modified polyphenylene ether compound (g)) having a carbon-carbon unsaturated double bond at a terminal, a carbon-carbon unsaturated double bond equivalent at a terminal is preferably from 400 to 5000 g, and more preferably from 400 to 2500 g, per carbon-carbon unsaturated double bond. When the terminal carbon-carbon unsaturated double bond equivalent is the above lower limit or more, the relative permittivity (Dk) and dielectric loss tangent (Df) of a cured product of the resin composition tend to further decrease, whereas when the terminal carbon-carbon unsaturated double bond equivalent is the above upper limit or less, the solubility of the resin composition in a solvent, and the low viscosity properties and the moldability of the resin composition tend to further improve.

The functional group equivalent (equivalent of carbon-carbon unsaturated double bond) in the polyphenylene ether compound having a carbon-carbon unsaturated double bond at its terminal is calculated from the inverse of the amount of double bonds, which is determined from the measurement results using an infrared spectrometer.

The double bond equivalent [g/eq.] was determined as follows.

Powder of the polyphenylene ether compound is weighed, and the weight is recorded. The powder is put into a measuring flask, and then the volume is increased to a predetermined amount with carbon disulfide to prepare a measurement sample. The sample solution is placed in a measurement cell and set in an infrared spectrophotometer

(FT/IR-4600, available from JASCO Corporation). Subsequently, the sample solution is subjected to infrared spectrometry. In the case of the vinyl group in the polyphenylene ether compound, the peak area of the spectrum around 905 $cm^{-1}$ is recorded. When the carbon-carbon unsaturated double bond has a methacrylic group, the peak area of the spectrum around 1640 $cm^{-1}$ is recorded. From the area values and the calibration curve, a double bond concentration [mol/L] is determined as a measured value.

Subsequently, the double bond equivalent is calculated by the following equation.

Double bond equivalent [g/eq.] = weight of powder in measurement sample [g]/double bond concentration [mol/L] × volume of measurement sample solution [L]

The functional group equivalents of the additional compound (C) and the compound (B) can also be determined according to the method described above. However, in a compound (monomer) that can be represented by a single molecular weight, a value obtained by calculating a functional group equivalent by (theoretical molecular weight ÷ number of functional groups) is preferentially adopted in both the compound (C) and the compound (B). When two or more additional compounds (C) are contained, the functional group equivalent of the additional compound (C) is a sum (weighted average value) of values obtained by multiplying the functional group equivalent of each compound (C) by a mass fraction. Even when two or more additional compounds (B) are contained, the functional group equivalent can be determined in the same manner as the compound (C).

As described above, the resin composition of the present embodiment is a compound having a number average molecular weight of more than 400, and preferably contains one or more selected from the group consisting of a maleimide compound, a polymer having a structural unit represented by Formula (V), and a polyphenylene ether compound having a carbon-carbon unsaturated double bond at a terminal.

A total content of the maleimide compound having a number average molecular weight of more than 400, the polymer having a structural unit represented by Formula (V), and the polyphenylene ether compound having a carbon-carbon unsaturated double bond at a terminal in the resin composition of the present embodiment is preferably 1 part by mass or more, more preferably 5 parts by mass or more, still more preferably 10 parts by mass or more, even more preferably 20 parts by mass or more, further more preferably 30 parts by mass or more, and may be 40 parts by mass or more, with respect to 100 parts by mass of the resin solid content. The upper limit of the content is preferably 90 parts by mass or less, more preferably 75 parts by mass or less, still more preferably 60 parts by mass or less, and may be 50 parts by mass or less or 40 parts by mass or less.

The resin composition in the present embodiment may contain only one kind or two or more kinds of each of the maleimide compound having a number average molecular weight of more than 400, the polymer having a structural unit represented by Formula (V), and the polyphenylene ether compound having a carbon-carbon unsaturated double bond at a terminal.

<<Cyanate ester compound>>

The resin composition of the present embodiment may contain a cyanate ester compound having a number average molecular weight of more than 400.

The cyanate ester compound is not particularly limited as long as it is a compound containing one or more (preferably 2 or more, more preferably 2 to 12, further more preferably 2 to 6, still more preferably 2 to 4, even more preferably 2 or 3, even still more preferably 2) cyanate groups (cyanato groups) per molecule, and a wide variety of compounds commonly used in the field of printed wiring boards can be used. The cyanate ester compound is preferably a compound in which the cyanate group is directly bonded to an aromatic backbone (aromatic ring).

Examples of the cyanate ester compound include at least one selected from the group consisting of phenol novolac-type cyanate ester compounds, naphthol aralkyl-type cyanate ester compounds (naphthol aralkyl-type cyanates), naphthylene ether-type cyanate ester compounds, biphenyl aralkyl-type cyanate ester compounds, xylene resin-type cyanate ester compounds, trisphenol methane-type cyanate ester compounds, bisphenol M-type cyanate ester compounds, bisphenol A-type cyanate ester compounds, bisphenol E-type cyanate ester compounds, diallyl bisphenol A-type cyanate ester compounds, indancinate compounds, and adamantane skeleton-type cyanate ester compounds, which have a number average molecular weight of more than 400, and oligomers thereof. Among these, from the viewpoints of further improving the low water absorption of the resulting cured product, the cyanate ester compound is preferably at least one selected from the group consisting of phenol novolac-type cyanate ester compounds, naphthol aralkyl-type cyanate ester compounds, naphthylene ether-type cyanate ester compounds, and xylene resin-type cyanate ester compounds, which have a number average molecular weight of more than 400, more preferably at least one selected from the group consisting of phenol novolac-type cyanate ester compounds and naphthol aralkyl-type cyanate ester compounds, which have a number average molecular weight of more than 400, and still more preferably naphthol aralkyl-type cyanate ester compounds having a number average molecular weight of more than 400. Such a cyanate ester compound may be prepared by a known method, or a commercially available product may be used. A cyanate ester compound having a naphthol aralkyl backbone, a naphthylene ether backbone, a xylene backbone, a trisphenol methane backbone, or an adamantane backbone has a relatively large number of functional group equivalents and a small number of unreacted cyanate ester groups, and thus the cured product of the resin composition formed using the cyanate ester compound of these tends to have even better low water absorption. In addition, mainly due to having an aromatic skeleton or an adamantane skeleton, plating adhesion tends to be further improved.

The naphthol aralkyl-type cyanate ester compound is more preferably a compound (resin) represented by Formula (1) and having a number average molecular weight of more than 400.

[Chem.78]

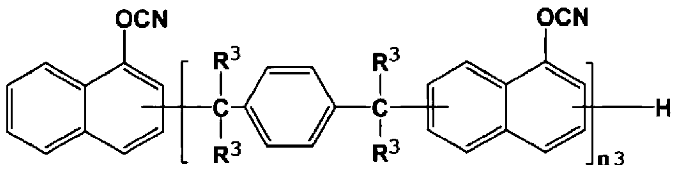

(1)

(In Formula (1), each $R^3$ independently represents a hydrogen atom or a methyl group, and n3 represents an integer of 1 or more.)

In Formula (1), each $R^3$ independently represents a hydrogen atom or a methyl group, and among these, a hydrogen atom is preferable.

In Formula (1), n3 is an integer of 1 or more, and preferably an integer of from 1 to 20, more preferably an integer of from 1 to 10, and still more preferably an integer of from 1 to 6.

The novolac-type cyanate ester compound is not particularly limited, and for example, a compound (resin) represented by Formula (VII) and having a number average molecular weight of more than 400 is preferable.

[Chem.79]

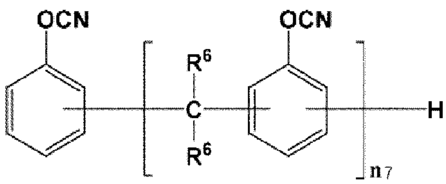

(VII)

(In Formula (VII), each $R^6$ independently represents a hydrogen atom or a methyl group; and n7 represents an integer of 1 or more.)

In Formula (VII), each $R^6$ independently represents a hydrogen atom or a methyl group, and among them, a hydrogen atom is preferred.

In Formula (VII), n7 is an integer of 1 or more, preferably an integer of from 1 to 20, more preferably an integer of from 1 to 10, and still more preferably an integer of from 1 to 6.

As the bisphenol A-type cyanate ester compound, one or more selected from the group consisting of 2,2-bis(4-cyanatophenyl)propane and a prepolymer of 2,2-bis(4-cyanatophenyl)propane may be used.

Examples of the indancinate compound include a compound represented by Formula (a) below.

Formula (a)

[Chem.80]

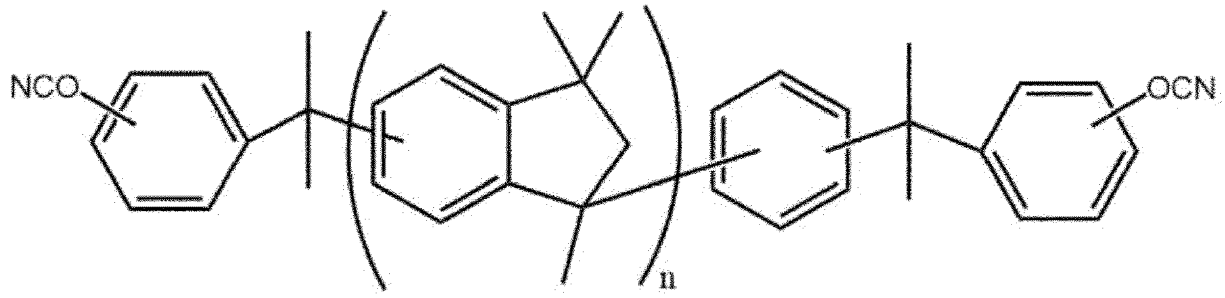

(In Formula (a), n is an average number of repetitions and is a number of 3.0 or more and 15.0 or less.)

As the cyanate ester compound, a compound described in paragraphs 0035 to 0061 of JP 2024-110099 can also be used in addition to the above, the contents of which are incorporated herein by reference.

When the resin composition of the present embodiment contains the cyanate ester compound having a number average molecular weight of more than 400, the content of the cyanate ester compound is preferably 0.1 parts by mass or more, more preferably 1 part by mass or more, and still more preferably 2 parts by mass or more with respect to 100 parts by mass of the resin solid content in the resin composition. When the content of the cyanate ester compound is 0.1 parts by mass or more, peel strength and toughness tend to be improved. The upper limit of the content of the cyanate ester compound having a number average molecular weight of more than 400 is preferably 50 parts by mass or less, more preferably 30 parts by mass or less, still more preferably 20 parts by mass or less, even more preferably 10 parts by mass or less, and may be 8 parts by mass or less or 5 parts by mass or less, with respect to 100 parts by mass of the resin solid content in the resin composition. With the content of the cyanate ester compound being 50 parts by mass or less, the resulting cured product tends to improve in electrical properties.

The resin composition of the present embodiment may contain only one type of cyanate ester compound having a number average molecular weight of more than 400 or may contain two or more types of the cyanate ester compounds. When two or more aliphatic polyamide resins are contained, the total amount is preferably in the range described above.

In addition, the resin composition in the present embodiment can also be configured to contain substantially no cyanate ester compound having a number average molecular weight of more than 400. The phrase "contain substantially no" means that the content of the cyanate ester compound is less than 0.1 parts by mass with respect to 100 parts by mass of the resin solid content in the resin composition, and the content is preferably less than 0.01 parts by mass, and may be less than 0.001 parts by mass.

<<Epoxy compound>>

The resin composition of the present embodiment may contain an epoxy compound having a number average molecular weight of more than 400.

The epoxy compound is not particularly limited as long as it is a compound or resin having one or more (preferably from 2 to 12, more preferably from 2 to 6, still more preferably from 2 to 4, even more preferably 2 or 3, and further more preferably 2) epoxy groups per molecule, and compounds usually used in the field of printed wiring boards can be commonly used.

Examples of the epoxy compound include: compounds having a number average molecular weight of more than 400 and obtained by epoxidizing double bonds such as a phenol novolac-type epoxy resin, a bisphenol A novolac-type epoxy resin, a glycidyl ester-type epoxy resin, an aralkyl novolac-type epoxy resin, a biphenyl aralkyl-type epoxy resin, a naphthylene ether-type epoxy resin, a cresol novolac-type epoxy resin, a polyfunctional phenol-type epoxy resin, a naphthalene-type epoxy resin, an anthracene-type epoxy resin, a naphthalene skeleton modified novolac-type epoxy resin, a phenol aralkyl-type epoxy resin, a naphthol aralkyl-type epoxy resin, a dicyclopentadiene-type epoxy resin, a biphenyl-type epoxy resin, an alicyclic epoxy resin, a polyol-type epoxy resin, a phosphorus-containing epoxy resin, glycidylamine, a glycidyl ester, and butadiene; and compounds obtained by reacting hydroxyl group-containing silicone resins with epichlorohydrin. The use of such a compound improves the moldability and adhesion of the resin composition. Among these, the epoxy compound is preferably one or more selected from the group consisting of a biphenyl aralkyl-type epoxy resin, a naphthylene ether-type epoxy resin, a polyfunctional phenol-type epoxy resin, and a naphthalene-type epoxy resin, and more preferably a biphenyl aralkyl-type epoxy resin, from the viewpoint of further improving flame retardancy and thermal resistance.

When the resin composition of the present embodiment contains the epoxy compound having a number average molecular weight of more than 400, the content of the epoxy compound is preferably 0.1 parts by mass or more, more preferably 1 part by mass or more, and still more preferably 2 parts by mass or more with respect to 100 parts by mass of the resin solid content in the resin composition. When the content of the epoxy compound is 0.1 parts by mass or more, peel

strength and toughness tend to be improved. The upper limit of the content of the epoxy compound having a number average molecular weight of more than 400 is preferably 50 parts by mass or less, more preferably 30 parts by mass or less, still more preferably 20 parts by mass or less, even more preferably 10 parts by mass or less, and may be 8 parts by mass or less or 5 parts by mass or less, with respect to 100 parts by mass of the resin solid content in the resin composition. With the content of the epoxy compound being 50 parts by mass or less, the resulting cured product tends to improve in electrical properties.

The resin composition of the present embodiment may contain only one type of epoxy compound having a number average molecular weight of more than 400 or may contain two or more types of the epoxy compounds. When two or more aliphatic polyamide resins are contained, the total amount is preferably in the range described above.

In addition, the resin composition in the present embodiment can also be configured to contain substantially no epoxy compound having a number average molecular weight of more than 400. The phrase "contain substantially no" means that the content of the epoxy compound is less than 0.1 parts by mass with respect to 100 parts by mass of the resin solid content in the resin composition, and the content is preferably less than 0.01 parts by mass, and may be less than 0.001 parts by mass.

<<Phenolic compound>>

The resin composition of the present embodiment may contain a phenolic compound having a number average molecular weight of more than 400.

The phenolic compound is any phenolic compound having one or more (preferably from 2 to 12, more preferably from 2 to 6, still more preferably from 2 to 4, yet still more preferably 2 or 3, and yet still more preferably 2) phenolic hydroxyl groups per molecule and is not particularly limited, and a wide variety of compounds commonly used in the field of printed wiring boards can be used.

Examples of the phenolic compound include a phenolic novolac resin, a bisphenolic A novolac-type phenolic resin, a glycidyl ester-type phenolic resin, an aralkyl novolac phenolic resin, a biphenyl aralkyl-type phenolic resin, a cresol novolac-type phenolic resin, a polyfunctional phenolic resins, a naphthol resin, a naphthol novolac resin, a polyfunctional naphthol resin, an anthracene-type phenolic resin, a naphthalene skeleton-modified novolac-type phenolic resin, a phenolic aralkyl-type phenolic resin, a naphthol aralkyl-type phenolic resin, a dicyclopentadiene-type phenolic resin, a biphenyl-type phenolic resin, an alicyclic phenolic resin, a polyol-type phenolic resin, a phosphorus-containing phenolic resin, and a hydroxyl group-containing silicone resin, which have a number average molecular weight of more than 400. Among these, from the viewpoints of further improving the flame resistance of the resulting cured product, the phenolic compound is preferably at least one selected from the group consisting of biphenyl aralkyl-type phenolic resins, naphthol aralkyl-type phenolic resins, phosphorus-containing phenolic resins, and hydroxyl group-containing silicone resins.

Other examples of the phenolic compound that can be used in the present embodiment and has a number average molecular weight of more than 400 include a resin having a hydroxyl group obtained by reacting a mixture containing a compound represented by Formula (DIP) and a compound represented by Formula (P1).

[Chem.81]

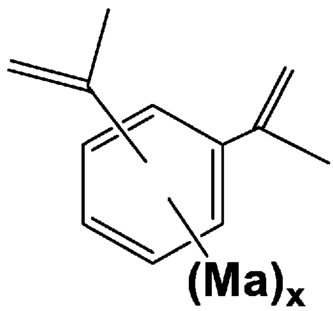

**(DIP)**

(where each Ma independently represents a hydrocarbon group having from 1 to 12 carbon atoms, each carbon atom being optionally substituted with a halogen atom, and x represents an integer of from 0 to 4.)

[Chem.82]

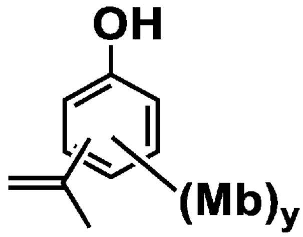

(P1)

(In Formula (P1), each Mb independently represents a hydroxyl group, a halogen atom, or a hydrocarbon group having from 1 to 20 carbon atoms, each carbon atom being optionally substituted with a hydroxyl group or a halogen atom. y represents an integer of from 0 to 4.)

Formula (DIP) has the same meaning as Formula (DIP) described in the section of the resin (IP1) described later, and the preferred range thereof is also the same.

In Formula (P1), Mb and y each independently have the same meanings as Mb and y in Formula (T-St) described later, respectively, and the preferred ranges thereof are also the same.

For details of the resin having a hydroxyl group obtained by reacting a mixture containing the compound represented by Formula (DIP) and the compound represented by Formula (P1), reference can be made to the description of JP 2022-180443, the contents of which are incorporated herein by reference.

Other examples of the phenolic compound that can be used in the present embodiment and has a number average molecular weight of more than 400 include a hydroxy resin represented by Formula (T-OH).

[Chem.83]

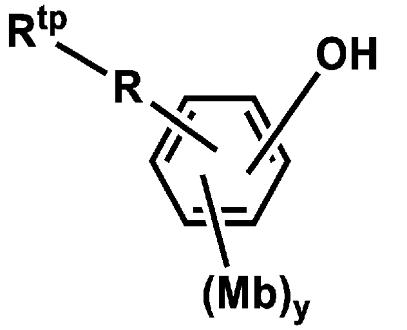

(T-OH)

(In Formula (T-OH), R is a group containing a structural unit represented by Formula (Tx). $R^{tp}$ is a hydrogen atom, a hydroxyl group, an isopropenyl group, or another group. each Mb independently represents a hydroxyl group, a halogen atom, or a hydrocarbon group having from 1 to 20 carbon atoms, each carbon atom being optionally substituted with a hydroxyl group or a halogen atom. y represents an integer of from 0 to 4.)

[Chem.84]

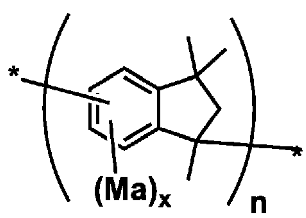

(a)

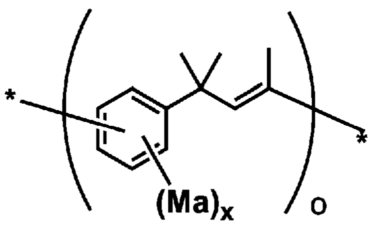

(b)

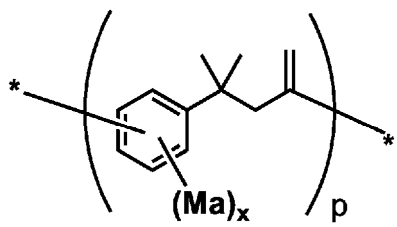

(c)

(Tx)

(In Formula (Tx), n, o, and p are average numbers of repeating units, n represents a number more than 0 and 20 or less, o and p each independently represent a number of from 0 to 20, and $1.0 \leq n + o + p \leq 20.0$. each Ma independently represents a hydrocarbon group having from 1 to 12 carbon atoms, each carbon atom being optionally substituted with a halogen atom. x represents an integer of from 0 to 4. the structural units (a), (b), and (c) are each bonded at * to the structural unit (a), (b), or (c), or an additional group, and structural units may be randomly bonded.)

Formula (T-OH) is preferably represented by Formula (T-OH2), and more preferably represented by Formula (T-OH3).

[Chem.85]

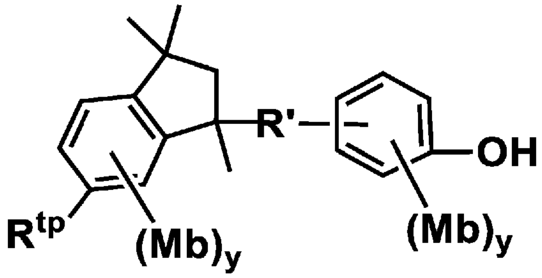

(T-OH2)

(In Formula (T-OH2), R' is a group to be a group containing a structural unit represented by Formula (Tx) in combination with the group having an indane skeleton adjacent to the left side, and $R^{tp}$ is a hydrogen atom, a hydroxyl group, an isopropenyl group, or another group. each Mb independently represents a hydroxyl group, a halogen atom, or a hydrocarbon group having from 1 to 20 carbon atoms, each carbon atom being optionally substituted with a hydroxyl group or a halogen atom. y represents an integer of from 0 to 4.)

[Chem.86]

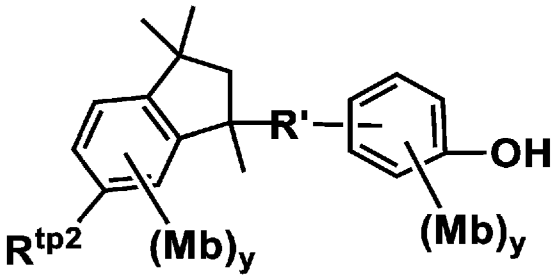

(T-OH3)

(In Formula (T-OH3), R' is a group to be a group containing a structural unit represented by Formula (Tx) in combination with the group having an indane skeleton adjacent to the left side, and $R^{tp2}$ represents a hydroxyl group or an isopropenyl group. each Mb independently represents a hydroxyl group, a halogen atom, or a hydrocarbon group having from 1 to 20 carbon atoms, each carbon atom being optionally substituted with a hydroxyl group or a halogen atom. y represents an integer of from 0 to 4.)

In Formula (T-OH), R has the same meaning as R in Formula (T1-1) described above, and the preferred range thereof is also the same. Mb and y each independently have the same meaning as Mb and y in Formula (T-St) described later, and the preferred ranges thereof are also the same. $R^{tp}$ is preferably a hydroxyl group or an isopropenyl group, and more preferably a hydroxyl group.

In Formula (T-OH2) and Formula (T-OH3), R' has the same meaning as R in Formula (T1-1) described above, and the preferred range thereof is also the same. Mb and y each independently have the same meaning as Mb and y in Formula (T-St) described later, and the preferred ranges thereof are also the same.

In Formula (T-OH2), $R^{tp}$ is preferably a hydroxyl group or an isopropenyl group, and more preferably a hydroxyl group. In Formula (T-OH3), $R^{tp2}$ is preferably a hydroxyl group.

For details of the hydroxy resins represented by Formulas (T-OH1) to (T-OH3), reference can be made to the description of JP 2022-180444, the contents of which are incorporated herein by reference.

Other examples of the phenolic compound that can be used in the present embodiment and has a number average molecular weight of more than 400 also include a hydroxy resin represented by Formula (T-OH4).

[Chem.87]

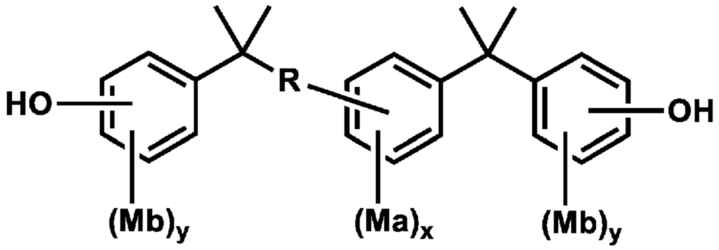

(T-OH4)

(In Formula (T-OH4), R is a group containing a structural unit represented by Formula (Tx). each Ma independently represents a hydrocarbon group having from 1 to 12 carbon atoms, each carbon atom being optionally substituted with a halogen atom. each Mb independently represents a hydroxyl group, a halogen atom, or a hydrocarbon group having from 1 to 20 carbon atoms, each carbon atom being optionally substituted with a hydroxyl group or a halogen atom. x and y each independently represent an integer of from 0 to 4.)

[Chem.88]

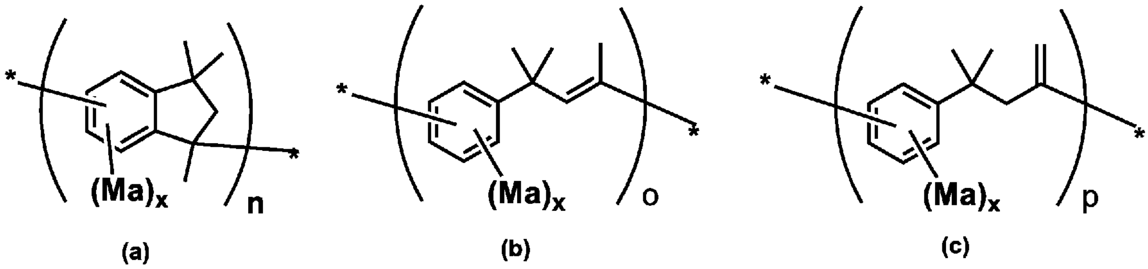

(Tx)

(In Formula (Tx), n, o, and p are average numbers of repeating units, n represents a number more than 0 and 20 or less, o and p each independently represent a number of from 0 to 20, and $1.0 \leq n + o + p \leq 20.0$. each Ma independently represents a hydrocarbon group having from 1 to 12 carbon atoms which is optionally substituted with a halogen atom. x represents an integer of from 0 to 4. the structural units (a), (b), and (c) are each bonded at * to the structural unit (a), (b), or (c), or an additional group, and structural units may be randomly bonded.)

In Formula (T-OH4), Ma and x each independently have the same meanings as Ma and x in Formula (T1), respectively, and the preferred ranges thereof are also the same.

In Formula (T-OH4), Mb and y each independently have the same meanings as Mb and y in Formula (T-St) described later, respectively, and the preferred ranges thereof are also the same.

In Formula (T-OH4), R has the same meaning as R in Formula (T-OH), and the preferred range thereof is also the same.

For details of the hydroxy resin represented by Formula (T-OH4), reference can be made to the description of paragraphs [0018] to [0019] of PCT/JP2023/009587, the contents of which are incorporated herein by reference.

When the resin composition of the present embodiment contains the phenolic compound having a number average molecular weight of more than 400, the content of the phenolic compound is preferably 0.1 parts by mass or more, more preferably 1 part by mass or more, and still more preferably 2 parts by mass or more with respect to 100 parts by mass of the resin solid content in the resin composition. The content is preferably 50 parts by mass or less, more preferably 30 parts by mass or less, still more preferably 20 parts by mass or less, and still more preferably 10 parts by mass or less, and may be 5 parts by mass or less.

The resin composition of the present embodiment may contain only one type of phenolic compound having a number average molecular weight of more than 400 or may contain two or more types of the phenolic compounds. When two or more aliphatic polyamide resins are contained, the total amount is preferably in the range described above.

In addition, the resin composition in the present embodiment can also be configured to contain substantially no phenolic compound having a number average molecular weight of more than 400. The phrase "contain substantially no" means that the content of the phenolic compound is less than 0.1 parts by mass with respect to 100 parts by mass of the resin solid content in the resin composition.

<<Compound containing (meth)allyl group>>

The resin composition of the present embodiment may contain a compound having a number average molecular weight of more than 400 and containing a (meth)allyl group.

The compound containing a (meth)allyl group is preferably a compound containing two or more (meth)allyl groups, and more preferably a compound containing two to eight allyl groups.

The compound containing a (meth)allyl group preferably includes at least one selected from the group consisting of an allyl isocyanurate compound, an allyl group-substituted nadimide compound, an allyl compound having a glycoluril structure, and diallyl phthalate, more preferably includes at least one selected from the group consisting of an allyl isocyanurate compound, an allyl group-substituted nadimide compound, and an allyl compound having a glycoluril structure, even more preferably includes an allyl group-substituted nadimide compound, and an alkenyl-substituted nadimide compound is further preferable.

The allyl isocyanurate compound is preferably a compound having a number average molecular weight of more than 400 and represented by Formula (TA-1).

Formula (TA-1)

[Chem.89]

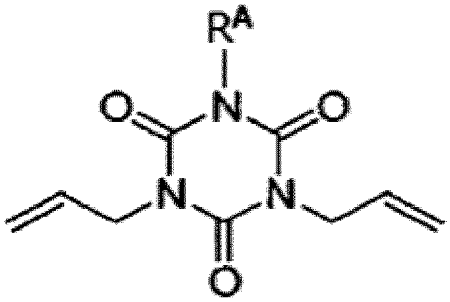

(In Formula (TA-1), $R^A$ represents a substituent.)

In Formula (TA-1), $R^A$ represents a substituent, and is more preferably a substituent having a formula weight from 194 to 500.

A first example of $R^A$ is an alkyl group having from 14 to 22 carbon atoms or an alkenyl group having from 14 to 22 carbon atoms. By using an allyl compound having an alkyl group having from 14 to 22 carbon atoms or an alkenyl group having from 14 to 22 carbon atoms, it is possible to provide a resin composition capable of obtaining a cured product having excellent crosslinkability and high toughness. Thus, even when a substrate, such as glass cloth, is not included in the resin composition, cracking during etching treatment or the like can be suppressed.

Examples of the alkyl group having from 14 to 22 carbon atoms include a linear or branched alkyl group, and examples thereof include a tetradecyl group, a hexadecyl group, an octadecyl group, an eicosyl group, and a docosyl group. Examples of the alkenyl group having from 14 to 22 carbon atoms include a decenyl group.

A second example of $R^A$ is a group containing an allyl isocyanurate group. When $R^A$ contains an allyl isocyanurate group, the compound represented by Formula (TA-1) is preferably a compound represented by Formula (TA-2).

[Chem.90]

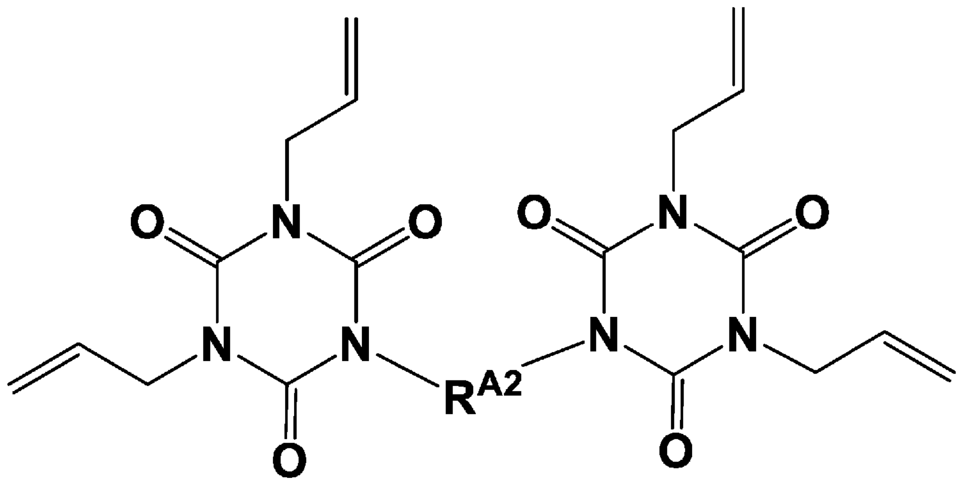

(In Formula (TA-2), $R^{A2}$ is a divalent linking group.)

In Formula (TA-2), $R^{A2}$ is preferably a divalent linking group having a formula weight from 54 to 250, more preferably a divalent linking group having a formula weight from 54 to 250 and having carbon atoms at both terminals, and still more preferably an aliphatic hydrocarbon group having from 2 to 20 carbon atoms (however, the aliphatic hydrocarbon group may contain an ether group or may have a hydroxyl group). More specifically, $R^{A2}$ is preferably a group represented by any one of Formulas (i) to (iii) below.

[Chem.91]

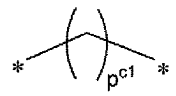

(i)

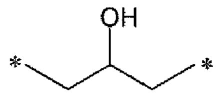

(ii)

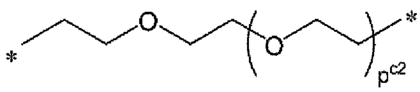

(iii)

(In Formulas (i) to (iii), $p^{c1}$ represents the number of repeating units of a methylene group, and is an integer of from 2 to 18. $p^{c2}$ represents the number of repeating units of an oxyethylene group, and is 0 or 1. * is a bonding position.)

The $p^{c1}$ is preferably an integer of from 2 to 10, more preferably an integer of from 3 to 8, and still more preferably an integer of from 3 to 5.

$p^{c2}$ may be 0 or 1, and is preferably 1.

A third example of $R^A$ is a phosphorus-based substituent.

Specific examples of the compound represented by Formula (TA-1) include 5-tetradecyl-1,3-diallyl isocyanurate, 5-hexadecyl-1,3-diallyl isocyanurate, 5-octadecyl-1,3-diallyl isocyanurate, 5-eicosyl-1,3-diallyl isocyanurate, 5-docosyl-1,3-diallyl isocyanurate, and 5-decenyl-1,3-diallyl isocyanurate. For these, one type may be used, or two or more types may be used in combination. These may be used as prepolymers.

As the compound represented by Formula (TA-1), a commercially available product can also be used. Examples of the commercially available product include, but are not particularly limited to, DD-1 available from Shikoku Chemicals Corporation.

The alkenyl-substituted nadimide compound is not particularly limited as long as the compound has one or more alkenyl-substituted nadimide groups in a molecule and has a molecular weight of more than 400. Among these, a compound represented by Formula (AN-1) is preferred. Use of such an alkenyl-substituted nadimide compound tends to further reduce the coefficient of thermal expansion of the resulting cured product and tends to further improve thermal resistance. Formula (AN-1)

[Chem.92]

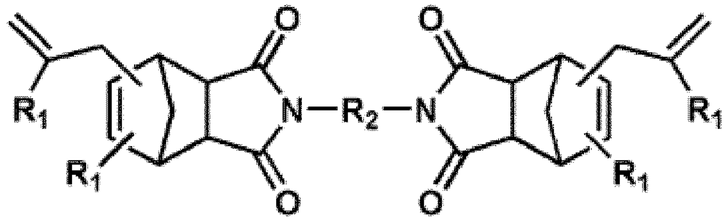

(In Formula (AN-1), each $R_1$ independently represents a hydrogen atom or an alkyl group having from 1 to 6 carbon atoms; and $R_2$ represents an alkylene group having from 1 to 6 carbon atoms, a phenylene group, a biphenylene group, a naphthylene group, a group represented by Formula (AN-2), or a group represented by Formula (AN-3).) Formula (AN-2)

[Chem.93]

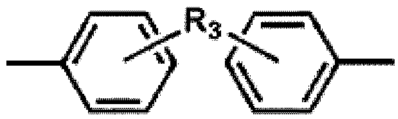

(In Formula (AN-2), $R_3$ represents a methylene group, an isopropylidene group, -C(=O)-, -O-, -S-, or -S(=O)$_2$-.) Formula (AN-3)

[Chem.94]

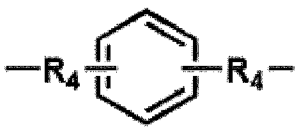

(In Formula (AN-3), each $R_4$ independently represents an alkylene group having from 1 to 4 carbon atoms or a cycloalkylene group having from 5 to 8 carbon atoms.)

Among the compounds represented by Formula (AN-1), a compound represented by Formula (AN-4) and a compound represented by Formula (AN-5) are preferred. Use of such an alkenyl-substituted nadimide compound tends to further reduce the coefficient of thermal expansion of the resulting cured product and tends to further improve thermal resistance. Formula (AN-4)

[Chem.95]

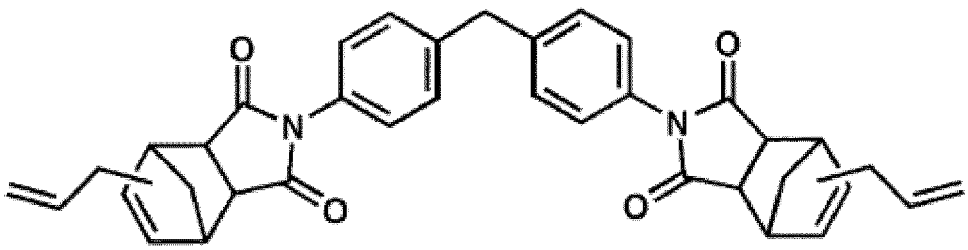

Formula (AN-5)

[Chem.96]

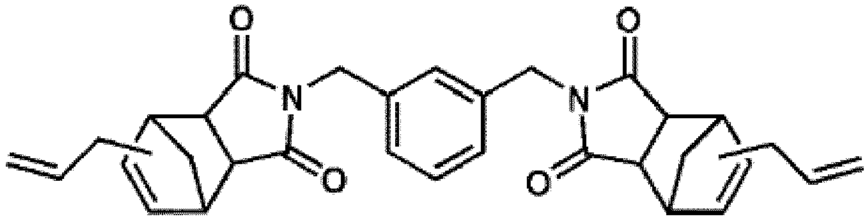

In addition, a commercially available product of the alkenyl-substituted nadimide compound can be used. Examples of the commercially available product include, but are not particularly limited to, BANI-M (available from Maruzen Petrochemical Co., Ltd., a compound represented by Formula (AN-4)) and BANI-X (available from Maruzen Petrochemical Co., Ltd., a compound represented by Formula (AN-5)).

The resin composition of the present embodiment preferably contains a compound containing a (meth)allyl group (preferably, alkenyl-substituted nadimide compound) having a number average molecular weight of more than 400 within a range that does not impair the effects of the present invention. When the resin composition of the present embodiment contains the compound containing a (meth)allyl group (preferably, alkenyl-substituted nadimide compound), the content thereof is preferably 0.1 parts by mass or more and preferably 50 parts by mass or less with respect to 100 parts by mass of the resin solid content in the resin composition.

The resin composition in the present embodiment may contain only one type or two or more types of the compounds containing a (meth)allyl group (preferably, alkenyl-substituted nadimide compounds) having a number average molecular weight of more than 400. When two or more aliphatic polyamide resins are contained, the total amount is preferably in the range described above.

In addition, the resin composition in the present embodiment can also be configured to contain substantially no alkenyl-substituted nadimide compound (furthermore, compound containing a (meth)allyl group) having a number average molecular weight of more than 400. The phrase "contain substantially no" means that the content of the alkenyl-substituted nadimide compound (furthermore, compound containing a (meth)allyl group) is less than 0.1 parts by mass with respect to 100 parts by mass of the resin solid content in the resin composition.

<<Benzoxazine compound>>

The resin composition of the present embodiment may contain a benzoxazine compound having a number average molecular weight of more than 400.

The benzoxazine compound is any compound having two or more (preferably from 2 to 12, more preferably from 2 to 6, still more preferably from 2 to 4, still more preferably 2 or 3, and even more preferably 2) dihydrobenzoxazine rings per molecule and is not particularly limited, and a compound from a wide variety of compounds commonly used in the field of printed wiring boards can be used.

Examples of the benzoxazine compound include a bisphenolic A-type benzoxazine BA-BXZ (available from Konishi Chemical Ind. Co., Ltd.), a bisphenolic F-type benzoxazine BF-BXZ (available from Konishi Chemical Industry Co., Ltd.), and a bisphenolic S-type benzoxazine BS-BXZ (available from Konishi Chemical Industry Co., Ltd.).

The resin composition of the present embodiment preferably contains the benzoxazine compound having a number average molecular weight of more than 400 in a range that does not impair the effects of the present invention. When the resin composition of the present embodiment contains the benzoxazine compound, the content of the benzoxazine compound is preferably 0.1 parts by mass or more and preferably 50 parts by mass or less with respect to 100 parts by mass of the resin solid content in the resin composition.

The resin composition of the present embodiment may contain only one type of benzoxazine compound having a number average molecular weight of more than 400 or may contain two or more types of the benzoxazine compounds. When two or more aliphatic polyamide resins are contained, the total amount is preferably in the range described above.

In addition, the resin composition in the present embodiment can also be configured to contain substantially no benzoxazine compound having a number average molecular weight of more than 400. The phrase "contain substantially no" means that the content of the benzoxazine compound is less than 0.1 parts by mass with respect to 100 parts by mass of the resin solid content in the resin composition.

<<Arylcyclobutene resin>>

The resin composition of the present embodiment may contain an arylcyclobutene resin having a number average molecular weight of more than 400.

For details thereof, the arylcyclobutene resins described in paragraph [0042] of JP 2019-194312 A are exemplified, the contents of which are incorporated herein by reference.

The resin composition of the present embodiment preferably contains the arylcyclobutene resin having a number average molecular weight of more than 400 in a range that does not impair the effects of the present invention. When the resin composition of the present embodiment contains the arylcyclobutene resin, the content thereof is preferably 0.1 parts by mass or more and preferably 50 parts by mass or less, with respect to 100 parts by mass of the resin solid content in the resin composition.

The resin composition of the present embodiment may contain only one type of arylcyclobutene resin having a number average molecular weight of more than 400 or may contain two or more types of the arylcyclobutene resins. When two or more aliphatic polyamide resins are contained, the total amount is preferably in the range described above.

In addition, the resin composition in the present embodiment can also be configured to contain substantially no arylcyclobutene resin having a number average molecular weight of more than 400. The phrase "contain substantially no" means that the content of the arylcyclobutene resin is less than 0.1 parts by mass with respect to 100 parts by mass of the resin solid content in the resin composition.

<<Polyamide compound>>

The resin composition of the present embodiment may contain a polyamide compound having a number average molecular weight of more than 400 or a thermosetting polyamide compound.

For details thereof, reference can be made to the polyamide described in paragraph 0063 of JP 6951829 B, the contents of which are incorporated herein by reference.

The resin composition of the present embodiment preferably contains the polyamide compound having a number average molecular weight of more than 400 in a range that does not impair the effects of the present invention. When the resin composition of the present embodiment contains the polyamide compound, the content thereof is preferably 0.1 parts by mass or more and preferably 50 parts by mass or less with respect to 100 parts by mass of the resin solid content in the resin composition.

The resin composition of the present embodiment may contain only one type of polyamide compound having a number average molecular weight of more than 400 or may contain two or more types of the polyamide compounds. When two or more aliphatic polyamide resins are contained, the total amount is preferably in the range described above.

In addition, the resin composition in the present embodiment can also be configured to contain substantially no polyamide compound having a number average molecular weight of more than 400. The phrase "contain substantially no" means that the content of the polyamide compound is less than 0.1 parts by mass, with respect to 100 parts by mass of the resin solid content in the resin composition.

<<Polyimide compound>>

The resin composition of the present embodiment may contain a polyimide compound having a number average molecular weight of more than 400 or a thermosetting polyimide compound.

For details thereof, reference can be made to the polyimide described in paragraph 0064 of JP 6951829 B, the contents of which are incorporated herein by reference.

The resin composition of the present embodiment preferably contains the polyimide compound having a number average molecular weight of more than 400 in a range that does not impair the effects of the present invention. When the resin composition of the present embodiment contains the polyimide compound, the content thereof is preferably 0.1 parts by mass or more and preferably 50 parts by mass or less with respect to 100 parts by mass of the resin solid content in the resin composition.

The resin composition of the present embodiment may contain only one type of polyimide compound having a number average molecular weight of more than 400 or may contain two or more types of the polyimide compounds. When two or more aliphatic polyamide resins are contained, the total amount is preferably in the range described above.

In addition, the resin composition in the present embodiment can also be configured to contain substantially no polyimide compound having a number average molecular weight of more than 400. The phrase "contain substantially no" means that the content of the polyimide compound is less than 0.1 parts by mass, with respect to 100 parts by mass of the resin solid content in the resin composition.

<<Perfluorovinyl ether resin>>

The resin composition of the present embodiment may contain a perfluorovinyl ether resin having a number average molecular weight of more than 400 or a perfluorovinyl benzyl ether resin.

For details thereof, the perfluorovinyl ether resins and the like described in paragraph [0043] of JP 2019-194312

A are exemplified, the contents of which are incorporated herein by reference.

The resin composition of the present embodiment preferably contains the perfluorovinyl ether resin having a number average molecular weight of more than 400 in a range that does not impair the effects of the present invention. When the resin composition of the present embodiment contains the perfluorovinyl ether resin, the content thereof is preferably 0.1 parts by mass or more and preferably 50 parts by mass or less, with respect to 100 parts by mass of the resin solid content in the resin composition.

The resin composition of the present embodiment may contain only one type of perfluorovinyl ether resin having a number average molecular weight of more than 400 or may contain two or more types of the perfluorovinyl ether resins. When two or more aliphatic polyamide resins are contained, the total amount is preferably in the range described above.

In addition, the resin composition in the present embodiment can also be configured to contain substantially no perfluorovinyl ether resin having a number average molecular weight of more than 400. The phrase "contain substantially no" means that the content of the perfluorovinyl ether resin is less than 0.1 parts by mass with respect to 100 parts by mass of the resin solid content in the resin composition.

<<Compound having isopropenyl group other than resin (A)>>

The resin composition of the present embodiment may contain a compound having a number average molecular weight of more than 400 and having an isopropenyl group other than the resin (A).

For details thereof, the resin having an isopropenyl group described in WO 2022/210095 (for example, compounds described in Synthesis Examples 1, 2, 7, and 8 of the same publication) are exemplified, the contents of which are incorporated herein by reference.

The resin composition of the present embodiment preferably contains a compound having an isopropenyl group other than the resin (A) and having a number average molecular weight of more than 400 within a range not impairing the effects of the present invention. When the resin composition of the present embodiment contains the compound having an isopropenyl group other than the resin (A), the content of the compound is preferably 0.1 parts by mass or more and preferably 50 parts by mass or less with respect to 100 parts by mass of the resin solid content in the resin composition.

The resin composition in the present embodiment may contain only one type of the compound having a number average molecular weight of more than 400 and having an isopropenyl group other than the resin (A) or may contain two or more types of the compounds. When two or more aliphatic polyamide resins are contained, the total amount is preferably in the range described above.

In addition, the resin composition in the present embodiment can also be configured to contain substantially no compound having a number average molecular weight of more than 400 and having an isopropenyl group other than the resin (A). The phrase "contain substantially no" means that the content of the compound having an isopropenyl group other than the resin (A) is less than 0.1 parts by mass with respect to 100 parts by mass of the resin solid content in the resin composition.

<<Polyfunctional (meth)acrylate compound other than polyphenylene ether compound>>

The resin composition of the present embodiment may contain a polyfunctional (meth)acrylate compound other than the polyphenylene ether compound having a carbon-carbon unsaturated double bond at a terminal, the compound having a number average molecular weight of more than 400.

Here, the polyfunctional (meth)acrylate compound means a compound containing two or more (meth)acryloyloxy groups in one molecule, and preferably contains three or more (meth)acryloyloxy groups in one molecule. The polyfunctional (meth)acrylate compound is more preferably a compound having three to five (meth)acryloyloxy groups, still more preferably a compound having three or four (meth)acryloyloxy groups, and even more preferably a compound having three (meth)acryloyloxy groups.

The (meth)acrylate compound is preferably a compound having a methacryloyloxy group.

Specific examples of the polyfunctional (meth)acrylate compound other than the polyphenylene ether compound having a number average molecular weight of more than 400 and having a carbon-carbon unsaturated double bond at a terminal include the prepolymers of the compounds described above for the (meth)acrylate compound having a number average molecular weight of 400 or less.

For details of the polyfunctional (meth)acrylate compound having a number average molecular weight of more than 400, among the resin having a (meth)acrylic group described in WO 2022/210095 A (e.g., compounds described in Synthesis Examples 5 and 21 of the same publication) and the resin having a (meth)acrylic group described in JP 6962507 B2 (e.g., compounds described in Examples from 1 to 9), a compound having a number average molecular weight of more than 400 is exemplified, the contents of which are incorporated herein.

The resin composition of the present embodiment preferably contains the polyfunctional (meth)acrylate compound other than the polyphenylene ether compound having a carbon-carbon unsaturated double bond at a terminal,

the compound having a number average molecular weight of more than 400, as long as the effect of the present invention is not impaired. When the resin composition of the present embodiment contains the polyfunctional (meth)acrylate compound, the content thereof is preferably 0.1 parts by mass or more and preferably 50 parts by mass or less with respect to 100 parts by mass of the resin solid content in the resin composition.

The resin composition in the present embodiment may contain only one type of the polyfunctional (meth)acrylate compound other than the polyphenylene ether compound having a carbon-carbon unsaturated double bond at a terminal, the compound having a number average molecular weight of more than 400, or may contain two or more types of the polyfunctional (meth)acrylate compounds. When two or more aliphatic polyamide resins are contained, the total amount is preferably in the range described above. The resin composition in the present embodiment can also be configured to contain substantially no polyfunctional (meth)acrylate compound described above. The phrase "contain substantially no" means that the content of the polyfunctional (meth)acrylate compound is less than 0.1 parts by mass with respect to 100 parts by mass of the resin solid content in the resin composition.

<<Additional compound (compound (XC)) having carbon-carbon unsaturated double bond at terminal>>

The resin composition of the present embodiment may contain the additional compound (compound (XC)) having a carbon-carbon unsaturated double bond at a terminal other than those described above, the compound having a number average molecular weight of more than 400. That is, the resin composition may contain the resin (A), a maleimide compound, a polymer having a structural unit represented by Formula (V), a polyphenylene ether compound having a carbon-carbon unsaturated double bond at a terminal, a compound containing a (meth)allyl group, and a compound having a number average molecular weight of more than 400 other than the compound having an isopropenyl group other than the resin (A), that is, a compound having a carbon-carbon unsaturated double bond at a terminal.

An example of the additional compound (compound (XC)) having a carbon-carbon unsaturated double bond at the terminal is a resin represented by Formula (T-St).

[Chem. 97]

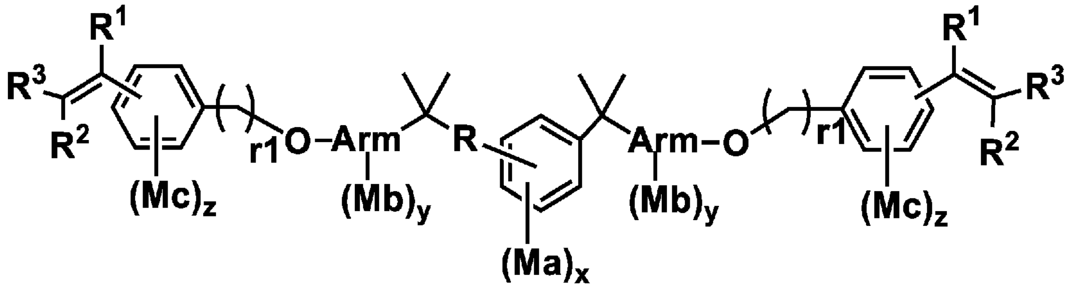

(T-St)

(In Formula (T-St), R is a group containing a structural unit represented by Formula (Tx-St). each Arm independently represents a benzene ring, a naphthalene ring, or an anthracene ring. each Ma independently represents a hydrocarbon group having from 1 to 12 carbon atoms, each carbon atom being optionally substituted with a halogen atom. each Mb independently represents a hydroxyl group, a halogen atom, or a hydrocarbon group having from 1 to 20 carbon atoms, each carbon atom being optionally substituted with a hydroxyl group or a halogen atom. each Mc independently represents a hydrocarbon group having from 1 to 12 carbon atoms. x, y, and z each independently represent an integer of from 0 to 4. r1 represents an integer of from 1 to 6. $R^1$, $R^2$, and $R^3$ each independently represent a hydrogen atom, an alkyl group, an alkenyl group, or an alkynyl group.)

[Chem. 98]

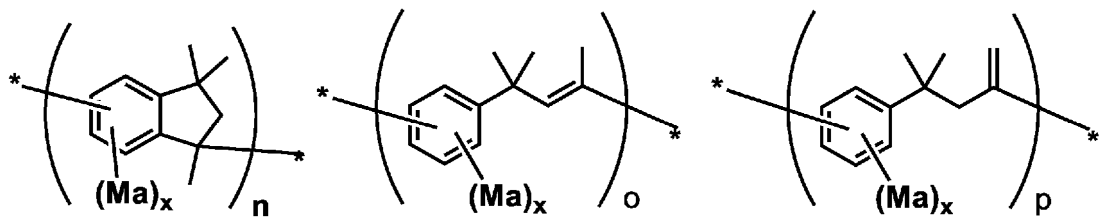

(a) (b) (c) (Tx-St)

(In Formula (Tx-St), n, o, and p are average numbers of repeating units, n represents a number of more than 0 and 20 or

less, o and p each independently represent a number of from 0 to 20, and $1.0 \leq n + o + p \leq 20.0$. each Ma independently represents a hydrocarbon group having from 1 to 12 carbon atoms, each carbon atom being optionally substituted with a halogen atom. x represents an integer of from 0 to 4. The structural unit is bonded to the structural unit (a), (b), or (c), or an additional group, and structural units may be randomly bonded.)

In Formula (T-St), R is a group containing structural units represented by Formula (Tx-St).

In Formula (Tx-St), n, o, and p each mean an average number of repeating units in all molecules in the resin.

In Formula (Tx-St), the sum of n, o, and p is preferably $1.1 \leq n + o + p$, more preferably $1.2 \leq n + o + p$, still more preferably $1.5 \leq n + o + p$, even more preferably $2.0 \leq n + o + p$, further more preferably $2.5 \leq n + o + p$, still further more preferably $3.0 \leq n + o + p$, and particularly preferably $3.3 \leq n + o + p$, and, in addition, the order of $3.5 \leq n + o + p$, $3.7 \leq n + o + p$, $4.0 \leq n + o + p$, and $4.2 \leq n + o + p$ is more preferred. In Formula (Tx-St), the sum of n, o, and p is also preferably $n + o + p \leq 20.0$, more preferably $n + o + p \leq 10.0$, still more preferably $n + o + p \leq 8.0$, even more preferably $n + o + p \leq 7.0$, further more preferably $n + o + p \leq 6.5$, and still further more preferably $n + o + p \leq 6.4$. The sum of n, o, and p can be calculated by the method described in Examples below. In Formula (Tx-St), the sum of n, o, and p is usually the same as the sum of n, o, and p in Formula (Tx).

In Formula (Tx-St), Ma and x have the same meanings as Ma and x in Formula (Tx) described above, respectively, and the preferred ranges thereof are also the same.

In Formula (T-St), each Arm is independently a benzene ring, a naphthalene ring, or an anthracene ring, and is preferably a benzene ring or a naphthalene ring, and more preferably a benzene ring.

When Arm is a benzene ring and y is an integer of from 1 to 4, it is preferable that an OH group bonded to Arm and Mb are bonded to each other at one or two of an ortho position and a para position (preferably at least one or two ortho positions).

In Formula (T-St), each Ma independently represents a hydrocarbon group having from 1 to 12 carbon atoms, each carbon atom being optionally substituted with a halogen atom, and has the same meaning as Ma in Formula (Tx) described above, and the preferred range is also the same.

In Formula (T-St), each Mb independently represents a hydroxyl group, a halogen atom, or a hydrocarbon group having from 1 to 20 carbon atoms, each carbon atom being optionally substituted with a hydroxyl group or a halogen atom, and is preferably a hydroxyl group, a halogen atom, or a hydrocarbon group having from 1 to 20 carbon atoms, each carbon atom being optionally substituted with a halogen atom, and more preferably a hydroxyl group, a fluorine atom, a chlorine atom, a bromine atom, an iodine atom, a linear or branched alkyl group having from 1 to 10 carbon atoms, an alicyclic alkyl group having from 4 to 8 carbon atoms, a cumyl group, a phenyl group, or a benzyl group. The halogen atom is preferably a fluorine atom, a chlorine atom, a bromine atom, or an iodine atom, and more preferably a fluorine atom or a chlorine atom. The linear or branched alkyl group having from 1 to 10 carbon atoms is preferably a methyl group, an ethyl group, an isopropyl group, an isobutyl group, a t-butyl group, a pentyl group, an octyl group, or a nonyl group. As the alicyclic alkyl group having from 4 to 8 carbon atoms, a cyclohexyl group is preferable. In the present embodiment, Mb is more preferably a hydroxyl group, a linear or branched alkyl group having from 1 to 10 carbon atoms, or a benzyl group, and still more preferably a hydroxyl group, a methyl group, an ethyl group, an isopropyl group, an isobutyl group, a t-butyl group, or a benzyl group.

In Formula (T-St), each Mc independently represents a hydrocarbon group having from 1 to 12 carbon atoms, and is preferably a hydrocarbon group having from 1 to 10 carbon atoms, more preferably a linear or branched alkyl group having from 1 to 10 carbon atoms, still more preferably a methyl group, an ethyl group, an isopropyl group, an isobutyl group, a t-butyl group, a pentyl group, an octyl group, or a nonyl group, and yet still more preferably a methyl group, an ethyl group, an isopropyl group, an isobutyl group, or a t-butyl group.

In Formula (T-St), x has the same meaning as x in Formula (Tx) described above, and the preferred range thereof is also the same.

In Formula (T-St), each y independently represents an integer of from 0 to 4, and is preferably an integer of from 0 to 3 and more preferably an integer of from 0 to 2.

In Formula (T-St), each z independently represents an integer of from 0 to 4, and is preferably an integer of from 0 to 3, more preferably an integer of from 0 to 2, still more preferably 0 or 1, and yet still more preferably 0.

In Formula (T-St), r1 represents an integer of from 1 to 6, preferably an integer of from 1 to 5, more preferably an integer of from 1 to 4, still more preferably an integer of from 1 to 3, further preferably 1 or 2, and yet further preferably 1.

In Formula (T-St), $R^1$, $R^2$, and $R^3$ each independently represent a hydrogen atom, an alkyl group, an alkenyl group, or an alkynyl group, and are each preferably a hydrogen atom or an alkyl group, more preferably a hydrogen atom or a methyl group, and still more preferably a hydrogen atom. The number of carbon atoms of the alkyl group, the alkenyl group, or the alkynyl group as $R^1$, $R^2$, or $R^3$ is preferably 5 or less, and more preferably 3 or less.

In the present embodiment, Formula (T-St) is preferably represented by Formula (T-St2).

[Chem.99]

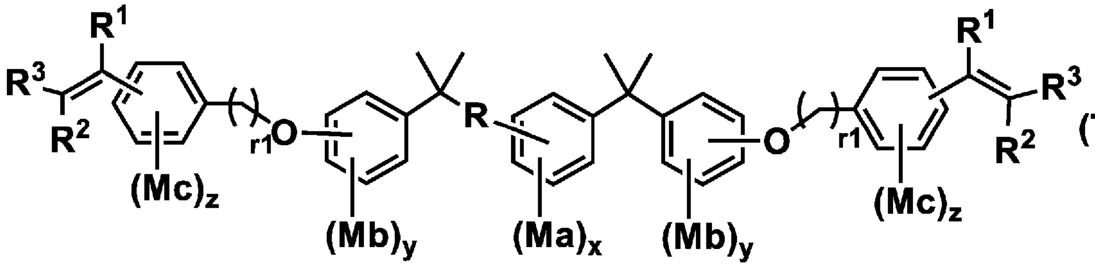

(T-St2)

(In Formula (T-St2), R is a group containing a structural unit represented by Formula (Tx-St). each Ma independently represents a hydrocarbon group having from 1 to 12 carbon atoms, each carbon atom being optionally substituted with a halogen atom. each Mb independently represents a hydroxyl group, a halogen atom, or a hydrocarbon group having from 1 to 20 carbon atoms, each carbon atom being optionally substituted with a hydroxyl group or a halogen atom. each Mc independently represents a hydrocarbon group having from 1 to 12 carbon atoms. x, y, and z each independently represent an integer of from 0 to 4. r1 represents an integer of from 1 to 6. $R^1$, $R^2$, and $R^3$ each independently represent a hydrogen atom, an alkyl group, an alkenyl group, or an alkynyl group.)

[Chem.100]

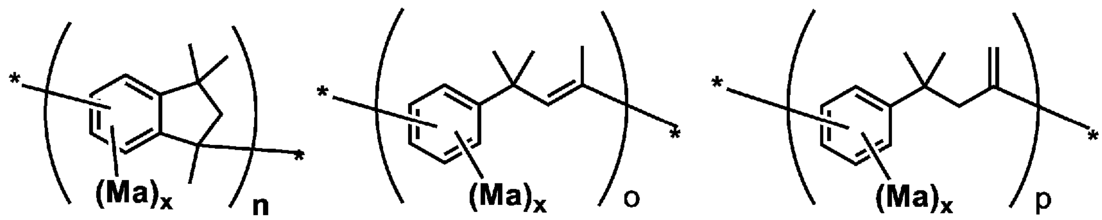

(a) (b) (c)

(Tx-St)

(In Formula (Tx-St), n, o, and p are average numbers of repeating units, n represents a number of more than 0 and 20 or less, o and p each independently represent a number of from 0 to 20, and $1.0 \leq n + o + p \leq 20.0$. each Ma independently represents a hydrocarbon group having from 1 to 12 carbon atoms, each carbon atom being optionally substituted with a halogen atom. x represents an integer of from 0 to 4. The structural unit is bonded to the structural unit (a), (b), or (c), or an additional group, and structural units may be randomly bonded.)

In Formula (T-St2), R, Ma, Mb, Mc, x, y, z, r1, $R^1$, $R^2$, and $R^3$ have the same meanings as R, Ma, Mb, Mc, x, y, z, r1, $R^1$, $R^2$, and $R^3$ in Formula (T-St), respectively, and the preferred ranges thereof are also the same.

The resin represented by Formula (T-St) preferably has parameter $\alpha$ calculated from Equation ($\alpha$) of 0.55 or more and 1.00 or less.

[Num.2]

$$\text{PARAMETER } \alpha = \frac{(2.55 \text{ ppm to } 2.31 \text{ ppm})}{(6.24 \text{ ppm to } 5.91 \text{ ppm}) + (2.98 \text{ ppm to } 2.55 \text{ ppm})/2 + (2.55 \text{ ppm to } 2.31 \text{ ppm})} \qquad (\alpha)$$

(Expressions in parentheses in Equation ($\alpha$) indicate integral values between corresponding chemical shift values in $^1$H-NMR.)

Here, $\alpha$ represents a ratio of the structural unit (the structural unit (a) in Formula (Tx-St)) having an indane skeleton. More specifically, it is presumed that when the proportion of the structural unit having an indane skeleton is adjusted so as to satisfy the range of the parameter $\alpha$, the rigidity of the resulting resin molecule can be enhanced, and the glass transition temperature of a cured product can be increased.

The parameter $\alpha$ in the resin represented by Formula (T-St) is preferably 0.57 or more, more preferably 0.59 or more, still more preferably 0.60 or more, and further preferably 0.62 or more, and may be 0.65 or more, 0.70 or more, 0.75 or more, or 0.80 or more. When the parameter $\alpha$ is the above lower limit or more, the resulting cured product tends to have further improved low dielectric properties (low relative permittivity and/or low dielectric loss tangent) and thermal resistance. The parameter $\alpha$ is preferably large because the resulting cured product tends to have substantially excellent low dielectric properties and thermal resistance. However, the parameter $\alpha$ may be 0.95 or less, 0.94 or less, 0.93 or less, or 0.92 or less.

Another example of the additional compound (compound (XC)) having a carbon-carbon unsaturated double bond at the terminal is a resin (hereinafter, it may be referred to as "resin (IP1)") containing a structural unit derived from a compound represented by Formula (DIP) as a main component and having a structure represented by Formula (In-1) and/or Formula (In-2).

[Chem.101]

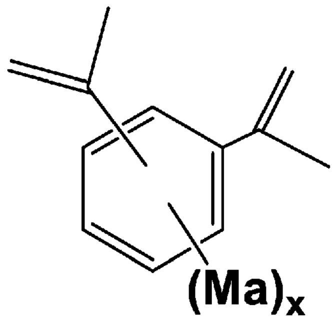

**(DIP)**

(where each Ma independently represents a hydrocarbon group having from 1 to 12 carbon atoms, each carbon atom being optionally substituted with a halogen atom, and x represents an integer of from 0 to 4.)

[Chem.102]

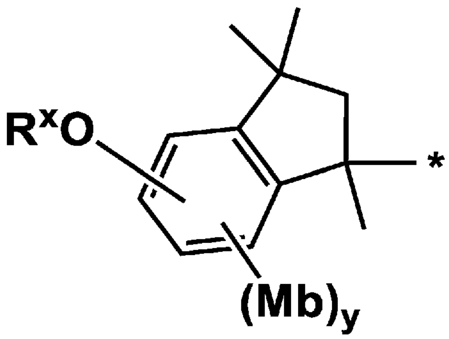

**(In-1)**

(In Formula (In-1), each Mb independently represents a hydroxyl group, a halogen atom, or a hydrocarbon group having from 1 to 20 carbon atoms, each carbon atom being optionally substituted with a hydroxyl group or a halogen atom. y represents an integer of from 0 to 3. $R^x$ is a group containing a carbon-carbon unsaturated double bond. * is a bonding position for another moiety.)

[Chem.103]

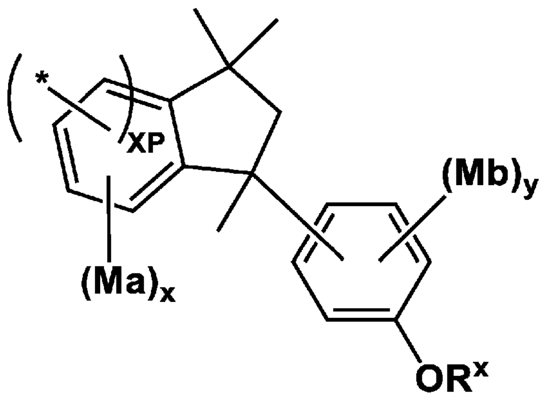

**(In-2)**

(In Formula (In-2), each Ma independently represents a hydrocarbon group having from 1 to 12 carbon atoms, each carbon atom being optionally substituted with a halogen atom. x represents an integer of from 0 to 3. each Mb independently represents a hydroxyl group, a halogen atom, or a hydrocarbon group having from 1 to 20 carbon atoms, each carbon atom

being optionally substituted with a hydroxyl group or a halogen atom. y represents an integer of from 0 to 4. $R^x$ is a group containing a carbon-carbon unsaturated double bond. xp is the number of binders from the benzene ring, and is an integer of 1 or 2. * is a bonding position for another moiety.)

Here, another moiety means a moiety other than the structure represented by Formula (In-1) and/or Formula (In-2) contained in the resin (IP1). The same applies to other moieties in the section of the resin (IP1).

In the resin (IP1), it is presumed that, ($R^x$), a group containing a carbon-carbon unsaturated double bond at a terminal, and a structural unit derived from the compound represented by Formula (DIP) (in particular, a structural unit derived from a compound represented by Formula (DIP) and having an indane skeleton (preferably a trimethylindane structure (the same applies to the preferred range of the indane skeleton hereinafter))) are bonded via a low-molecular-weight structural unit such as an oxygen atom and/or a phenyleneoxy group optionally having a substituent, thereby increasing the content proportion of the structural unit derived from the compound represented by Formula (DIP) (in particular, indane skeleton) in the cured product of the resin composition containing the resin (IP1), and Df (dielectric loss tangent) can thus be lowered. In particular, it is presumed that a low Df can be achieved even when the curing temperature is high. Further, the resin (IP1) can have excellent thermal resistance. The resin (IP1) can also have a low relative permittivity (Dk).

It is needless to say that the structural unit derived from the compound represented by Formula (DIP) may be synthesized from the compound represented by Formula (DIP) or may be synthesized from another raw material that gives the structural unit derived from the compound represented by Formula (DIP). Examples of the compound represented by Formula (DIP) include 1,3-diisopropenylbenzene and 1,4-diisopropenylbenzene. Examples of another raw material for providing the structural unit derived from the compound represented by Formula (DIP) include an equivalent of a compound represented by Formula (DIP), such as α,α'-dihydroxy-1,3-diisopropylbenzene, α,α'-dihydroxy-1,4-diisopropylbenzene α,α'-dihalogeno-1,3-diisopropylbenzene (for example α,α'-dichloro-1,3-diisopropylbenzene), α,α'-dihalogeno-1,4-diisopropylbenzene (for example α,α'-dichloro-1,4-diisopropylbenzene), α,α'-dialkoxy-1,3-diisopropylbenzene (for example α,α'-dimethoxy-1,3-diisopropylbenzene), and α,α'-dialkoxy-1,4-diisopropylbenzene (for example α, α'-dimethoxy-1,4-diisopropylbenzene), which provides a compound represented by Formula (DIP) through a unit operation such as heating. In the present embodiment, among the above, 1,3-diisopropenylbenzene and α,α'-dihydroxy-1,3-diisopropylbenzene are preferable. One type of the above-described compounds may be used alone, or two or more types thereof may be used in combination.

First, Formula (DIP) will be described.

[Chem.104]

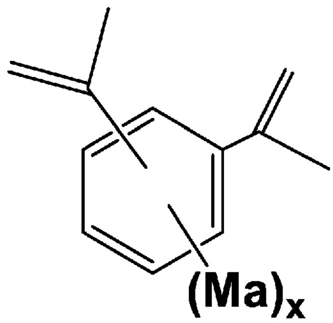

(DIP)

(In Formula (DIP), each Ma independently represents a hydrocarbon group having from 1 to 12 carbon atoms, each carbon atom being optionally substituted with a halogen atom. x represents an integer of from 0 to 4.)

The resin (IP1) may contain a plurality of structural units derived from the compound represented by Formula (DIP), and in this case, Ma and x may be the same or different.

In Formula (DIP), each Ma independently represents a hydrocarbon group having from 1 to 12 carbon atoms, each carbon atom being optionally substituted with a halogen atom, has the same meaning as Ma in Formula (T1) described above, and the preferred range is also the same.

In Formula (DIP), x represents an integer of from 0 to 4, and is preferably an integer of from 0 to 3, more preferably an integer of from 0 to 2, still more preferably 0 or 1, and yet still more preferably 0.

In the resin (IP1), a structural unit derived from the compound represented by Formula (DIP) is used as a main component. The phrase "used as a main component" means that the structural unit derived from the compound represented by Formula (DIP) accounts for the largest proportion among all the structural units constituting the resin (IP1). More specifically, the content of the structural unit derived from the compound represented by Formula (DIP) in the resin (IP1) is preferably 50 mol% or higher, more preferably 60 mol% or higher, still more preferably 70 mol% or higher, yet still more preferably 80 mol% or higher, yet still more preferably 82 mol% or higher, yet still more preferably 83 mol% or

higher, and particularly preferably 85 mol% or higher of all the structural units.

Here, all the structural units refer to the total amount of structural units derived from all monomer molecules used as the raw material of the resin (IP1).

The resin (IP1) further has a structure represented by Formula (In-1) and/or Formula (In-2). These groups are usually present as terminal groups. Since the resin (IP1) has the structure represented by Formula (In-1) and/or Formula (In-2), the structural unit derived from the compound represented by Formula (DIP) is bonded to ($R^x$), which is the group containing a carbon-carbon unsaturated double bond, via a low-molecular-weight structural unit such as an oxygen atom and/or a phenyleneoxy group optionally having a substituent, and it is presumed that Df (dielectric loss tangent) can thus be lowered, and it is also presumed that low Df can be achieved even when the curing temperature is high, as described above.

As long as the resin (IP1) has a structure represented by Formula (In-1) and/or Formula (In-2), the resin (IP1) may have a terminal group of another structure.

[Chem.105]

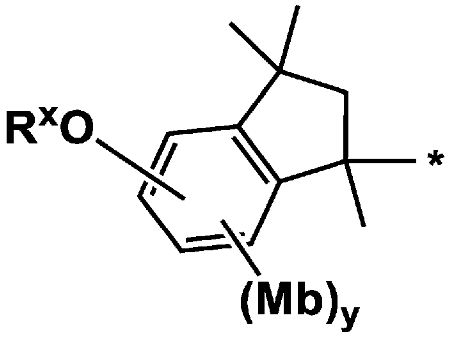

(In-1)

(In Formula (In-1), each Mb independently represents a hydroxyl group, a halogen atom, or a hydrocarbon group having from 1 to 20 carbon atoms, each carbon atom being optionally substituted with a hydroxyl group or a halogen atom. y represents an integer of from 0 to 3. $R^x$ is a group containing a carbon-carbon unsaturated double bond. * is a bonding position for another moiety.)

[Chem.106]

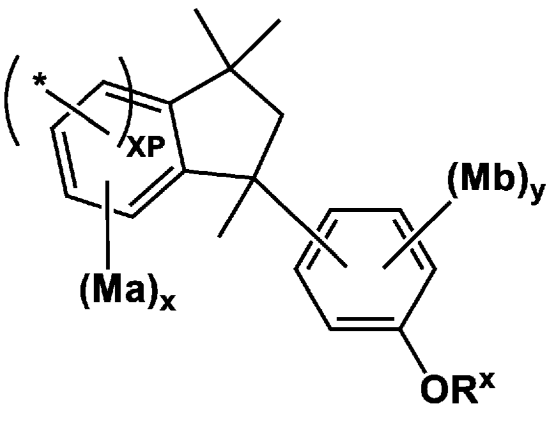

(In-2)

(In Formula (In-2), each Ma independently represents a hydrocarbon group having from 1 to 12 carbon atoms optionally substituted with a halogen atom. x represents an integer of from 0 to 3. each Mb independently represents a hydroxyl group, a halogen atom, or a hydrocarbon group having from 1 to 20 carbon atoms, each carbon atom being optionally substituted with a hydroxyl group or a halogen atom. y represents an integer of from 0 to 4. $R^x$ is a group containing a carbon-carbon unsaturated double bond. xp is the number of binders from the benzene ring, and is an integer of 1 or 2. * is a bonding position for another moiety.)

In Formula (In-1), each Mb independently represents a hydroxyl group, a halogen atom, or a hydrocarbon group having from 1 to 20 carbon atoms, each carbon atom being optionally substituted with a hydroxyl group or a halogen atom, and has the same meaning as Mb in Formula (T-St), and the preferred range is also the same.

In Formula (In-1), y represents an integer of from 0 to 3, preferably an integer of from 0 to 2, more preferably 0 or 2, and may be 0. It is preferable that y is 2 from the viewpoint of dielectric properties.

When y is 1 or more, Mb is preferably bonded at an adjacent position (ortho position) to the carbon atom to which the $R^xO$ group is bonded.

In Formula (In-1), $R^x$ is a group containing a carbon-carbon unsaturated double bond, and more preferably a group having a formula weight from 27 to 120.

Specifically, each $R^x$ is independently preferably a group represented by Formula (Rx-11) or a group represented by Formula (Rx-2), more preferably a vinylbenzyl group or a (meth)acryloyl group, and still more preferably a vinylbenzyl group.

[Chem.107]

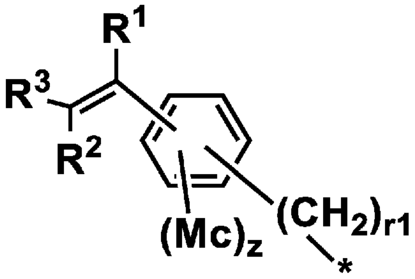

(Rx-11)

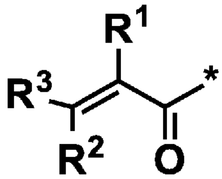

(Rx-2)

(In Formula (Rx-11) and Formula (Rx-2), $R^1$, $R^2$, and $R^3$ each independently represent a hydrogen atom, an alkyl group, an alkenyl group, or an alkynyl group. * is a bonding position for an oxygen atom. each Mc independently represents a hydrocarbon group having from 1 to 12 carbon atoms. z represents an integer of from 0 to 4. r1 represents an integer of from 1 to 6.)

Formulas (Rx-11) and (Rx-2) have the same meanings as Formulas (Rx-1) and (Rx-2) described in the section of the polyphenylene ether compound except for r1, and the preferred ranges thereof are also the same. r1 in Formula (Rx-11) is preferably an integer of 5 or less, more preferably an integer of 4 or less, still more preferably an integer of 3 or less, yet still more preferably 1 or 2, and further preferably 1.

In Formula (In-2), each Ma independently represents a hydrocarbon group having from 1 to 12 carbon atoms, each carbon atom being optionally substituted with a halogen atom, has the same meaning as Ma in Formula (T1), and the preferred range thereof is also the same.

In Formula (In-2), x represents an integer of from 0 to 3, preferably an integer of from 0 to 2, more preferably 0 or 1, and may be 0.

In Formula (In-2), Mb and $R^x$ have the same meaning as Mb and $R^x$ in Formula (In-1), respectively, and the preferred ranges thereof are also the same.

In Formula (In-2), y represents an integer of from 0 to 4, preferably an integer of from 0 to 3, more preferably an integer of from 0 to 2, still more preferably 0 or 2, and may be 0. It is preferable that y is 2 from the viewpoint of dielectric properties.

When y is 1 or more, Mb is preferably bonded at an adjacent position (ortho position) to the carbon atom to which the $R^xO$ group is bonded.

In Formula (In-2), xp is the number of binders from the benzene ring, and is an integer of 1 or 2. When xp is 2, for example, as set forth below, two groups derived from a benzene ring may be bonded to form a ring.

[Chem.108]

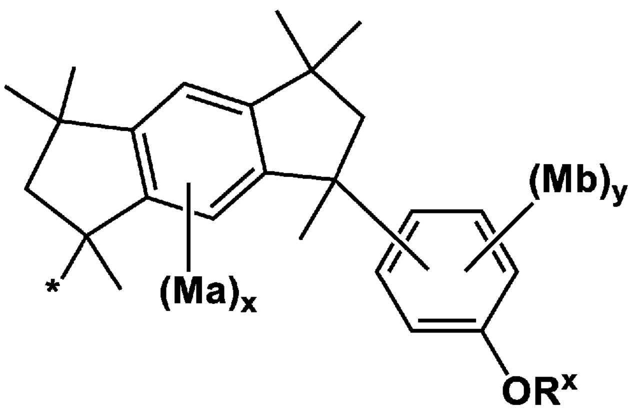

In the formula above, * is a bonding position for another moiety, $R^x$, Ma, x, Mb, and y have the same meaning as $R^x$, Ma, x, Mb, and y in Formula (In-2), and the preferred ranges are also the same.

In Formula (In-1) and Formula (In-2), it is more preferable that formula weights of $R^x$ (a group containing a carbon-carbon unsaturated double bond) are each independently from 27 to 120 groups.

In the present embodiment, the number of $R^x$ in one molecule of the resin (IP1) is preferably 2.5 or more, more preferably more than 2.5, still more preferably 2.6 or more, yet still more preferably 2.7 or more, and yet still more preferably 2.8 or more on average. In addition, the number of $R^x$ in one molecule of the resin (IP1) is preferably 8.0 or less, more preferably 7.0 or less, still more preferably 6.5 or less, still more preferably 6.0 or less, and may be 5.5 or less on average. When the number of $R^x$ in one molecule of the resin (IP1) is within the above range, the resulting cured product tends to have further improved low dielectric properties (low relative permittivity and/or low dielectric loss tangent) and thermal resistance.

In the present embodiment, the resin (IP1) preferably includes both the structure represented by Formula (In-1) and the structure represented by Formula (In-2).

The resin (IP1) usually contains an indane skeleton other than the structure represented by Formula (In-1) and/or Formula (In-2). Such an indane skeleton other than the structure represented by Formula (In-1) and/or Formula (In-2) is usually formed by a cyclization reaction of the compound represented by Formula (DIP). That is, in the resin (IP1) of the present embodiment, at least a part of the structural unit derived from the compound represented by Formula (DIP) preferably contains an indane skeleton, and more preferably contains a structure represented by Formula (In-0).

[Chem.109]

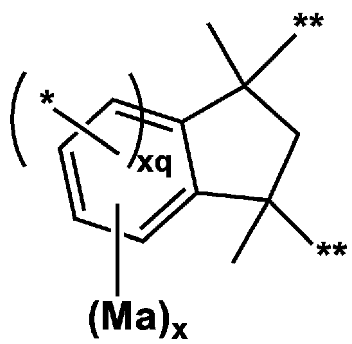

(In-0)

(In Formula (In-0), each Ma independently represents a hydrocarbon group having from 1 to 12 carbon atoms, each carbon atom being optionally substituted with a halogen atom. x represents an integer of from 0 to 3. xq is the number of binders from the benzene ring, and is an integer of 1 or 2. * is a bonding position for another moiety. ** is a bonding position for another moiety or a methyl group bonded to a cyclopentane ring. at least one of the two ** is a bonding position for another moiety.)

In Formula (In-0), Ma has the same meaning as Ma in Formula (DIP), and the preferred range thereof is also the same.

In Formula (In-0), x represents an integer of from 0 to 3, preferably an integer of from 0 to 2, more preferably 0 or 1, and may be 0.

In Formula (In-0), xq is the number of binders from the benzene ring, and is an integer of 1 or 2. When xq is 2, as described above, two groups derived from a benzene ring may be bonded to form a ring.

The content of the indane skeleton in the resin (IP1) is not particularly limited; however, as will be described in detail later, when expressed by the parameter $\alpha$, $\alpha$ is preferably 0.35 or more and 1.00 or less.

Specific examples of the structural unit derived from the compound represented by Formula (DIP) in the resin (IP1) include the following structural units (a) to (c) (hereinafter, may be referred to as Formula (Tx)) in addition to the structure represented by Formula (In-0). In Formula (Tx), * represents a bonding position for the structural units (a) to (c), the structure represented by Formula (In-1), the structure represented by Formula (In-2), the structure represented by Formula (In-0), a partial structure exemplified below, and the like.

[Chem.110]

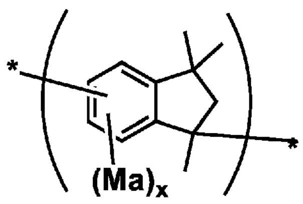 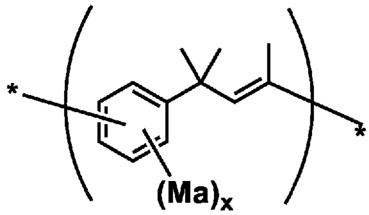 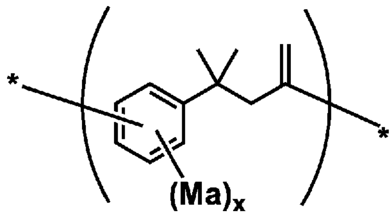 (Tx)

(a) (b) (c)

In the structural units (a) to (c), Ma and x each independently have the same meaning as Ma and x in Formula (DIP), and the preferred ranges thereof are also the same.

Specific examples of the structure containing a structural unit derived from the compound represented by Formula (DIP) in the resin (IP1) also include the following partial structures. It is needless to say that the structure including the structural unit derived from the compound represented by Formula (DIP) or the structural unit derived from the compound represented by Formula (DIP) in the resin (IP1) is not limited to these examples. Ma and x in formulas below each independently have the same meaning as Ma and x in Formula (DIP), and the preferred ranges are also the same.

[Chem.111]

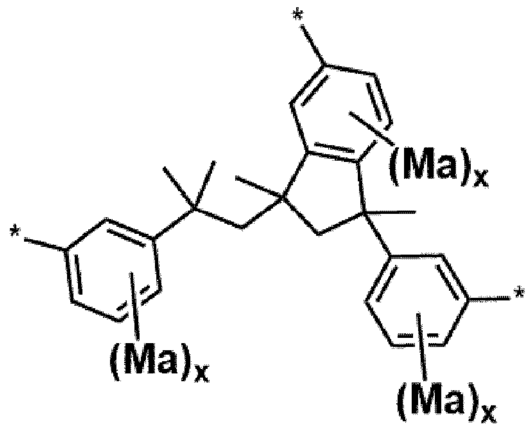

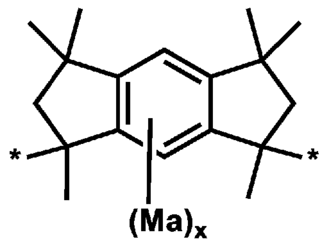

[Chem.112]

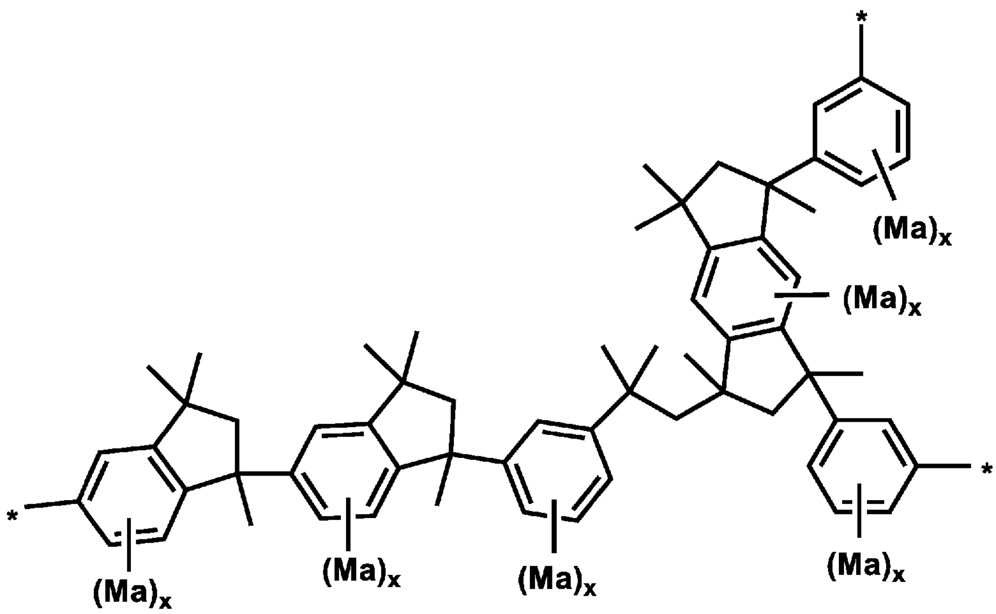

[Chem.113]

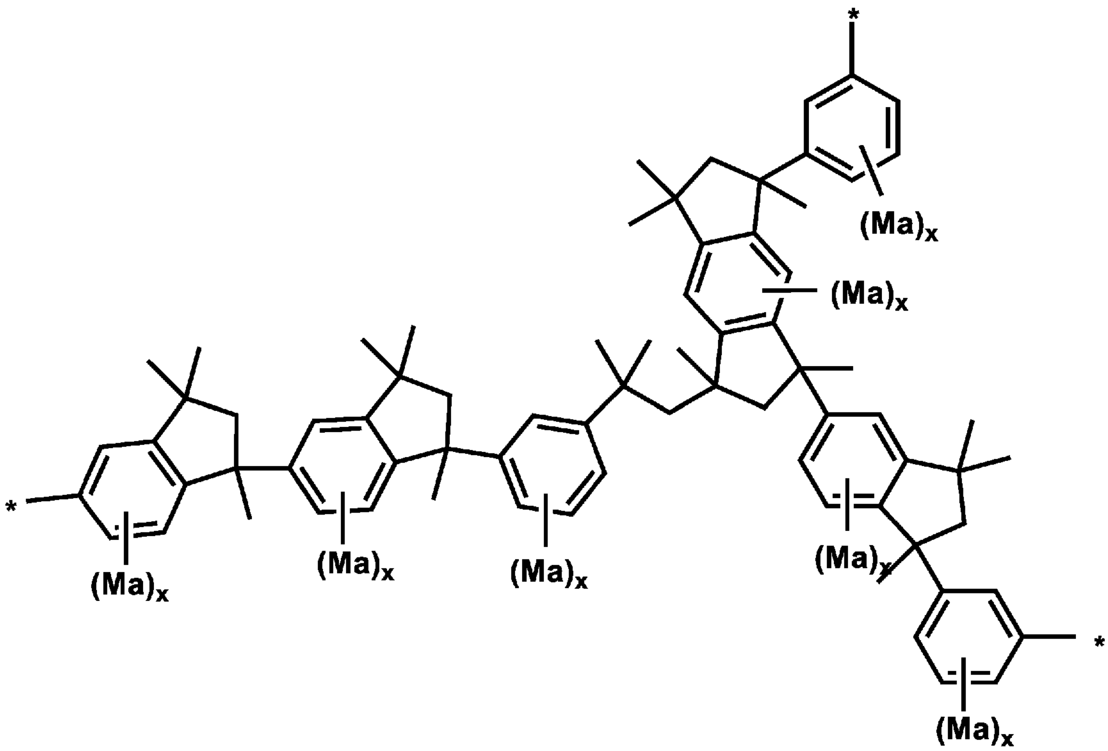

[Chem.114]

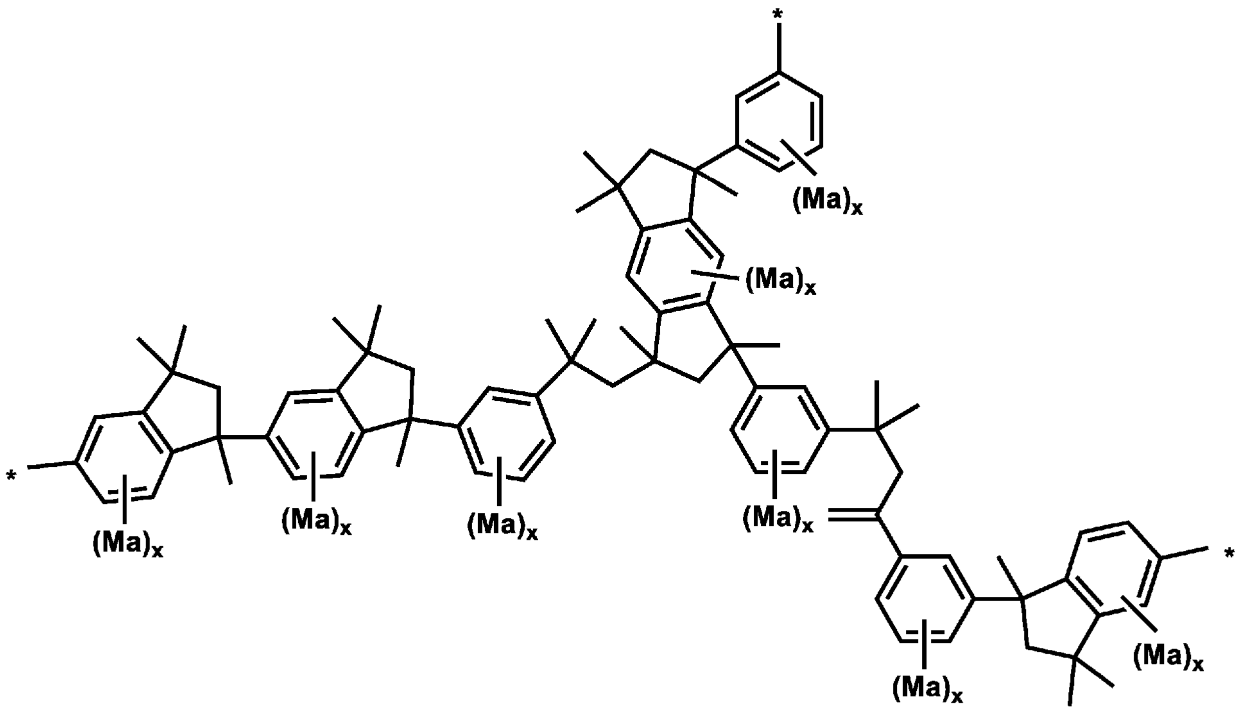

In the above formulas, * is a bonding position for another moiety.

Another example of the additional compound (compound (XC)) having a carbon-carbon unsaturated double bond at the terminal is a resin (resin (IP2)) represented by Formula (D). In such a resin (IP2), it is presumed that ($R^x$), a group containing a carbon-carbon unsaturated double bond at a terminal, a structural unit having an indane skeleton, and the like, are bonded via a low-molecular-weight structural unit such as an oxygen atom and/or a phenyleneoxy group

optionally having a substituent, thereby increasing the content proportion of the indane skeleton (preferably a trimethylindane structure) in the cured product of the composition containing the resin (IP2), and the Df (dielectric loss tangent) can thus be lowered. In particular, it is presumed that a low Df can be achieved even when the curing temperature is high. Further, the resin of the present embodiment can have excellent thermal resistance. The resin (IP2) can also have a low relative permittivity (Dk). The resin (IP2) may be the same resin as the resin (IP1).

[Chem.115]

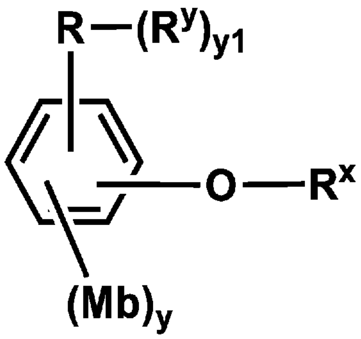

(D)

(In Formula (D), R is a group containing a structural unit represented by Formula (Tx). $R^x$ is a group containing a carbon-carbon unsaturated double bond. $R^y$ is a hydrogen atom, a group containing an -O-carbon-carbon unsaturated double bond, or another group. y1 is an integer of from 1 to 4. each Mb independently represents a hydroxyl group, a halogen atom, or a hydrocarbon group having from 1 to 20 carbon atoms, each carbon atom being optionally substituted with a hydroxyl group or a halogen atom. y represents an integer of from 0 to 4.)

[Chem.116]

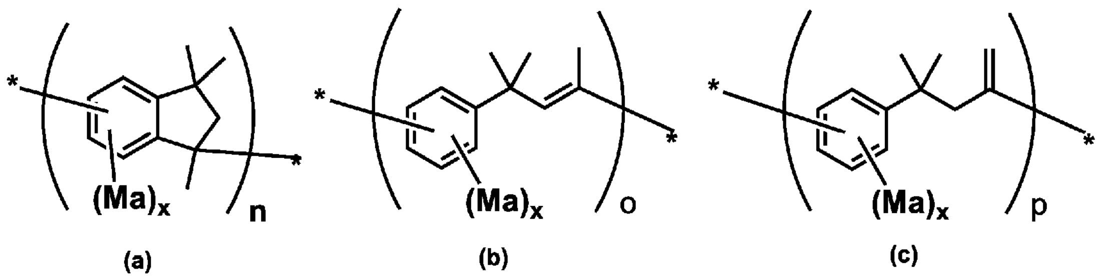

(Tx)

(In Formula (Tx), n, o, and p represent an average number of repeating units, n represents a number of more than 0 and 20 or less, o and p each independently represent a number of from 0 to 20, and $1.0 \leq n + o + p \leq 20.0$. each Ma independently represents a hydrocarbon group having from 1 to 12 carbon atoms, each carbon atom being optionally substituted with a halogen atom. x represents an integer of from 0 to 4. the structural units (a), (b), and (c) are each bonded at * to the structural unit (a), (b), or (c), or an additional group, and structural units may be randomly bonded.)

In Formula (D), R is a group containing a structural unit represented by Formula (Tx).

That is, in the resin (IP2), R contains at least the structural unit (a) in a part thereof, and may further contain the structural units (b) and/or (c), and may further have another structural unit (hereinafter, it may be referred to as "additional structural unit") or another group other than the structural units (a), (b) or (c). That is, the structural units (a), (b), and (c) may be bonded at * to: any one of the structural units (a) to (c); the additional structural unit other than the structural units (a) to (c); another group; and a group bonded to R in Formula (D), respectively.

In the resin (IP2), R is not necessarily linear, and may be bonded two-dimensionally or three-dimensionally. In the present embodiment, the resin (IP2) (in particular, a group containing a structural unit represented by Formula (Tx)) is preferably linear. When the respective structural units constituting the resin (IP2) are linearly bonded, low dielectric properties tend to improve, which is preferable.

Examples of another structural unit include a structural unit derived from a compound represented by Formula (DIP) which is bonded to any one of structural units (a), (b) and (c).

It is needless to say that the structural unit derived from the compound represented by Formula (DIP) may be synthesized from the compound represented by Formula (DIP) or may be synthesized from another raw material that gives the structural unit derived from the compound represented by Formula (DIP). Examples of another raw material for

providing the structural unit derived from the compound represented by Formula (DIP) include equivalents of the compound represented by Formula (DIP), which provide the compound represented by Formula (DIP) through a unit operation such as heating, such as α,α'-dihydroxy-1,3-diisopropylbenzene, α,α'-dihalogeno-1,3-diisopropylbenzene, and α,α'-dialkoxy-1,3-diisopropylbenzene.

[Chem.117]

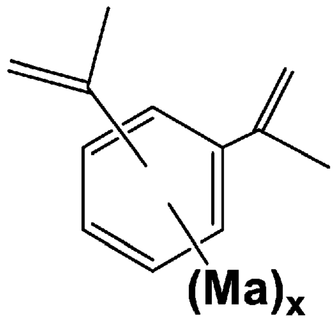

(DIP)

(In Formula (DIP), each Ma independently represents a hydrocarbon group having from 1 to 12 carbon atoms, each carbon atom being optionally substituted with a halogen atom. x represents an integer of from 0 to 4.)

The details of Formula (DIP) have the same meaning as described in the section of the resin (IP1), and the preferred range thereof is also the same.

When the resin (IP2) has an additional structural unit, the resin (IP2) may have a branched structure.

Further, in the resin (IP2), the double bond of the structural unit (b) and/or (c) may react with the structural unit derived from the compound represented by Formula (DIP) to form a ring, thereby constituting a structural unit having an indane skeleton. As an example of such a structure, for example, the following structure is exemplified.

[Chem.118]

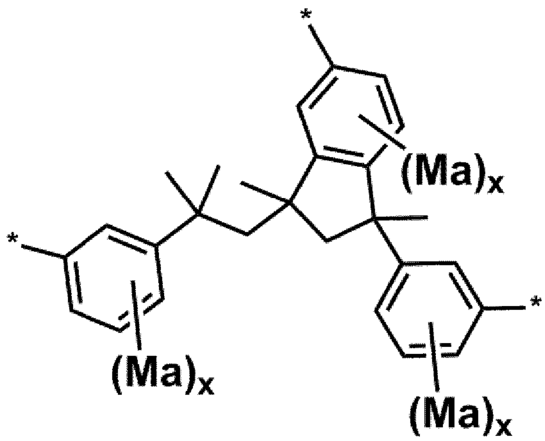

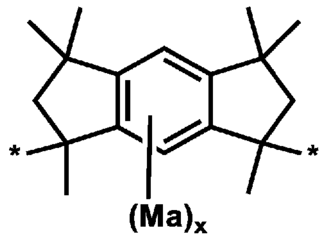

In the above structure, Ma and x each independently have the same meaning as Ma and x in Formula (Tx), and the preferred ranges are also the same.

In the above structure, * is preferably bonded to any one of the terminal groups bonded to R in Formula (D) or any of the structural units (a) to (c).

Further, a terminal group may be bonded to the structural unit (a), (b), or (c).

The resin (IP2) may contain the compound described below.

[Chem.119]

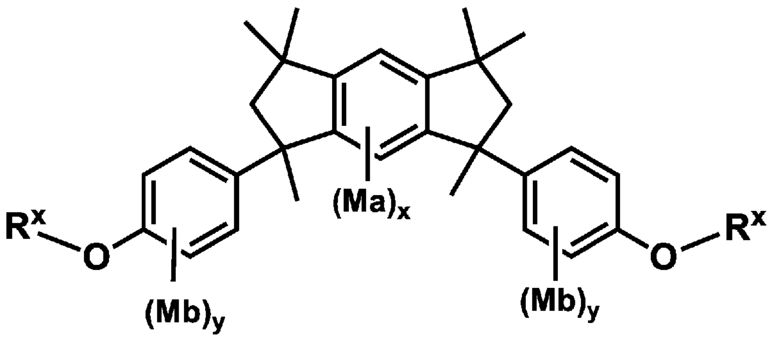

In the above-described compound, Ma and x have the same meanings as Ma and x in Formula (Tx), respectively, and the preferred ranges are also the same. Mb and y each independently have the same meaning as Mb and y in Formula (D) described above, and the preferred ranges thereof are also the same. $R^x$ is a group containing a carbon-carbon unsaturated double bond.

Formula (Tx) has the same meaning as (Tx) described in the section of the resin (A), and the preferred range thereof is also the same.

In Formula (D), $R^x$ is a group containing a carbon-carbon unsaturated double bond, and more preferably a group having a formula weight from 27 to 120.

Specifically, each $R^x$ is independently preferably a group represented by Formula (Rx-11) or a group represented by Formula (Rx-2), more preferably a vinylbenzyl group or a (meth)acryloyl group, and still more preferably a vinylbenzyl group.

[Chem.120]

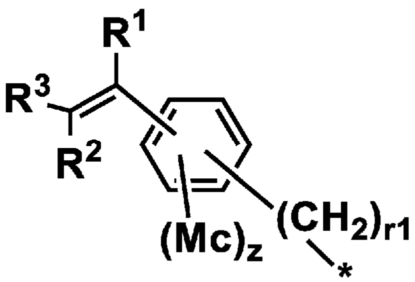 (Rx-11) 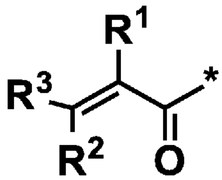 (Rx-2)

(In Formula (Rx-11) and Formula (Rx-2), $R^1$, $R^2$, and $R^3$ each independently represent a hydrogen atom, an alkyl group, an alkenyl group, or an alkynyl group. * is a bonding position for an oxygen atom. each Mc independently represents a hydrocarbon group having from 1 to 12 carbon atoms. z represents an integer of from 0 to 4. r1 represents an integer of from 1 to 6.)

Formulas (Rx-11) and (Rx-2) have the same meanings as Formulas (Rx-1) and (Rx-2) described in the section of the polyphenylene ether compound except for r1, and the preferred ranges thereof are also the same. r1 in Formula (Rx-11) is preferably an integer of 5 or less, more preferably an integer of 4 or less, still more preferably an integer of 3 or less, yet still more preferably 1 or 2, and further preferably 1.

In Formula (D), $R^y$ is a hydrogen atom, a group containing an -O-carbon-carbon unsaturated double bond, or another group.

$R^y$ is bonded to R at any position, but may be bonded to any one of the structural units (a), (b), or (c) contained in R and the additional structural unit described above. An example of an aspect in which R is bonded is an aspect in which R is bonded to a benzene ring of the structural unit (a), (b) or (c). Still another example of the aspect in which R is bonded is an aspect in which R is bonded to the additional structural unit other than the structural units (a), (b), or (c) included in R. In the resin of the present embodiment, preferably, at least one of $R^y$ is bonded to the benzene ring of the structural unit (a), (b) or (c), and more preferably, at least one of $R^y$ is bonded to the benzene ring of the structural unit (a).

When $R^y$ is a group containing an -O-carbon-carbon unsaturated double bond, the group containing a carbon-carbon unsaturated double bond has the same meaning as $R^x$ described above, and the preferred range thereof is also the same.

The number of groups containing a carbon-carbon unsaturated double bond in $R^y$ is preferably 0.2 or more, more preferably 0.3 or more, still more preferably 0.4 or more, yet still more preferably 0.5 or more, yet further preferably 0.8 or more, and may be 1.0 or more in terms of the average value of all molecules in the resin (IP2). The number of groups containing a carbon-carbon unsaturated double bond in $R^y$ is preferably 7 or less, more preferably 6 or less, still more

preferably 5 or less, still more preferably 4 or less, and yet still more preferably 3 or less in terms of the average value of all molecules in the resin, and may be 2.5 or less, 1.5 or less, less than 1.5, 1.4 or less, or 1.2 or less.

When $R^y$ has another group, examples of another group include an organic group, a hydroxyl group, and a halogen atom. As the organic group, a hydrocarbon group having from 1 to 20 carbon atoms optionally substituted with a hydroxyl group or a halogen atom is preferable, a hydrocarbon group having from 1 to 5 carbon atoms, each carbon atom being optionally substituted with a hydroxyl group or a halogen atom, is more preferable, a saturated hydrocarbon group having from 1 to 5 carbon atoms is still more preferable, a saturated hydrocarbon group having from 1 to 3 carbon atoms is yet still more preferable, and a propyl group or an isopropyl group is yet still more preferable.

In Formula (D), y1 is an integer of from 1 to 4, preferably 1 or more, preferably 3 or less, more preferably 2 or less, and still more preferably 1.

The total number of groups containing a carbon-carbon unsaturated double bond contained in $R^x$ and/or $R^y$ per molecule of the resin (IP2) is preferably 2.5 or less, more preferably less than 2.5, still more preferably 2.4 or less, and may be 2.2 or less in terms of the average value of all molecules in the resin (IP2). The total number of groups containing a carbon-carbon unsaturated double bond contained in $R^x$ and/or $R^y$ per molecule of the resin (IP2) is preferably 0.8 or more, more preferably 1.2 or more, still more preferably 1.3 or more, yet still more preferably 1.4 or more, yet still more preferably 1.5 or more, yet still more preferably 1.8 or more, and may be 2.0 or more. When the total number of groups containing the carbon-carbon unsaturated double bond is within the above range, the cured product tends to have excellent low dielectric properties.

In Formula (D), each Mb independently represents a hydroxyl group, a halogen atom, or a hydrocarbon group having from 1 to 20 carbon atoms, each carbon atom being optionally substituted with a hydroxyl group or a halogen atom, and has the same meaning as Mb in Formula (T-St), and the preferred range is also the same.

In Formula (D), y represents an integer of from 0 to 4, preferably an integer of from 0 to 3, more preferably an integer of from 0 to 2, still more preferably 0 or 2, and may be 0. It is preferable that y is 2 from the viewpoint of dielectric properties.

When y is 1 or more, Mb is preferably bonded at an adjacent position (ortho position) to the carbon atom to which the $R^xO$ group is bonded.

In the resin (IP2) of the present embodiment, Formula (D) is preferably represented by Formula (D-1).

[Chem.121]

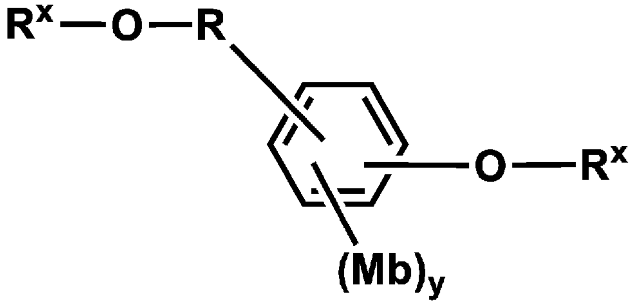

(D-1)

(In Formula (D-1), R is a group containing a structural unit represented by Formula (Tx). each $R^x$ independently represents a group containing a carbon-carbon unsaturated double bond. each Mb independently represents a hydroxyl group, a halogen atom, or a hydrocarbon group having from 1 to 20 carbon atoms, each carbon atom being optionally substituted with a hydroxyl group or a halogen atom. y represents an integer of from 0 to 4.)

Further, Formula (D-1) is preferably represented by Formula (D-1-2).

[Chem.122]

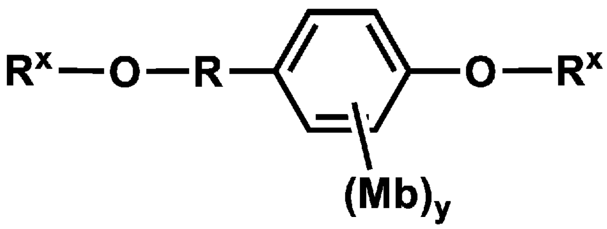

(D-1-2)

(In Formula (D-1-2), R is a group containing a structural unit represented by Formula (Tx). each $R^x$ independently

represents a group containing a carbon-carbon unsaturated double bond. each Mb independently represents a hydroxyl group, a halogen atom, or a hydrocarbon group having from 1 to 20 carbon atoms, each carbon atom being optionally substituted with a hydroxyl group or a halogen atom. y represents an integer of from 0 to 4.)

In the resin (IP2) of the present embodiment, Formula (D) is preferably represented by Formula (D-2).

[Chem.123]

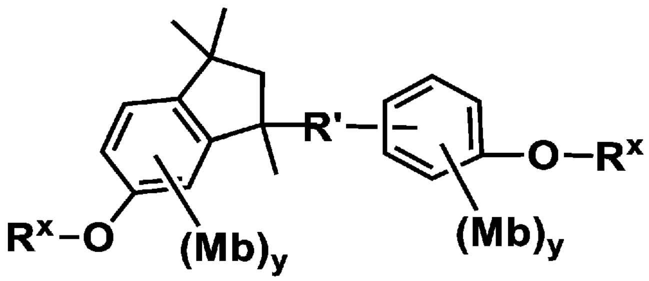

(D-2)

(In Formula (D-2), R' is a group to be a group containing the structural unit represented by Formula (Tx) together with the group having an indane skeleton adjacent to the left side, and each $R^x$ is independently a group containing a carbon-carbon unsaturated double bond. each Mb independently represents a hydroxyl group, a halogen atom, or a hydrocarbon group having from 1 to 20 carbon atoms, each carbon atom being optionally substituted with a hydroxyl group or a halogen atom. y represents an integer of from 0 to 4.)

Further, Formula (D-2) is preferably represented by Formula (D-2-1).

[Chem.124]

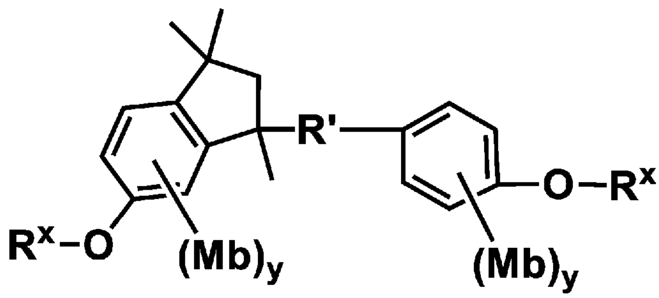

(D-2-1)

(In Formula (D-2-1), R' is a group to be a group containing a structural unit represented by Formula (Tx) together with the group having an indane skeleton adjacent to the left side, and each $R^x$ is independently a group containing a carbon-carbon unsaturated double bond. each Mb independently represents a hydroxyl group, a halogen atom, or a hydrocarbon group having from 1 to 20 carbon atoms, each carbon atom being optionally substituted with a hydroxyl group or a halogen atom. y represents an integer of from 0 to 4.)

In Formulas (D-1), (D-1-2), (D-2), and (D-2-1), each $R^x$ independently has the same meaning as $R^x$ in Formula (D), and the preferred range thereof is also the same.

In Formula (D-1) and Formula (D-1-2), each R independently has the same meaning as R in Formula (D), and the preferred range thereof is also the same.

In Formulas (D-2) and (D-2-1), R' is a group to be a group containing the structural unit represented by Formula (Tx) together with the group having an indane skeleton adjacent to the left side. That is, Formula (D) essentially has a structure in which $R^y$ is a group containing an -O-carbon-carbon unsaturated double bond, and an oxygen atom thereof is bonded to the benzene ring of the structural unit (a) in Formula (Tx). Specifically, for example, in Formula (D-2), a circled portion described below corresponds to R in Formula (D).

[Chem.125]

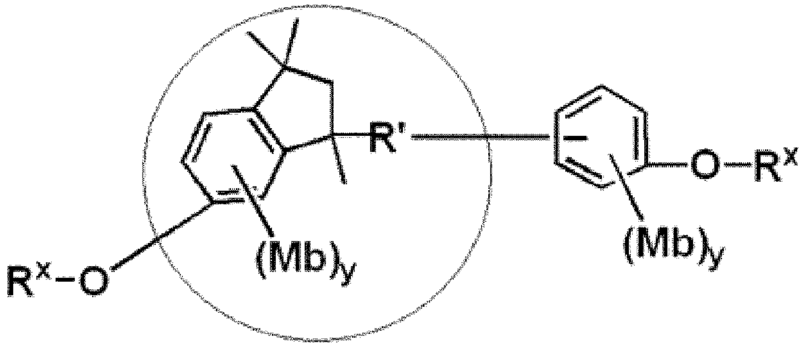

(D-2)

In Formula (D-1), Formula (D-1-2), Formula (D-2), and Formula (D-2-1), Mb and y each independently have the same meaning as Mb and y in Formula (D), and the preferred ranges are also the same.

In the present embodiment, the resin (IP1) and/or the resin (IP2) preferably have parameter $\alpha$ of 0.35 or more and 1.00 or less as calculated from Equation ($\alpha$).

[Num.3]

$$\text{PARAMETER } \alpha = \frac{(2.55 \text{ ppm to } 2.31 \text{ ppm})}{(6.24 \text{ ppm to } 5.91 \text{ ppm}) + (2.98 \text{ ppm to } 2.55 \text{ ppm})/2 + (2.55 \text{ ppm to } 2.31 \text{ ppm})} \qquad (\alpha)$$

(Expressions in parentheses in Equation ($\alpha$) indicate integral values between corresponding chemical shift values in $^1$H-NMR.)

Here, $\alpha$ represents the proportion of the structural unit (structural unit (a) in Formula (Tx)) having an indane skeleton in the resin (IP1) and/or the resin (IP2). More specifically, it is presumed that by adjusting the proportion of the structural unit having an indane skeleton in the resin (IP1) and/or the resin (IP2) so as to satisfy the range of the parameter $\alpha$, the rigidity of the resulting resin molecule is increased. The molecule having high rigidity has lower mobility than the molecule having low rigidity. Thus, the relaxation time at the time of dielectric relaxation becomes longer, and the dielectric loss tangent (Df) can be lowered. In addition, it is presumed that since the rigidity of the resin molecule is increased, the glass transition temperature of the cured product can be increased, and the thermal resistance is excellent. In the present embodiment, R in Formula (D), a group containing a structural unit represented by Formula (Tx), is bonded to ($R^x$), a group containing a carbon-carbon unsaturated double bond, via a low-molecular-weight structural unit such as an oxygen atom and/or a phenyleneoxy group optionally having a substituent, thereby increasing the content proportion of the indane skeleton in the resin (IP1) and/or the resin (IP2).

The parameter $\alpha$ in the resin (IP1) and/or the resin (IP2) is more preferably 0.36 or more, still more preferably 0.40 or more, yet still more preferably 0.45 or more, and yet still more preferably 0.50 or more. Further, the parameter $\alpha$ may be 0.55 or more, 0.60 or more, 0.65 or more, or 0.70 or more. When the parameter $\alpha$ is the above lower limit or more, the resulting cured product tends to have further improved low dielectric properties (low relative permittivity and/or low dielectric loss tangent) and thermal resistance. The parameter $\alpha$ is preferably large because the parameter $\alpha$ tends to provide substantially excellent low dielectric properties and thermal resistance. However, the parameter $\alpha$ may be 0.98 or less, 0.95 or less, 0.90 or less, 0.85 or less, 0.84 or less, or 0.82 or less.

The number average molecular weight of the resin (IP1) and/or the resin (IP2) is preferably 8000 or less, and more preferably 4000 or less. When the number average molecular weight is the above lower limit or more, the resulting cured product tends to have further improved low dielectric properties (in particular, low dielectric loss tangent). This is considered to be because the proportion of the indane skeleton (for example, the structural unit (a) in Formula (Tx)) contained in the molecule increases as the molecular weight is increased. When the number average molecular weight is the above upper limit or less, the moldability and solvent solubility of the resin tend to further improve. The lower limit of the number average molecular weight of the resin (IP1) and/or the resin (IP2) is more preferably 500 or more, still more preferably 600 or more, and yet still more preferably 700 or more, yet still more preferably 800 or more, and may be 850 or more, 900 or more, 1000 or more, 1100 or more, 1200 or more, 1300 or more, 1400 or more, 1500 or more, 1600 or more, 1700 or more, 1800 or more, 1900 or more, 2000 or more, 2200 or more, 2300 or more, 2400 or more, 2500 or more, or 2600 or more. The upper limit of the number average molecular weight of the resin (IP1) and/or the resin (IP2) is more preferably 7000 or less, still more preferably 6000 or less, yet still more preferably 5000 or less, yet still more preferably 4000 or less, and may be 3800 or less, 3500 or less, 3200 or less, or 3000 or less, and further, may be 2800 or less, 2600 or less, 2400 or less, 2200 or less, 2000 or less, 1900 or less, 1800 or less, 1700 or less, 1600 or less, or 1500 or less.

A method for producing the resin represented by the resin (IP1) and/or the resin (IP2) is not particularly limited.

For example, it can be produced using a hydroxy resin in which the RxO moiety and the Ry moiety are hydroxyl groups in Formula (D).

Examples of a first embodiment of the method for producing the resin (IP1) and/or the resin (IP2) include a method in which a mixture containing a compound represented by Formula (DIP) and a compound represented by Formula (P1) is reacted to synthesize a resin having a hydroxyl group (hereinafter, it may be referred to as "hydroxy resin"), and the hydroxy resin is reacted with a compound having a group containing a carbon-carbon unsaturated double bond and a group that reacts with the hydroxyl group of the hydroxy resin to be eliminated to synthesize the resin. Further, the hydroxy resin may be synthesized by reacting a compound represented by Formula (DIP) with a compound represented by Formula (P1) described later, and then further reacting a compound represented by Formula (DIP).

[Chem.126]

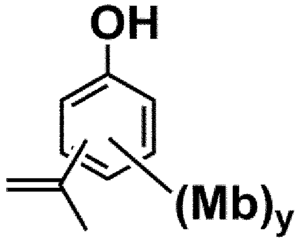

(P1)

(In Formula (P1), each Mb independently represents a hydroxyl group, a halogen atom, or a hydrocarbon group having from 1 to 20 carbon atoms, each carbon atom being optionally substituted with a hydroxyl group or a halogen atom. y represents an integer of from 0 to 4.)

Mb and y in Formula (P1) have the same meaning as Mb and y in Formula (D), and the preferred ranges thereof are also the same.

The compound having a group containing a carbon-carbon unsaturated double bond and the group that reacts with the hydroxyl group of the hydroxy resin to be eliminated will be described.

The group containing a carbon-carbon unsaturated double bond is preferably a group represented by Formula (Rx-1) or a group represented by Formula (Rx-2), more preferably a vinylbenzyl group or a (meth)acryloyl group, and still more preferably a vinylbenzyl group.

On the other hand, examples of the group that reacts with the hydroxyl group of the hydroxy resin to be eliminated include a halogen atom, a hydroxyl group, an alkoxy group, and a (meth)acryloyl group, and a halogen atom is preferable. Examples of the halogen atom include a chlorine atom, a bromine atom, and an iodine atom. The halogen atom is preferably a chlorine atom or a bromine atom.

As a first embodiment of the method for producing the resin (IP1) and/or the resin (IP2), the resin (IP1) and/or the resin (IP2) can be produced by synthesizing a polymer (oligomer) containing, as a main component, a structural unit derived from a compound represented by Formula (DIP) in advance from a compound represented by Formula (DIP), then reacting the polymer with a compound represented by Formula (P1) to synthesize a hydroxy resin, and reacting the obtained hydroxy resin with a compound having a group containing a carbon-carbon unsaturated double bond and a group that reacts with the hydroxyl group of the hydroxy resin to be eliminated.

Another example of another compound (compound (XC)) having a carbon-carbon unsaturated double bond at a terminal is vinylbenzyl ether.

Examples of the vinyl benzyl ether include a reaction product of 4,4'-isopropylidene bis(2,6-dimethylphenol) (tetramethylbisphenol A), hexamethylbiphenol (2,2',3,3',5,5'-hexamethyl-(1,1'-biphenyl)-4,4'-diol), or the like with vinylbenzyl chloride or vinylbenzyl bromide.

In addition, 2-(diphenylphosphoryl)hydroquinone, bis(2,6-dimethylphenol), 2,2'-biphenol, 4,4-biphenol, 2,2',6,6'-tetramethylbiphenol, 3,3',5,5'-tetrabromo-2,2'6,6'-tetramethylbiphenol, 3,3'-dibromo-2,2',6,6'-tetramethylbiphenol, 4,4'-isopropylidenediphenol (bisphenol A), 4,4'-isopropylidene bis(2,6-dibromophenol) (tetrabromobisphenol A), 4,4'-isopropylidene bis(2-methylphenol), 4,4'-isopropylidene bis(2-allylphenol), 4,4'(1,3-phenylenediisopropylidene) bisphenol (bisphenol M), 4,4'-isopropylidene bis(3-phenylphenol), 4,4'-(1,4-phenylenediisopropylidene)bisphenol (bisphenol P), 4,4'-ethylidenediphenol (bisphenol E), 4,4'-oxydiphenol, 4,4'-thiodiphenol, 4,4'-thiobis(2,6-dimethylphenol), 4,4'-sulfonyldiphenol, 4,4'-sulfonylbis (2,6-dimethylphenol), 4,4'-sulfinyldiphenol, 4,4'-hexafluoroisopropylidene) bisphenol (bisphenol AF), 4,4'(1-phenylethylidene)bisphenol (bisphenol AP), bis(4-hydroxyphenyl)-2,2-dichloroethylene (bisphenol C), bis(4-hydroxyphenyl)methane (bisphenol-F), bis(2,6-dimethyl-4-hydroxyphenyl) methane, 4,4'-(cyclopentylidene)diphenol, 4,4'-(cyclohexylidene)diphenol (bisphenol Z), 4,4'-(cyclododecylidene)diphenol, 4,4'-(bicyclo [2.2.1] heptylidene)diphenol, 4,4'-(9H-fluorene-9,9-diyl)diphenol, 3,3-bis(4-hydroxyphenyl)isobenzofuran-1(3H)-one, 1-(4-hydroxyphenyl)-3,3-dimethyl-2,3-dihydro-1H-indene-5-ol, 1-(4-hydroxy-3,5-dimethylphenyl)-1,3,3,4,6-pentamethyl-2,3-dihydro-1H-indene-5-ol, 3,3,3',3'-tetramethyl-2,2',3,3'-tetrahydro-1,1'-spirobi[indene]-5,6'-diol (spirobiindane), dihydroxybenzophenone (bisphenol K), tris(4-hydroxyphenyl)methane, tris(4-hydroxyphenyl) ethane, tris(4-hydroxyphenyl)propane, tris(4-hydroxyphenyl) butane, tris(3-methyl-4-hydroxyphenyl)methane, tris(3,5-dimethyl-4-hydroxyphenyl)methane, tetrakis(4-hydroxyphenyl) ethane, tetrakis(3,5-dimethyl-4-hydroxyphenyl) ethane, bis(4-hydroxyphenyl) phenylphosphine oxide, dicyclopentadienyl bis(2,6-dimethylphenol), dicyclopentadienyl bis(o-cresol),dicyclopentadienyl bisphenol, or the like, and vinyl benzyl ether produced by the reaction of bisphenols or the like with vinylbenzyl chloride or vinylbenzyl bromide.

In addition to the above, the vinyl benzyl compound as the compound (C) also includes a compound having a number average molecular weight of more than 400 among the vinyl benzyl ether compounds described in paragraph 0041 of JP 2019-194312 A, the contents of which are incorporated herein by reference.

In addition to the above, a compound having a number average molecular weight of more than 400 and having vinylphenyl at the terminal described in WO 2022/210095 (for example, the compound described in Synthesis Examples 12 to 16 of the same publication), a vinyl benzyl ether resin described in paragraphs 0029 to 0039 of JP 2022-85610 A and paragraph 0041 of JP 2019-194312 A, a copolymerized oligomer described in paragraphs 0013 to 0027 of WO 2022/014599, a copolymer described in JP 2024-007493 A, a compound described in WO 2021/100658, a compound described in JP 2024-086554 A, and the like can also be used, the contents of which are incorporated herein by reference.

When the resin composition of the present embodiment contains the additional compound (compound (XC)) having a carbon-carbon unsaturated double bond at the terminal, the content thereof is preferably 1 part by mass or more and preferably 50 parts by mass or less with respect to 100 parts by mass of the resin solid content in the resin composition.

The resin composition in the present embodiment may contain only one of, or two or more of the additional compound (compound (XC)) having a carbon-carbon unsaturated double bond at a terminal. When two or more aliphatic polyamide resins are contained, the total amount is preferably in the range described above.

The resin composition in the present embodiment can also be configured to contain substantially no additional compound (compound (XC)) having a carbon-carbon unsaturated double bond at a terminal. The phrase "contain substantially no" means that the content of the additional compound (compound (XC)) having a carbon-carbon unsaturated double bond at a terminal is less than 1 part by mass, preferably less than 0.1 parts by mass, and more preferably less than 0.01 parts by mass, with respect to 100 parts by mass of the resin solid content in the resin composition.

The content of the thermosetting compound (C) having a number average molecular weight of more than 400 in the resin composition of the present embodiment is preferably 10 parts by mass or more, more preferably 50 parts by mass or more, still more preferably parts by mass or more, even more preferably 100 parts by mass or more, further more preferably 150 parts by mass or more, and is preferably 1000 parts by mass or less, more preferably 800 parts by mass or less, still more preferably 600 parts by mass or less, even more preferably 400 parts by mass or less, further more preferably 250 parts by mass or less with respect to 100 parts by mass of the resin (A). When the content is the above lower limit or more, the thermal resistance (low dielectric properties (Dk and/or Df, in particular Df) after heating) over time of the resulting cured product can be more effectively maintained, and the thermal resistance (in particular, the glass transition temperature) tends to be further improved. When the content is the above upper limit or less, the resulting cured product tends to have further improved low dielectric properties (Dk and/or Df, in particular Df).

The resin composition of the present embodiment may contain only one, or two or more compounds (C). When two or more aliphatic polyamide resins are contained, the total amount is preferably in the range described above.

In the resin composition of the present embodiment, a total amount of the resin (A), the compound (B), and the compound (C) is preferably 50 parts by mass or more, more preferably 60 parts by mass or more, in 100 parts by mass of the resin solid content contained in the resin composition, and may be 80 parts by mass or more, 90 parts by mass or more, or 100 parts by mass, depending on the intended use and the like.

<Elastomer>

The resin composition of the present embodiment may contain an elastomer. The elastomer may be thermoplastic, thermosetting, or may be neither thermoplastic nor thermosetting, and is preferably thermoplastic.

The elastomer in the present embodiment is not particularly limited, and examples of the elastomer include at least one selected from the group consisting of polyisoprene, polybutadiene, styrene-butadiene, butyl rubber, ethylene-propylene rubber, styrene-butadiene-ethylene, styrene-butadienestyrene, styrene-isoprene-styrene, styrene-ethylene-butylene-styrene, styrene-propylene-styrene, styrene-ethylene-propylene-styrene, fluororubber, silicone rubber, their hydrogenated compounds, their alkylated compounds, and their copolymers.

Examples of the elastomer include oligomers or polymers having a curable vinyl functional group described in paragraphs 0044 and 0045 of JP 2019-194312 A, polybutadiene resins, a compound described in JP 2022-085610 A, and 1,2-SBS-L42 (liquid 1,2-SBS) and 1,2-SBS-P35 (solid 1,2-SBS) available from Nippon Soda Co., Ltd., the contents of which are incorporated herein by reference.

The number average molecular weight of the elastomer (preferably, thermoplastic elastomer) used in the present

embodiment is preferably 1000 or more. When the number average molecular weight is 1000 or more, the resulting cured product tends to have more excellent low dielectric properties (Dk and/or Df, in particular, low dielectric loss tangent). The number average molecular weight is preferably 1500 or more, more preferably 2000 or more, and may be 60000 or more, 70000 or more, or 80000 or more depending on the intended use and the like. The upper limit of the number average molecular weight of the elastomer is preferably 400000 or less, more preferably 350000 or less, and still more preferably 300000 or less. When the number average molecular weight is the above upper limit or less, the solubility of the elastomer component in the resin composition tends to improve.

When the resin composition of the present embodiment contains two or more elastomers, the number average molecular weight of their mixture is preferably within the range described above.

Examples of the elastomer used in the present embodiment include a resin containing a polybutadiene structure. The polybutadiene structure may be partially or fully hydrogenated. Specific examples thereof include B-1000, B-2000, B-3000, BI-2000, and BI-3000 available from Nippon Soda Co., Ltd., and Ricon 100, Ricon 130, Ricon 131, Ricon 142, Ricon 150, Ricon 181, and Ricon 184 available from CRAY VALLEY.

Examples of the elastomer used in the present embodiment include a resin having a poly(meth)acrylate structure. Specific examples thereof include Teisan Resin available from Nagase ChemteX Corporation, and ME-2000, W-197C, KG-15, and KG-3000 available from Negami Chemical Industrial Co., Ltd.

Examples of the elastomer used in the present embodiment include a resin having a polycarbonate structure. The resin having a polycarbonate structure may be referred to as a "polycarbonate resin". Examples of such a resin include a carbonate resin having no reactive group, a hydroxy group-containing carbonate resin, a phenolic hydroxyl group-containing carbonate resin, a carboxy group-containing carbonate resin, an acid anhydride group-containing carbonate resin, an isocyanate group-containing carbonate resin, a urethane group-containing carbonate resin, and an epoxy group-containing carbonate resin. Here, the reactive group refers to a functional group capable of reacting with other components such as a hydroxy group, a phenolic hydroxyl group, a carboxy group, an acid anhydride group, an isocyanate group, a urethane group, and an epoxy group.

Specific examples of the polycarbonate resin include FPC 0220 and FPC 2136 available from MITSUBISHI GAS CHEMICAL COMPANY, INC., and T6002 and T6001 (polycarbonate diol) available from Asahi Kasei Corporation.

Examples of the elastomer used in the present embodiment include a resin having a polysiloxane structure. Specific examples thereof include SMP-2006, SMP-2003 PGMEA, SMP-5005 PGMEA, KR-510, and SMP-7014-3S available from Shin-Etsu Chemical Co., Ltd.

Examples of the elastomer used in the present embodiment include a resin having a polyalkylene structure and/or a polyalkyleneoxy structure. The polyalkyleneoxy structure is preferably a polyalkyleneoxy structure having from 2 to 15 carbon atoms, more preferably a polyalkyleneoxy structure having from 3 to 10 carbon atoms, and particularly preferably a polyalkyleneoxy structure having from 5 to 6 carbon atoms. Specific examples of the resin having a polyalkylene structure and/or a polyalkyleneoxy structure include PTXG-1000 and PTXG-1800 available from Asahi Kasei Fibers Corporation.

Examples of the elastomer used in the present embodiment include a resin having a polyisoprene structure. Specific examples thereof include KL-610 and KL613 available from Kuraray Co., Ltd.

Examples of the elastomer used in the present embodiment include a resin having a polyisobutylene structure. Specific examples thereof include SIBSTAR-073T (styrene-isobutylene-styrene triblock copolymer) and SIBSTAR-042D (styrene-isobutylene diblock copolymer) available from KANEKA CORPORATION.

In the present embodiment, the elastomer is preferably an elastomer containing a styrene monomer unit and a conjugated diene monomer unit (hereinafter referred to as "elastomer (e)"). By using such an elastomer (e), the resulting cured product has more excellent low dielectric properties (Dk and/or Df, in particular, low dielectric loss tangent).

The elastomer (e) contains a styrene monomer unit. With the elastomer (e) containing the styrene monomer unit, the solubility of the elastomer (e) in the resin composition is improved. Examples of the styrene monomer include styrene, $\alpha$-methylstyrene, p-methylstyrene, divinylbenzene (vinylstyrene), N,N-dimethyl-p-aminoethylstyrene, and N,N-diethyl-p-aminoethylstyrene. Of these, styrene, $\alpha$-methylstyrene, and p-methylstyrene are preferable from the viewpoint of availability and productivity. Among these, styrene is particularly preferred.

The content of the styrene monomer unit in the elastomer (e) is preferably 10 mass% or more, more preferably 13 mass% or more, and still more preferably 15 mass% or more of all the monomer units, and is preferably 150 mass% or less, more preferably 45 mass% or less, and still more preferably 40 mass% or less. When the content of the styrene monomer unit is the above upper limit or less, adhesion and tackiness to a substrate or the like are further improved. When the content of the styrene monomer unit is the above lower limit or more, an increase in adhesiveness can be suppressed, an adhesive residue or a stop mark is less likely to occur, and easy release between adhesive faces tend to be improved, which is preferable.

The elastomer (e) may contain only one styrene monomer unit, or two or more styrene monomer units. When two or more types are contained, a total amount thereof is preferably in the above range.

As for a method for measuring the content of the styrene monomer unit in the elastomer (e) of the present

embodiment, reference can be made to the description of WO 2017/126469, the contents of which are incorporated herein by reference. The same shall apply to the conjugated diene monomer unit to be described later.

The elastomer (e) contains a conjugated diene monomer unit. With the elastomer (e) containing the conjugated diene monomer unit, the solubility of the elastomer (e) in the resin composition is improved. The conjugated diene monomer is not particularly limited as long as it is a diolefin having a pair of conjugated double bonds. Examples of the conjugated diene monomer include 1,3-butadiene, 2-methyl-1,3-butadiene (isoprene), 2,3-dimethyl-1,3-butadiene, 1,3-pentadiene, 2-methyl-1,3-pentadiene, 1,3-hexadiene, and Farnesene. Of these, 1,3-butadiene and isoprene are preferable, and 1,3-butadiene is more preferred.

The elastomer (e) may contain only one conjugated diene monomer unit, or two or more conjugated diene monomer units.

In the elastomer (e), the mass ratio of the styrene monomer unit to the conjugated diene monomer unit (styrene monomer unit/conjugated diene monomer unit) is preferably in a range from 5/95 to 80/20, more preferably in a range from 7/93 to 77/23, and still more preferably in a range from 10/90 to 70/30. When the mass ratio of the styrene polymer unit to the conjugated diene monomer unit is in the range from 5/95 to 80/20, an increase in adhesiveness can be suppressed, adhesive strength can be maintained high, and easy release between adhesive faces is improved.

In the elastomer (e), all of the conjugated diene bonds of the elastomer may be hydrogenated, some of the conjugated diene bonds may be hydrogenated, or the conjugated diene bonds do not have to be hydrogenated.

The elastomer (e) may or may not contain an additional monomer unit in addition to the styrene monomer unit and the conjugated diene monomer unit. Examples of the additional monomer unit include an aromatic vinyl compound unit other than the styrene monomer unit.

In the elastomer (e), a total of the styrene monomer unit and the conjugated diene monomer unit is preferably 90 mass% or more, more preferably 95 mass% or more, still more preferably 97 mass% or more, and even more preferably 99 mass% or more of all the monomer units.

As described above, the elastomer (e) may contain only one type of each of the styrene monomer unit and the conjugated diene monomer unit, or may contain two or more types of each of the styrene monomer units and the conjugated diene monomer units. When two or more types are contained, the total amount is preferably in the range described above.

The elastomer (e) used in the present embodiment may be a block polymer or a random polymer. The elastomer (e) may be a hydrogenated elastomer in which the conjugated diene monomer units are hydrogenated, an unhydrogenated elastomer in which the conjugated diene monomer units are not hydrogenated, or a partially hydrogenated elastomer in which the conjugated diene monomer units are partially hydrogenated, and is preferably an unhydrogenated elastomer or a partially hydrogenated elastomer.

In an embodiment of the present embodiment, the elastomer (e) is a hydrogenated elastomer. Here, the hydrogenated elastomer means, for example, one in which double bonds based on a conjugated diene monomer unit in an elastomer are hydrogenated, and is intended to include one having a hydrogen addition percentage (hydrogenation percentage) of 80% or more in addition to one having a hydrogenation percentage of 100%. The hydrogenation percentage of the hydrogenated elastomer is preferably 85% or more, more preferably 90% or more, and still more preferably 95% or more. In the present embodiment, the hydrogenation percentage is calculated from the measurement results of $^{1}$H-NMR spectrum measurement.

In an embodiment of the present embodiment, the elastomer (e) is an unhydrogenated elastomer. Here, the "unhydrogenated elastomer" is intended to include an elastomer having a proportion of hydrogenated double bonds among double bonds based on conjugated diene monomer units in the elastomer, i.e., a hydrogen addition percentage (hydrogenation percentage) of 20% or less. The hydrogenation percentage is preferably 15% or less, more preferably 10% or less, and still more preferably 5% or less.

Meanwhile, the partially hydrogenated elastomer means one in which some of double bonds based on a conjugated diene monomer unit in an elastomer are hydrogenated, and usually refers to one having a hydrogen addition percentage (hydrogenation percentage) of less than 80% and more than 20%.

Examples of commercially available products of the elastomer (e) used in the present embodiment include SEPTON (trade name) 2104, V9461, and S8104 available from Kuraray Co., Ltd., S.O.E. (trade name) S1606, S1613, S1609, and S1605 available from Asahi Kasei Corporation, TUFTEC (trade name) H1041, H1043, P2000, and MP10 available from Asahi Kasei Corporation, and DYNARON (trade name) 9901P and TR2250 available from JSR Corporation.

The elastomer used in the present embodiment may also be a liquid diene. The liquid diene means a liquid elastomer containing a conjugated diene monomer unit. Examples of the conjugated diene monomer include 1,3-butadiene, 2-methyl-1,3-butadiene (isoprene), 2,3-dimethyl-1,3-butadiene, 1,3-pentadiene, 2-methyl-1,3-pentadiene, 1,3-hexadiene, and Farnesene, 1,3-butadiene and isoprene are preferable, and 1,3-butadiene is more preferable.

Examples of the liquid diene used in the present embodiment include liquid polybutadiene, liquid polyisoprene, a modified product of liquid polybutadiene, a modified product of liquid polyisoprene, a liquid acrylonitrile-butadiene

copolymer, and a liquid styrene-butadiene copolymer.

The number average molecular weight of the liquid diene is not particularly limited as long as it is liquid at 20°C, and is preferably 500 or more or 10000 or less.

When the resin composition of the present embodiment contains an elastomer (preferably, the elastomer (e)), the content thereof is preferably 1 part by mass or more, more preferably 5 parts by mass or more, and still more preferably 8 parts by mass or more, with respect to 100 parts by mass of the resin solid content in the resin composition, and may be 10 parts by mass or more, or 12 parts by mass or more depending on the intended use and the like. When the content is the above lower limit or more, dielectric properties (low dielectric loss tangent) tend to further improve. The upper limit value of the content of the elastomer is preferably 45 parts by mass or less, more preferably 40 parts by mass or less, still more preferably 35 parts by mass or less, yet still more preferably 32 parts by mass or less, and yet still more preferably 28 parts by mass or less, with respect to 100 parts by mass of the resin solid content in the resin composition. When the content is the above upper limit or less, thermal resistance tends to further improve.

The resin composition of the present embodiment may contain only one elastomer or may contain two or more elastomers. When two or more types are contained, the total amount is preferably in the range described above.

In addition, the resin composition in the present embodiment can also be configured to contain substantially no elastomer. The phrase "contain substantially no" means that the content of the elastomer is less than 1 part by mass with respect to 100 parts by mass of the resin solid content in the resin composition, and the content is preferably less than 0.1 parts by mass, and more preferably less than 0.01 parts by mass.

<Styrene-based oligomer>

In the resin composition of the present embodiment, a styrene-based oligomer can be used in combination for improving low permittivity and low dielectric loss tangent. The styrene-based oligomer according to the present embodiment is a compound obtained by polymerizing at least one selected from the group consisting of styrene, a styrene derivative (a-methylstyrene, 3-methylstyrene, 4-propylstyrene, 4-cyclohexylstyrene, and the like), and vinyltoluene, and having a number average molecular weight of from 178 to 1600, an average number of the aromatic rings of from 2 to 14, a total amount of the aromatic rings of from 2 to 14 of 50 mass% or more, and a boiling point of 300°C or higher, and is preferably a compound having no branched structure.

The styrene-based oligomer is typically thermoplastic. Furthermore, the styrene-based oligomer does not have a polymerizable carbon-carbon unsaturated double bond. Therefore, a compound corresponding to the styrene-based oligomer and also corresponding to the compound (B) or the compound (C) is the compound (B) or the compound (C).

Examples of the styrene-based oligomer used in the present embodiment include a styrene polymer, a vinyltoluene polymer, an $\alpha$-methylstyrene polymer, a vinyltoluene-$\alpha$-methylstyrene polymer, and a styrene-a-styrene polymer. For the styrene polymer, a commercially available product may be used, and examples thereof include Piccolastic A5 (available from Eastman Chemical), Piccolastic A-75 (available from Eastman Chemical), Piccotex 75 (available from Eastman Chemical), FTR-8100 (available from Mitsui Chemicals, Inc.), and FTR-8120 (available from Mitsui Chemicals, Inc.). In addition, examples of the vinyltoluene-$\alpha$-methylstyrene polymers include Piccotex LC (available from Eastman Chemical). Furthermore, examples of the $\alpha$-methylstyrene polymers include Crystalex 3070 (available from Eastman Chemical), Crystalex 3085 (available from Eastman Chemical), Crystalex (3100), Crystalex 5140 (available from Eastman Chemical), FMR-0100 (available from Mitsui Chemicals, Inc.), and FMR-0150 (available from Mitsui Chemicals, Inc.). Examples of the styrene-$\alpha$-styrene polymer include FTR-2120 (available from Mitsui Chemicals, Inc.). One type of these styrene-based oligomers may be used alone, or two or more types thereof may be used in combination.

In the resin composition of the present embodiment, an $\alpha$-methylstyrene oligomer is preferable because it is thermally cured well and is excellent in fine wiring embeddability, solder thermal resistance, and low dielectric properties (Dk and/or Df).

In addition, regarding the details of the styrene-based oligomer, reference may be made to paragraphs 0065 to 0067 of WO 2019/230945, the contents of which are incorporated herein by reference.

When the resin composition of the present embodiment contains the styrene-based oligomer, the content thereof is preferably 0.5 parts by mass or more, more preferably 1 part by mass or more, still more preferably 2 parts by mass or more, further preferably 3 parts by mass or more, and may be 5 parts by mass or more, with respect to 100 parts by mass of the resin solid content in the resin composition. When the content is the above lower limit or more, the resulting cured product tends to have further improved low dielectric properties (Dk and/or Df). The upper limit of the content of the styrene-based oligomer is preferably 30 parts by mass or less, more preferably 25 parts by mass or less, still more preferably 20 parts by mass or less, even more preferably 15 parts by mass or less, and further more preferably 10 parts by mass or less, with respect to 100 parts by mass of the resin solid content in the resin composition. When the content is the above upper limit or less, thermal resistance tends to further improve. The low dielectric properties (Dk and/or Df) and chemical resistance of the resulting cured product tend to be further improved.

The resin composition of the present embodiment may contain only one styrene-based oligomer or may contain two or more styrene-based oligomers. When two or more types are contained, the total amount is preferably in the range described above.

<Petroleum resin>

The resin composition of the present embodiment may contain a petroleum resin. The inclusion of the petroleum resin can reduce the melt viscosity.

The petroleum resin is a resin obtained by thermally decomposing petroleum naphtha, collecting a necessary fraction, and polymerizing the remaining component without isolating an unsaturated hydrocarbon, either without a catalyst or in the presence of a catalyst. The remaining fraction is mainly a fraction containing C5 fractions (for example, isoprene, piperylene, cyclopentadiene, pentenes, and pentanes) or C9 fractions (for example, vinyltoluene, indene, and dicyclopentadiene).

Regarding the details of the petroleum resin, reference can be made to the description of paragraphs 0028 to 0037 of WO 2023/027060, the contents of which are incorporated herein by reference.

When the resin composition of the present embodiment contains a petroleum resin, the lower limit of the content thereof is preferably 1 part by mass or more, more preferably 5 parts by mass or more, still more preferably 10 parts by mass or more, yet still more preferably 20 parts by mass or more, and yet still more preferably 25 parts by mass or more, with respect to 100 parts by mass of the resin solid content in the resin composition. When the content is the above lower limit or more, the melt viscosity tends to decrease. The upper limit of the content of the petroleum resin is preferably 70 parts by mass or less, more preferably 50 parts by mass or less, and may be 40 parts by mass or less, with respect to 100 parts by mass of the resin solid content in the resin composition. When the content is the above upper limit or less, Df tends to decrease.

The resin composition in the present embodiment may include only one type of petroleum resin, or may include two or more types thereof. When two or more types are contained, the total amount is preferably in the range described above.

The resin composition in the present embodiment can also be configured to contain substantially no petroleum resin. The phrase "contain substantially no" means that the content of the petroleum resin is less than 1 part by mass with respect to 100 parts by mass of the resin solid content in the resin composition, and the content is preferably less than 0.1 parts by mass, and more preferably less than 0.01 parts by mass.

<Filler>

The resin composition of the present embodiment preferably contains a filler. Containing the filler enables further improvement of physical properties, such as dielectric properties (e.g., low permittivity, low dielectric loss tangent), flame resistance, and low thermal expansion properties of the resin composition and a cured product thereof.

The filler used in the present embodiment more preferably has excellent low dielectric properties (Dk and/or Df). For example, the filler used in the present embodiment has a relative permittivity (Dk) at a frequency of 10 GHz as measured according to a cavity resonator perturbation method of preferably 8.0 or less, more preferably 6.0 or less, and still more preferably 4.0 or less. Furthermore, the lower limit of the relative permittivity is, for example, practically 2.0 or more. The filler used in the present embodiment has a dielectric loss tangent (Df) at a frequency of 10 GHz as measured according to a cavity resonator perturbation method of preferably 0.05 or less, and more preferably 0.01 or less. The lower limit of the dielectric loss tangent is, for example, practically 0.0001 or more.

The type of the filler used in the present embodiment is not particularly limited, and any filler commonly used in the art can be suitably used. Specific examples of the filler include silica such as natural silica, fused silica, synthetic silica, amorphous silica, aerosil, and hollow silica; metal oxides such as alumina, white carbon, titanium white, titanium oxide, zinc oxide, magnesium oxide, and zirconium oxide; composite oxides such as zinc borate, zinc stannate, forsterite, barium titanate, strontium titanate, and calcium titanate; nitrides such as boron nitride, aggregated boron nitride, silicon nitride, and aluminum nitride; metal hydroxides such as aluminum hydroxide, aluminum hydroxide heat treated products (aluminum hydroxide subjected to heat treatment to reduce a part of crystal water), boehmite, and magnesium hydroxide (including hydrates); molybdenum compounds such as molybdenum oxide and zinc molybdate; inorganic fillers such as barium sulfate, clay, kaolin, talc, fired clay, fired kaolin, fired talc, mica, E-glass, A-glass, NE-glass, NER-glass, NEZ-glass, C-glass, L-glass, D-glass, S-glass, M-glass G20, short glass fibers (including fine powders of glass such as E glass, T glass, D glass, S glass, and Q glass), hollow glass, and spherical glass; and organic fillers such as styrene type, butadiene type, and acrylic type rubber powders, core-shell type rubber powders, silicone resin powders, silicone rubber powders, and silicone composite powders.

In the present embodiments, inorganic fillers are preferable, and more preferably the filler includes one or more selected from the group consisting of silica, aluminum hydroxide, talc, aluminum nitride, boron nitride, forsterite, titanium

oxide, barium titanate, strontium titanate, and calcium titanate. From the viewpoint of the low dielectric properties (Dk and/or Df), the filler more preferably contains one or more selected from the group consisting of silica and aluminum hydroxide, and even more preferably contains silica. With the use of these inorganic fillers, the cured product of the resin composition is improved in characteristics such as thermal resistance, dielectric properties, thermal expansion characteristics, dimensional stability, and flame retardancy.

The content of the filler in the resin composition of the present embodiment can be appropriately determined depending on the desired properties, and is not particularly limited. The content is preferably 10 parts by mass or more, more preferably 20 parts by mass or more, still more preferably 40 parts by mass or more, even more preferably 60 parts by mass or more, and further more preferably 80 parts by mass or more, with respect to 100 parts by mass of the resin solid content in the resin composition. When the content is the above lower limit or more, the resulting cured product tends to be more excellent in low thermal expansion property and low dielectric loss tangent. The upper limit of the content of the filler is preferably 1600 parts by mass or less, more preferably 1000 parts by mass or less, still more preferably 500 parts by mass or less, even more preferably 300 parts by mass or less, and further more preferably 250 parts by mass or less, and may be 200 parts by mass or less, or 120 parts by mass or less with respect to 100 parts by mass of the resin solid content. When the content is the above upper limit or less, the moldability of the resin composition tends to be further improved.

In the resin composition according to the present embodiment, an aspect in which the content of the filler is from 1 to 95 mass% of components excluding a solvent is exemplified as an example of a preferred embodiment, and an aspect in which the content of the filler is from 30 mass% to 80 mass% of components excluding a solvent is preferred.

The resin composition of the present embodiment may contain only one type of filler, or may contain two or more types of fillers. When two or more aliphatic polyamide resins are contained, the total amount is preferably in the range described above.

When the filler, in particular, an inorganic filler, is used in the resin composition according to the present embodiments, a silane coupling agent may be further contained. By containing a silane coupling agent, the dispersion of the filler and the adhesive strength between the resin component and the filler and the substrate to be described later tend to be further improved.

The silane coupling agent is not particularly limited, and examples include silane coupling agents commonly used in surface treatment of inorganic materials including aminosilane-based compounds (e.g., such as γ-aminopropyltriethoxysilane, N-β-(aminoethyl)-γ-aminopropyltrimethoxysilane), epoxysilane-based compounds (e.g., such as γ-glycidoxypropyltrimethoxysilane), cationic silane-based compounds (e.g., such as N-β-(N-vinylbenzylaminoethyl)-γ-aminopropyltrimethoxysilane hydrochloride), and phenylsilane-based compounds. One type of the silane coupling agents can be used alone, or two or more types thereof can be used in combination.

The content of the silane coupling agent is not particularly limited, but may be from 0.1 to 5.0 parts by mass relative to 100 parts by mass of the resin solid content.

<Curing accelerator>

The resin composition of the present embodiment may further contain a curing accelerator.

The curing accelerator is not particularly limited, and examples thereof include imidazoles such as 2-ethyl-4-methylimidazole, 2-phenyl-4-methylimidazole, and triphenylimidazole; organic peroxides such as benzoyl peroxide, lauroyl peroxide, acetyl peroxide, parachlorobenzoyl peroxide, di-tert-butyl-di-perphthalate α,α'-di(t-butylperoxy)diisopropylbenzene, 2,5-dimethyl-2,5-di(t-butylperoxy) hexane, and 2,5-dimethyl-2,5-bis(t-butylperoxy)hexine-3; azo compounds such as azobisnitriles; tertiary amines such as N,N-dimethylbenzylamine, N,N-dimethylaniline, N,N-dimethyltoluidine, 2-N-ethylanilinoethanol, tri-n-butylamine, pyridine, quinoline, N-methylmorpholine, triethanolamine, triethylenediamine, tetramethylbutanediamine, and N-methylpiperidine; phenols such as phenol, xylenol, cresol, resorcin, and catechol; high-temperature decomposition type radical generator such as 2,3-dimethyl-2,3-diphenylbutane; organometallic salts such as lead naphthenate, lead stearate, zinc naphthenate, zinc octylate, manganese octylate, tin oleate, dibutyltin malate, manganese naphthenate, cobalt naphthenate, and iron acetylacetonate; those formed by dissolving these organometallic salts in hydroxyl group-containing compounds such as phenol and bisphenol; inorganic metal salts such as tin chloride, zinc chloride, and aluminum chloride; and organotin compounds such as dioctyl tin oxide, other alkyl tins, and alkyl tin oxides. Among them, preferred curing accelerators are imidazoles, organometallic salts, and organic peroxides, and imidazoles and organic peroxides are more preferred.

When the resin composition of the present embodiment contains the curing accelerator, the lower limit of the content of the curing accelerator is preferably 0.005 parts by mass or more, more preferably 0.01 parts by mass or more, and still more preferably 0.1 parts by mass or more, with respect to 100 parts by mass of the resin solid content in the resin composition. The upper limit of the content of the curing accelerator is preferably 10 parts by mass or less, more preferably 5 parts by mass or less, still more preferably 3 parts by mass or less, yet still more preferably 2 parts by mass or less, yet still more preferably 1.5 parts by mass or less, yet still more preferably 1.0 parts by mass or less, yet still more preferably 0.8 parts by mass or less, and particularly preferably 0.7 parts by mass or less, with respect to 100 parts by mass of the resin

solid content in the resin composition. The resin composition of the present embodiment is preferred in that the resin composition can be sufficiently cured even when the content of the curing accelerator is 0.8 parts by mass or less.

One type of the curing accelerators can be used alone, or two or more types thereof may be used in combination. When two or more are used, the total amount is in the above range.

<Flame retardant>

The resin composition of the present embodiment may contain a flame retardant. Examples of the flame retardant include a phosphorus-based flame retardant, a halogen-based flame retardant, an inorganic flame retardant, and a silicone-based flame retardant, and the phosphorus-based flame retardant is preferred.

A known flame retardant can be used as the flame retardant, and examples thereof include: halogen-based flame retardants such as a brominated epoxy resin, brominated polycarbonate, brominated polystyrene, brominated styrene, brominated phthalimide, tetrabromobisphenol A, pentabromobenzyl(meth)acrylate, pentabromotoluene, tribromophenol, hexabromobenzene, decabromodiphenyl ether, bis-1,2-pentabromophenylethane, chlorinated polystyrene, and chlorinated paraffin; phosphorus-based flame retardants such as red phosphorus, tricresyl phosphate, triphenyl phosphate, cresyl diphenyl phosphate, trixylenyl phosphate, trialkyl phosphate, dialkyl phosphate, tris(chloroethyl)phosphate, phosphazene, 1,3-phenylene bis(2,6-dixylenyl phosphate), and 10-(2,5-dihydroxyphenyl)-10H-9-oxa-10-phosphaphenanthrene-10-oxide; inorganic flame retardants such as aluminum hydroxide, magnesium hydroxide, partial boehmite, boehmite, zinc borate, and antimony trioxide; and silicone-based flame retardants such as silicone rubber and a silicone resin.

In the present embodiment, of these, 1,3-phenylene bis(2,6-dixylenyl phosphate) does not impair the low dielectric properties (Dk and/or Df) and thus is preferred.

When the resin composition of the present embodiment contains a flame retardant, the content thereof is preferably 1 part by mass or more, more preferably 5 parts by mass or more, and still more preferably 10 parts by mass or more, and may be 15 parts by mass or more, with respect to 100 parts by mass of the resin solid content in the resin composition. The lower limit of the content of the flame retardant is preferably 30 parts by mass or less, and more preferably 25 parts by mass or less, with respect to 100 parts by mass of the resin solid content in the resin composition.

One type of the flame retardants can be used alone, or two or more types thereof can be used in combination. When two or more are used, the total amount is in the above range.

<Active ester compound>

The resin composition of the present embodiment may contain an active ester compound within a range that does not impair the effects of the present invention. The active ester compound is not particularly limited, and for example, reference can be made to the description of paragraphs [0064] to [0066] of WO 2021/172317, the content of which is incorporated herein by reference.

When the resin composition of the present embodiment contains the active ester compound, the content of the active ester compound is preferably 1 part by mass or more and preferably 50 parts by mass or less, with respect to 100 parts by mass of the resin solid content in the resin composition.

The resin composition of the present embodiment may contain only one type of active ester compound or may contain two or more types of active ester compounds. When two or more types are contained, the total amount is preferably in the range described above.

The resin composition of the present embodiment can also be configured to contain substantially no active ester compound. The phrase "contain substantially no" means that the content of the active ester compound is less than 1 part by mass with respect to 100 parts by mass of the resin solid content in the resin composition, and the content is preferably less than 0.1 parts by mass, and more preferably less than 0.01 parts by mass.

<Dispersant>

The resin composition of the present embodiment may contain a dispersant. A dispersant commonly used in paints can be suitably used, and the type of the dispersant is not particularly limited. As the dispersant, a copolymer-based wet dispersant is preferably used, and specific examples thereof include DISPERBYK (trade name) -110, 111, 161, 180, 2009, 2152, and 2155, and BYK (trade name) -W996, W9010, W903, and W940, all of which are available from BYK Japan KK.

When the resin composition of the present embodiment contains a dispersant, the lower limit of the content thereof is preferably 0.01 parts by mass or more, more preferably 0.1 parts by mass or more, and may be 0.3 parts by mass or more, with respect to 100 parts by mass of the resin solid content in the resin composition. Furthermore, the upper limit of a content of the dispersant is preferably 10 parts by mass or less, and more preferably 5 parts by mass or less, and may be 3

parts by mass or less, with respect to 100 parts by mass of the resin solid content in the resin composition.

One type of the dispersants may be used alone, or two or more types thereof may be used in combination. When two or more are used, the total amount is in the above range.

<Solvent>

The resin composition of the present embodiment may contain a solvent and preferably contains an organic solvent. When the resin composition of the present embodiment contains a solvent, the resin composition is in a form (of solution or varnish) in which at least some, or preferably all of the various resin solid contents described aforementioned are dissolved or homogeneously mixed in the solvent. The solvent is not particularly limited as long as it is a polar organic solvent or non-polar organic solvent capable of dissolving or homogeneously mixing at least some, or preferably all of the various resin solid contents described above; examples of the polar organic solvent include ketones (for example, acetone, methyl ethyl ketone, methyl isobutyl ketone, and cyclohexanone), cellosolves (for example, propylene glycol monomethyl ether and propylene glycol monomethyl ether acetate), esters (for example, ethyl lactate, methyl acetate, ethyl acetate, butyl acetate, isoamyl acetate, ethyl lactate, methyl methoxypropionate, and methyl hydroxyisobutyrate), and amides (for example, dimethoxy acetamide and dimethylformamide); and examples of the non-polar organic solvent include aromatic hydrocarbon atoms (for example, toluene and xylene).

One type of the solvents can be used alone, or two or more types thereof can be used in combination. When two or more are used, the total amount is in the above range.

<Other components>

The resin composition of the present embodiment may contain various polymer compounds such as thermoplastic resins and oligomers thereof, various additives, and the like other than the above-described components. Examples of the additive include ultraviolet absorbers, antioxidants, photopolymerization initiators, fluorescent whitening agents, photosensitizers, dyes, pigments, thickeners, flow control agents, lubricants, antifoaming agents, leveling agents, brighteners, and polymerization inhibitors. One type of these additives can be used alone, or two or more types thereof can be used in combination.

The content of components (various polymer compounds such as thermoplastic resins and oligomers thereof, various additives, and the like) other than the above-described components in the resin composition of the present embodiment is preferably 0 parts by mass or more and less than 10 parts by mass, more preferably 0 parts by mass or more and less than 5 parts by mass, still more preferably 0 parts by mass or more and less than 3 parts by mass, and may be 0 parts by mass or more and less than 1 part by mass, with respect to 100 parts by mass of the resin solid content.

The content (total amount) of the additive is preferably 0 parts by mass or more and less than 5 parts by mass, more preferably 0 parts by mass or more and less than 3 parts by mass, still more preferably 0 parts by mass or more and less than 1 part by mass, and may be 0 parts by mass or more and less than 0.5 parts by mass, with respect to 100 parts by mass of the resin solid content.

Examples of the polymerization inhibitor include quinone, a phenol-based polymerization inhibitor, nitroso, hydroxylamine, an organic boric acid compound, and a compound having a phenolic hydroxyl group. Specific examples thereof include 2-nitrophenol, 4-methoxyphenol, 4-tert-butylpyrocatechol, pyrogallol, 4,4'-butylidene bis(6-tert-butyl-m-cresol), tert-butylhydroquinone, 1,4-benzoquinone, 2-hydroxybenzophenone, cuprous chloride, phenothiazine, chloranil, naphthylamine, β-naphthol, 2,6-di-t-butyl-4-cresol, 2,2'-methylene bis(4-methyl-6-t-butylphenol), pyridine, nitrobenzene, dinitrobenzene, picric acid, 4-toluidine, methylene blue, copper-organic chelating agent reaction product, methyl salicylate, dibutylhydroxytoluene, 1,1-diphenyl-2-picrylhydrazyl free radical, hydroquinone, hydroquinone monomethyl ether, mequinol, N-nitroso-N-phenylhydroxylamine aluminum, triethyl borate, tributyl borate, triisopropyl borate, 2,3-dihydroxynaphthalene, 4-methoxy-1-naphthol, and methylhydroquinone. In addition, the polymerization inhibitor to be used is not limited only to those described above.

When the resin composition of the present embodiment contains the polymerization inhibitor, the content thereof is preferably 0.001 parts by mass or more, more preferably 0.01 parts by mass or more, still more preferably 0.02 parts by mass or more, and even more preferably 0.04 parts by mass or more, and is preferably 10 parts by mass or less, more preferably 3 parts by mass or less, still more preferably 1 part by mass or less, even more preferably 0.5 parts by mass or less, and further more preferably 0.2 parts by mass or less, with respect to 100 parts by mass of the resin solid content. When the content is the above lower limit or more, the low dielectric properties (Dk and/or Df, in particular, Df) of the resulting cured product after heating for a long period of time tend to be further improved. When the content is the above upper limit or less, the resulting cured product tends to have improved low dielectric properties (Dk and/or Df) and thermal resistance.

The resin composition of the present embodiment may include only one type of polymerization inhibitor, or may include two or more types thereof. When two or more types are contained, the total amount is preferably in the range

described above.

<Application>

The resin composition of the present embodiment is used as a cured product. Specifically, the resin composition of the present embodiment can be suitably used as a low relative permittivity material and/or a low dielectric loss tangent material, and as a resin composition for an electronic material, such as an insulating layer of a printed wiring board or a material for a semiconductor package. The resin composition of the present embodiment can be suitably used as a material for a prepreg, a metal foil-clad laminate including the prepreg, a resin composite sheet, and a printed wiring board.

The cured product of the resin composition of the present embodiment preferably has a low relative permittivity (Dk) and a low dielectric loss tangent (Df). Specifically, when the resin composition is molded into a cured plate (without metal foil) having a thickness of 1.0 mm, the relative permittivity (Dk) at a frequency of 10 GHz as measured according to a cavity resonator perturbation method is preferably less than 2.4. The lower limit of the relative permittivity (Dk) is not particularly determined but is, for example, practically 0.01 or more. When the resin composition is molded into a cured plate (without metal foil) having a thickness of 1.0 mm, the dielectric loss tangent (Df) at a frequency of 10 GHz as measured according to a cavity resonator perturbation method is preferably 0.0020 or less. The lower limit of the dielectric loss tangent (Df) is not particularly specified, but is practically at least 0.0001, for example.

In addition, the dielectric loss tangent (Df) at a frequency of 10 GHz as measured according to the cavity resonator perturbation method after molding into a cured plate (without metal foil) having a thickness of 1.0 mm and heating at 130°C for 150 hours is preferably 0.0040 or less, and more preferably 0.0030 or less.

The relative permittivity (Dk) and the dielectric loss tangent (Df) of the cured plate are, more specifically, measured according to methods which will be described in Examples below.

The resin composition of the present embodiment is used in the form of a layered material (intended to include a film-like or sheet-like material), such as a prepreg or a resin composite sheet serving as an insulating layer of a printed wiring board. When the resin composition is formed into such a layered material, the thickness of the layered material is preferably 5 μm or more, and more preferably 10 μm or more. The upper limit of the thickness is preferably 200 μm or less and more preferably 180 μm or less. The thickness of the layered material means, for example, a thickness including a glass cloth when the glass cloth or such is impregnated with the resin composition of the present embodiment.

The material formed from the resin composition of the present embodiment may be used in an application to form a pattern by exposure and development or may be used in an application not involving exposure and development. In particular, the material is suitable for an application not involving exposure and development.

<<Prepreg>>

A prepreg of the present embodiment is formed from a substrate (prepreg substrate) and the resin composition of the present embodiment. The prepreg of the present embodiment is produced by, for example, applying the resin composition of the present embodiment to a substrate (for example, impregnating and/or coating the substrate with the resin composition) and then semi-curing the resin composition by heating (for example, by a method of drying at 120 to 220°C for 2 to 15 minutes). In this case, the amount of the resin composition adhered to the substrate, that is, the amount of the resin composition (including the filler) relative to the total amount of the prepreg after semi-curing is preferably in a range of 20 to 99 mass% and more preferably in a range of 20 to 80 mass%.

The substrate is not particularly limited as long as it is a substrate used in various printed wiring board materials. Examples of the material of the substrate include glass fibers (for example, such as E-glass, D-glass, L-glass, S-glass, T-glass, Q-glass, UN-glass, NE-glass, NER-glass, NEZ-glass, and spherical glass), inorganic fibers other than glass (for example, such as quartz), and organic fibers (for example, such as polyimide, polyamide, polyester, liquid crystal polyester, and polytetrafluoroethylene). The form of the substrate is not particularly limited, and examples include woven fabrics, nonwoven fabrics, rovings, chopped strand mats, and surfacing mats. One type of the substrates may be used alone, or two or more types thereof may be used in combination. Among these substrates, from the viewpoint of dimensional stability, the substrate is preferably a woven fabric subjected to ultra fiber opening and fine weaving; from the viewpoints of strength and low water absorption, the substrate is preferably a glass woven fabric with a thickness of 200 μm or less and a mass of 250 $g/m^2$ or less; and from the viewpoint of moisture-absorbability/thermal resistance, the substrate is preferably a glass woven fabric surface-treated with a silane coupling agent or the like, such as an epoxy silane or an aminosilane. From the viewpoint of electrical properties, the substrate is more preferably a low relative dielectric glass cloth made of a glass fiber, such as a glass fiber of L-glass, NE-glass, NER-glass, NEZ-glass, or Q-glass, achieving a low relative permittivity and a low dielectric loss tangent.

The low relative permittivity substrate is exemplified by a substrate with a relative permittivity of 5.0 or less (preferably from 3.0 to 4.9). The low dielectric loss tangent substrate is exemplified by a substrate with a dielectric loss tangent of 0.006 or lower (preferably from 0.001 to 0.005). The relative permittivity and the dielectric loss tangent are defined as the values obtained by measurement at a frequency of 10 GHz by the cavity resonator based on the perturbation method.

<<Metal foil-clad laminate>>

The metal foil-clad laminate of the present embodiment includes at least one layer formed from the prepreg of the present embodiment, and a metal foil disposed on one surface or both surfaces of the layer formed from the prepreg. Examples of the method for producing a metal foil-clad laminate of the present embodiment include a method of disposing at least one prepreg (preferably stacking two or more prepregs) of the present embodiment, disposing a metal foil on one or both sides of the prepreg, and laminate-molding the metal foil and the prepreg. More specifically, the metal foil-clad laminate can be produced by disposing a metal foil of copper, aluminum, or the like on one side or both sides of the prepreg, and laminate-molding the metal foil and the prepreg. The number of prepregs is preferably from 1 to 10, more preferably from 2 to 10, and still more preferably from 2 to 9.

The metal foil is any metal foil used in materials for printed wiring boards and is not particularly limited, but examples include a copper foil, such as a rolled copper foil and an electrolytic copper foil. The thickness of the metal foil (preferably a copper foil) is not particularly limited and may be approximately from 1.5 to 70 μm. When a copper foil is used as the metal foil, as the copper foil, roughness Rz of a copper foil surface as measured in accordance with JIS B 0601: 2013 is adjusted to from 0.2 to 4.0 μm. When the copper foil surface roughness Rz is 0.2 μm or more, the roughness of the copper foil surface is adjusted to a suitable level, and the copper foil peel strength tends to be further improved. On the other hand, with the roughness Rz of the copper foil surface being 4.0 μm or less, the roughness of the copper foil surface becomes an appropriate level, and the dielectric loss tangent properties of the resulting cured product tend to further improve. From the viewpoint of reducing the dielectric loss tangent, the copper foil surface roughness Rz is more preferably 0.5 μm or more, still more preferably 0.6 μm or more, particularly preferably 0.7 μm or more, and is more preferably 3.5 μm or less, still more preferably 3.0 μm or less, particularly preferably 2.0 μm or less.

Examples of the laminate-molding method include methods commonly used in molding a laminate and a multilayer board for a printed wiring board, and more specific examples include a method of laminate-molding using a multi-stage press, a multi-stage vacuum press, a continuous molding machine, an autoclave molding machine, or the like at a temperature of approximately 180 to 350°C, a heating time of approximately 100 to 300 minutes, and a surface pressure of approximately 1 to 10 MPa. In addition, the prepreg of the present embodiment is combined and laminate-molded with a separately produced wiring board for an inner layer and can also be formed into a multilayer board. In a method for producing a multilayer board, a multilayer board can be produced, for example, by disposing copper foils of approximately 35 μm on both sides of one prepreg of the present embodiment, laminate-molding them by the molding method described above, then forming an inner layer circuit, subjecting the inner layer circuit to a blackening treatment to form an inner layer circuit board, then alternately disposing the inner layer circuit board and the prepreg of the present embodiment one by one, and further disposing a copper foil on the outermost layer, followed by lamination molding under the conditions above preferably under vacuum. The metal foil-clad laminate of the present embodiment can be suitably used as a printed wiring board.

The metal foil-clad laminate of the present embodiment has a peel strength of preferably 0.28 kN/m or more, more preferably 0.38 kN/m or more, and even more preferably 0.50 kN/m or more as measured in accordance with 5.7 "Peel Strength" specified in JIS C6481. The upper limit of the peel strength is not particularly limited, and for example, even if the peel strength is 2.00 kN/m or less, the required performance is sufficiently satisfied.

As described above, in the resin composition for an electronic material obtained using the resin composition of the present embodiment (resin composition including a combination of specific components), the cured product thereof can have characteristics excellent in thermal resistance, desmear resistance, crack resistance, appearance of the cured product, and low thermal expansion property in addition to the low dielectric properties (low permittivity, low dielectric loss tangent, in particular low permittivity), the moisture-absorbability/thermal resistance, and the peel strength to the metal foil.

<<Printed wiring board>>

A printed wiring board of the present embodiment is a printed wiring board including an insulating layer and a conductor layer disposed on the surface of the insulating layer, and the insulating layer includes at least one of a layer formed from the resin composition of the present embodiment or a layer formed from the prepreg of the present embodiment. Such a printed wiring board can be produced by a common method, and the production method is not particularly limited. An example of the method for producing the printed wiring board is described below. First, the metal foil-clad laminate, such as the copper foil-clad laminate, described above is prepared. Next, the surface of the metal foil-clad laminate is subjected to an etching treatment to form an inner layer circuit, and an inner layer substrate is produced. The inner layer circuit surface of the inner layer substrate is subjected to surface treatment to increase the adhesive strength as necessary, then a required number of the prepregs described above are layered on the inner layer circuit surface, a metal foil for an outer layer circuit is further laminated on the outer side, and the laminate is heated, pressurized, and integrally molded. A multilayer laminate is thus produced with an insulating layer composed of a substrate and a cured product of the resin composition formed between the inner layer circuit and the metal foil for the outer layer circuit. Then, the multilayer

laminate is subjected to a drilling process for a through hole or a via hole, and then a plated metal film, for electrically connecting the inner layer circuit and the metal foil for the outer layer circuit, is formed on the wall surfaces of the holes. Further, the metal foil for the outer layer circuit is subjected to an etching treatment to form the outer layer circuit, thereby producing a printed wiring board.

The printed wiring board produced in the aforementioned producing example is configured to include an insulating layer and a conductor layer formed on the surface of the insulating layer, in which the insulating layer is configured to contain the resin composition of the present embodiment described above and/or the cured product thereof. That is, the prepreg of the present embodiment described above (for example, a prepreg formed from a substrate and the resin composition of the present embodiment impregnated into or applied onto the substrate) and the layer formed from the resin composition on the metal foil-clad laminate of the present embodiment described above serve as the insulating layer of the present embodiment.

The present embodiment also relates to a semiconductor device including the printed wiring board. For details of the semiconductor device, reference can be made to the description of paragraphs 0200 to 0202 of JP 2021-021027 A, the contents of which are incorporated herein by reference.

In the insulating layer formed of the cured product of the resin composition of the present embodiment, it is preferable to reduce the surface roughness of the insulating layer after roughening treatment. Specifically, the arithmetic average roughness Ra of the surface of the insulating layer after the roughening treatment is preferably 200 nm or less, more preferably 150 nm or less, and particularly preferably 100 nm or less. The lower limit of the arithmetic average roughness Ra is not particularly limited, and may be, for example, 10 nm or more. The arithmetic average roughness Ra of the surface of the insulating layer is measured using a non-contact type surface roughness meter, a VSI mode, and a lens with a magnification of 50.

As the non-contact type surface roughness meter, WYKONT3300 available from Beacon Instruments is used.

<<Resin composite sheet>>

A resin composite sheet of the present embodiment includes a layer including a support and the resin composition of the present embodiment disposed on a surface of the support. The resin composite sheet can be used as a build-up film or a dry film solder resist. The method for producing the resin composite sheet is not particularly limited, and examples include a method in which a solution obtained by dissolving the resin composition of the present embodiment in a solvent is coated (applied) to a support and dried to obtain a resin composite sheet.

Examples of the support used herein include, but are not particularly limited to, organic-based film substrates, such as polyethylene films, polypropylene films, polycarbonate films, poly(ethylene terephthalate) films, ethylene-tetrafluoroethylene copolymer films, as well as release films formed by coating a surface of such a film with a release agent, and polyimide films; conductive foils, such as copper foils and aluminum foils; and plate-like supports, such as glass plates, steel use stainless (SUS) plates, and fiber-reinforced plastics (FRPs).

For example, the application method (coating method) involves application of a solution prepared by dissolving the resin composition of the present embodiment in a solvent onto a support by using a bar coater, a die coater, a doctor blade, or a Baker applicator. In addition, a monolayer sheet can also be formed by peeling or etching the support after drying from the resin composite sheet in which the support and the resin composition are laminated. A monolayer sheet can also be produced without using a support by, for example, feeding a solution prepared by dissolving the resin composition of the present embodiment in a solvent into a mold having a sheet-shaped cavity and drying the solution to mold into a sheet shape.

In the production of the monolayer sheet or the resin composite sheet of the present embodiment, the drying conditions for removing the solvent are not particularly limited. However, drying at a low temperature is likely to cause the solvent to remain in the resin composition, and drying at a high temperature allows the curing of the resin composition to proceed. Thus, the drying is preferably performed at a temperature from 20°C to 200°C for from 1 to 90 minutes. The monolayer sheet or resin composite sheet can be used in an uncured state where the solvent is only dried or can be used as necessary in a semi-cured (B-staged) state. Further, the thickness of the resin layer in the monolayer sheet or resin composite sheet of the present embodiment can be adjusted by the concentration of the solution of the resin composition used for coating (application) of the present embodiment and the coating thickness, and is not particularly limited. However, in general, as the coating thickness increases, the solvent is likely to remain during drying, and thus the thickness is preferably from 0.1 to 500 μm.

Examples

Hereinafter, the present invention will be described more specifically with reference to Examples. Materials, amounts used, proportions, processing details, and processing procedures described in the following Examples can be appropriately changed without departing from the spirit of the present invention. Thus, the scope of the present invention is

not limited to the specific examples described below.

When it is difficult to obtain a measuring instrument or the like used in Examples because of discontinuation or the like, another instrument with equivalent performance can be used for the measurements.

<Measurement of weight average molecular weight and number average molecular weight>

The weight average molecular weight (Mw) and the number average molecular weight (Mn) of the compound (including the resin) were measured by a gel permeation chromatography (GPC) method. The measurement was conducted using a liquid feed pump (LC-20AD available from Shimadzu Corporation), a differential refractive index detector (RID-20A available from Shimadzu Corporation), and GPC columns (GPC KF-801, 802, 803, 804, available from Showa Denko K.K.), and also using tetrahydrofuran as a solvent, at a flow rate of 1.0 mL/min, a column temperature of 40°C, and a calibration curve based on monodispersed polystyrene.

<Measurement of parameters α and β>

The parameters α and β in the resin (A) were calculated by $^1$H-NMR measurement. The synthesized resin was dissolved in a mixed solvent of heptane and methanol and repeatedly dried to remove a residual solvent contained in a recovered solid. Thereafter, the recovered solid was dissolved in $CDCl_3$ (containing 0.03 vol% of TMS (tetramethylsilane)), and $^1$H-NMR measurement was performed. The parameters α and β of each resin were calculated using the following formula in the measured $^1$H-NMR. A peak position of TMS (tetramethylsilane) was set to 0 ppm.

As an apparatus, NMR AVANCE NEO500 available from Bruker was used.

[Num.4]

$$\text{PARAMETER } \alpha = \frac{(2.55\text{ ppm to }2.31\text{ ppm})}{(6.24\text{ ppm to }5.91\text{ ppm}) + (2.98\text{ ppm to }2.55\text{ ppm})/2 + (2.55\text{ ppm to }2.31\text{ ppm})} \quad (\alpha)$$

$$\text{PARAMETER } \beta = \frac{\{(5.49\text{ ppm to }4.89\text{ ppm}) - (4.89\text{ ppm to }4.45\text{ ppm})\}\times 1.5}{(2.31\text{ ppm to }1.96\text{ ppm}) - (2.55\text{ ppm to }2.31\text{ ppm})} \quad (\beta)$$

(Expressions in parentheses in Equations (α) and (β) indicate integral values between corresponding chemical shift values in $^1$H-NMR.)

<Synthesis Example 1 Synthesis of resin (A) having terminal group represented by Formula (T1) and having indane skeleton>

A flask equipped with a thermometer and a cooling tube was charged with 520 g of toluene, 0.75 g of activated clay, 150 g of 1,3-diisopropenylbenzene (available from Tokyo Chemical Industry), and a stirring bar, and the mixture was heated to an internal temperature of 50°C while being stirred. Thereafter, the mixture was gradually heated to an internal temperature of 70°C over 5 hours, and further reacted at an internal temperature of 70°C for 1 hour. After cooling, the activated clay was removed by filtration, and the solvent was distilled off with heating under reduced pressure to produce 129 g of a solid resin. An NMR chart of the produced resin is illustrated in FIG. 1.

The produced resin (A) had Mw of 1193, Mn of 693, and Mw/Mn of 1.7. In Formula (Tx), the parameter α was 0.63, the parameter β was 1.07, and n + o + p was 3.4. The structures in parentheses represented by (a), (b), and (c) in Formula (Tx) all had the same molecular weight, and n + o + p was calculated assuming that the Mn of the synthesized resin was the average molecular weight. It was confirmed that the amount of the residual monomer was 1 mass% or less through GPC analysis. The functional group equivalent (isopropenyl group equivalent) of the obtained resin (A) was 324 g/eq.

The functional group equivalent (g/eq.) of the resin (A) was calculated from (number average molecular weight (Mn) ÷ 2) ÷ β.

<Synthesis Example 2 Polyphenylene ether compound (B1) having carbon-carbon unsaturated double bond at terminal>

<<Synthesis of bifunctional phenylene ether oligomer>>

A 12 L vertically long reactor equipped with a stirrer, a thermometer, an air introduction tube, and a baffle plate was charged with 1.81 g (11 mmol) of N,N'-di-t-butylethylenediamine of 9.36 g (42 mmol) of $CuBr_2$ (copper bromide), 67.8 g (670 mmol) of n-butyldimethylamine, and 2600 g of toluene, and the mixture was stirred at an internal temperature of 40°C.

To this, a mixed solution of 129.3 g (0.48 mol) of 2,2',3,3',5,5'-hexamethyl-(1,1'-biphenyl)-4,4'-diol previously dissolved in 2300 g of methanol, 878 g (7.2 mol) of 2,6-dimethylphenol, 1.22 g (7.2 mmol) of N,N'-di-t-butylethylenediamine, and 26.4 g (261 mmol) of n-butyldimethylamine was added dropwise over 230 minutes while bubbling a mixed gas obtained by mixing nitrogen and air and adjusting the oxygen concentration to 8% at a flow rate of 5.2 L/min, and the resulting mixture was stirred at a reaction temperature of 40°C.

After completion of the dropwise addition, 1500 g of water in which 48.1 g (130 mmol) of tetrasodium ethylenediaminetetraacetate had been dissolved was added to stop the reaction. The aqueous layer and the organic layer were separated from each other, and the organic layer was washed with 1 M aqueous hydrochloric acid solution and then with pure water. The obtained solution was concentrated to 50 mass% with an evaporator to obtain 1980 g of a toluene solution A1 of a phenylene ether resin. The toluene solution A had a number average molecular weight of 1975 measured by the GPC method calibrated with polystyrene standards, a weight average molecular weight of 3514 by the GPC method calibrated with polystyrene standards, and a hydroxyl group equivalent of 990 g/eq.

<<Synthesis of modified polyphenylene ether compound>>

A reactor equipped with a stirrer, a thermometer, and a reflux tube was charged with 833 g of the toluene solution A1 of the phenylene ether resin obtained above, 76.7 g (0.50 mol) of vinylbenzyl chloride ("CMS-P" available from AGC Seimi Chemical Co., Ltd.), 1600 g of methylene chloride, 6.20 g (0.046 mol) of benzyldimethylamine, 200 g of pure water, and 84 g of a 30.5 mass% NaOH aqueous solution, and the mixture was stirred at a reaction temperature of 40°C. After stirring for 24 hours, the organic layer was washed with a 1 M aqueous hydrochloric acid solution followed by pure water. The resulting solution was concentrated, and added dropwise to methanol to solidify the solution. The solid was collected by filtration, and vacuum-dried to obtain 450 g of a polyphenylene ether compound (B1) mainly composed of a compound represented by Formula (OP-15).

The number average molecular weight measured by the GPC method calibrated with polystyrene standards was 2250, the weight average molecular weight by the GPC method calibrated with polystyrene standards was 3920, the double bond equivalent of the vinyl group was 1189 g/eq., and the hydroxyl group equivalent was 56250 g/eq.

Example 1

30 parts by mass of the resin (A) obtained in Synthesis Example 1, 60 parts by mass of a maleimide compound (ma) ("NE-X-9470S" available from DIC Corporation, functional group equivalent (maleimide group equivalent) was 450 g/eq.) having the following structure, and 10 parts by mass of a mixture of m-divinylbenzene and p-divinylbenzene (available from Tokyo Chemical Industry Co., Ltd., functional group equivalent (vinyl group equivalent) was 65 g/eq.) were dissolved in methyl ethyl ketone and toluene and mixed to obtain a varnish. The content of each component described above indicates a value in terms of solid content.

Maleimide compound (ma)

[Chem.127]

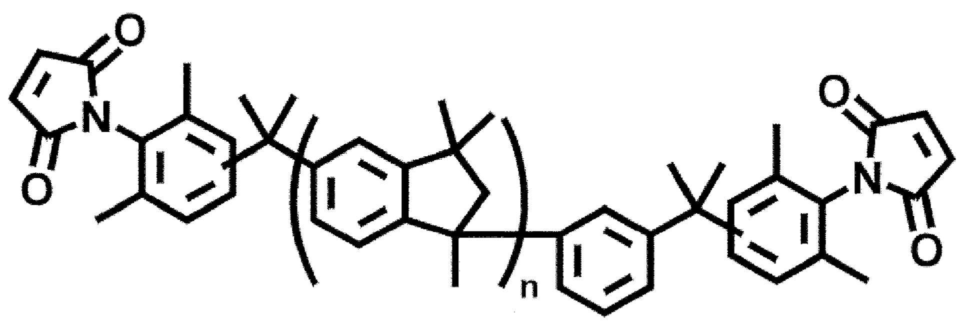

<Production of test piece of cured plate with thickness of 1.0 mm>

The solvent was distilled off by evaporation from the resulting varnish, and a powder of the resin composition was obtained. Using the obtained resin composition powder, a cured plate was prepared as follows. 4.5 g of the resin composition powder was spread in a stainless steel mold of 100 mm × 30 mm × 1.0 mm high frame, set in a vacuum press machine (available from KITAGAWA SEIKI CO., LTD.), held at 200°C for 1.5 hours, and pressed at a surface pressure of 1.9 MPa.

Using the obtained cured plate, the moldability, the relative permittivity (Dk), the dielectric loss tangent (Df), and the dielectric loss tangent (Df) after heating were evaluated. The evaluation results are presented in Tables 1 and 2.

<Methods of measurement and evaluation>

(1) Moldability

The moldability was evaluated as follows.
Using the obtained cured plate, the cured plate was downsized to a width of 1.0 mm, and then dried at 120°C for 60 minutes.

A: The product could be molded, and was not deformed even under a drying condition of 120°C for 60 minutes.
B: Although the product could be molded, the product was deformed under the drying condition of 120°C for 60 minutes, and the characteristics could not be evaluated.
C: The product was broken and could not be molded.

(2) Relative permittivity (Dk) and dielectric loss tangent (Df)

Among the samples evaluated for moldability, the sample evaluated as A was used as it was, and the relative permittivity (Dk) and the dielectric loss tangent (Df) at a frequency of 10 GHz were measured using a perturbation method cavity resonator. The measurement temperature was 23°C. Evaluation was made as follows:

(Dk)

A: less than 2.40
B: 2.40 or more

(Df)

A: 0.0020 or less
B: greater than 0.0020

The sample after the measurement of dielectric properties was heated at 130°C for 150 hours, and then the dielectric loss tangent (Df) at a frequency of 10 GHz was measured. Evaluation was made as follows:
(Df (after 150 hours))

A: 0.0030 or lower
B: more than 0.0030 and 0.0040 or less
C: more than 0.0040

As the cavity resonator based on the perturbation method, P5005A available from Keysite Technologies was used.

Example 2

The same procedure as in Example 1 was carried out, except that the content of the maleimide compound (ma) was 55 parts by mass and the content of divinylbenzene was 15 parts by mass, in Example 1.

Example 3

The same procedure as in Example 1 was carried out, except that the maleimide compound (ma) was not blended, the content of the polyphenylene ether compound (B1) having a carbon-carbon unsaturated double bond at a terminal, which was obtained in Synthesis Example 2, was 65 parts by mass, and the content of divinylbenzene was 5 parts by mass, in Example 1.

Example 4

The same procedure as in Example 1 was carried out, except that the content of the resin (A) obtained in

Synthesis Example 1 was 35 parts by mass, the maleimide compound (ma) was not blended, the content of the maleimide compound (the compound represented by Formula (M4), available from K·I Chemical Industry Co., LTD., BMI-70, functional group equivalent (maleimide group equivalent) was 221 g/eq.) was 14 parts by mass, divinylbenzene was not blended, the content of the modified polyphenylene ether compound (available from SABIC Innovative Plastics, SA9000, functional group equivalent (double bond equivalent of vinyl group) was 1011 g/eq.) having a methacrylic group at a terminal was 21 parts by mass, the content of 1,2-bis(4-vinylphenyl)ethane (BVPE: available from Angene International Ltd.) was 30 parts by mass, and the content of perbutyl P ($\alpha,\alpha'$-di(t-butylperoxy)diisopropylbenzene, available from NOF CORPORATION) was 0.5 parts by mass, in Example 1.

Example 5

The same procedure as in Example 1 was carried out, except that the content of the resin (A) obtained in Synthesis Example 1 was 60 parts by mass, the maleimide compound (ma) was not blended, the content of the maleimide compound (the compound represented by Formula (M4), available from K·I Chemical Industry Co., LTD., BMI-70, functional group equivalent (maleimide group equivalent) was 221 g/eq.) was 36 parts by mass, divinylbenzene was not blended, the content of acenaphthylene (available from Tokyo Chemical Industry Co., Ltd.) was 4 parts by mass, and the content of manganese octylate (available from NIHON KAGAKU SANGYO CO., LTD.) was 0.05 parts by mass, in Example 1.

Example 6

The same procedure as in Example 1 was carried out, except that the content of the resin (A) obtained in Synthesis Example 1 was 56 parts by mass, the maleimide compound (ma) was not blended, the content of the maleimide compound (the compound represented by Formula (M4), available from K·I Chemical Industry Co., LTD., BMI-70, functional group equivalent (maleimide group equivalent) was 221 g/eq.) was 33 parts by mass, divinylbenzene was not blended, the content of 4-methylstyrene (available from Tokyo Chemical Industry Co., Ltd.) was 11 parts by mass, and the content of manganese octylate (available from NIHON KAGAKU SANGYO CO., LTD.) was 0.05 parts by mass, in Example 1.

Example 7

The same procedure as in Example 1 was carried out, except that the content of the resin (A) obtained in Synthesis Example 1 was 30 parts by mass, the content of the maleimide compound (ma) was 65 parts by mass, divinylbenzene was not blended, and the content of triallyl isocyanurate (available from Nihon Kasei CO., LTD., molecular weight: 249.7, number of terminal double bonds: 3) was 5 parts by mass, in Example 1.

Example 8

The same procedure as in Example 1 was carried out, except that the content of the resin (A) obtained in Synthesis Example 1 was 30 parts by mass, the content of the maleimide compound (ma) was 65 parts by mass, divinylbenzene was not blended, and the content of N-phenylmaleimide (available from Tokyo Chemical Industry Co., Ltd.) was 5 parts by mass, in Example 1.

Example 9

The same procedure as in Example 1 was carried out, except that the content of the resin (A) obtained in Synthesis Example 1 was 30 parts by mass, the content of the maleimide compound (ma) was 65 parts by mass, divinylbenzene was not blended, and the content of t-butylstyrene (available from Tokyo Chemical Industry Co., Ltd.) was 5 parts by mass, in Example 1.

Comparative Example 1

The same procedure as in Example 1 was carried out, except that the content of the maleimide compound (ma) was 70 parts by mass and divinylbenzene was not blended, in Example 1.

Comparative Example 2

The same procedure as in Example 1 was carried out, except that the content of the resin (A) was 80 parts by

mass, the maleimide compound (ma) was not blended, and the content of divinylbenzene was 20 parts by mass, in Example 1.

Comparative Example 3

The same procedure as in Example 1 was carried out, except that the content of the resin (A) was 85 parts by mass, the maleimide compound (ma) was not blended, and the content of divinylbenzene was 15 parts by mass, in Example 1.

Comparative Example 4

The same procedure as in Example 1 was carried out, except that the resin (A) was not blended, and the content of the maleimide compound (ma) was 90 parts by mass, in Example 1.

[Table 1]

| | Example 1 | Example 2 | Example 3 | Comparative Example 1 | Comparative Example 2 | Comparative Example 3 | Comparative Example 4 |
|---|---|---|---|---|---|---|---|
| Moldability | A | A | A | A | C | C | A |
| Dk @ 10 GHz | A | A | A | B | - | - | B |
| Df @ 10 GHz | A | A | A | B | - | - | B |
| Df(150 hr) @ 10 GHz | A | A | A | C | - | - | B |

[Table 2]

| | Example 4 | Example 5 | Example 6 | Example 7 | Example 8 | Example 9 |
|---|---|---|---|---|---|---|
| Moldability | A | A | A | A | A | A |
| Dk @ 10 GHz | A | A | A | A | A | A |
| Df @ 10 GHz | A | A | A | A | A | A |
| Df (150 hr) @ 10 GHz | A | A | A | A | A | A |

## Claims

**1.** A resin composition comprising:

a resin (A) having a terminal group represented by Formula (T1) and having an indane skeleton;
a compound (B) having a polymerizable carbon-carbon unsaturated double bond and having a number average molecular weight of 400 or less; and
a thermosetting compound (C) having a number average molecular weight of more than 400, the compound (B) and the compound (C) not being compounds corresponding to the resin (A),

[Chem.1]

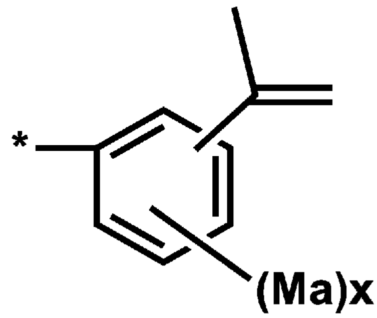

(T1)

(where each Ma independently represents a hydrocarbon group having 1 to 12 carbon atoms, each carbon atom being optionally substituted with a halogen atom, and x represents an integer of from 0 to 4, * represents a bonding position for another moiety.)

**2.** The resin composition according to claim 1, wherein the resin (A) includes a resin represented by Formula (T1-1):

[Chem.2]

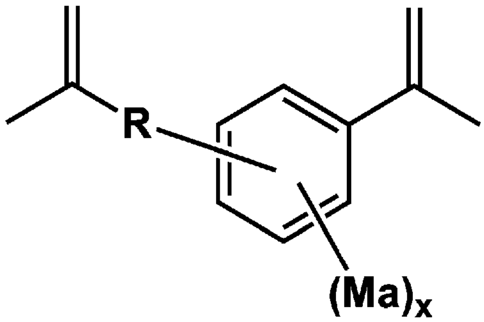

(T1-1)

(where R is a group including a structural unit represented by Formula (Tx), each Ma independently represents a hydrocarbon group having from 1 to 12 carbon atoms, each carbon atom being optionally substituted with a halogen atom, and x is an integer of from 0 to 4.)

[Chem.3]

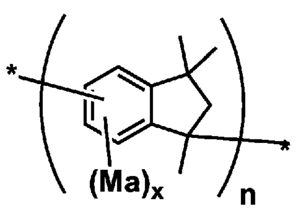

(a)

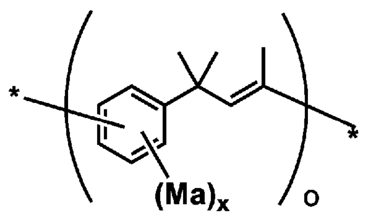

(b)

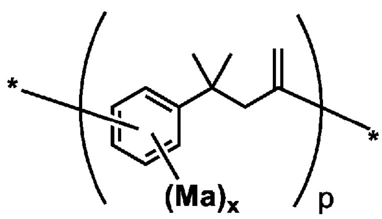

(c)

(Tx)

(where n, o, and p are average numbers of repeating units, n represents a number of more than 0 and 20 or less, o and p each independently represent a number of from 0 to 20, and $1.0 \leq n + o + p \leq 20.0$, each Ma independently represents a hydrocarbon group having from 1 to 12 carbon atoms, each carbon atom being optionally substituted with a halogen atom, x represents an integer of from 0 to 4, the structural units (a), (b), and (c) are each bonded at * to the structural unit (a), (b), or (c), or an additional group, and structural units are optionally randomly bonded.)

**3.** The resin composition according to claim 1 or 2, wherein an equivalent of the polymerizable carbon-carbon unsaturated double bond of the compound (B) is from 50 to 400 g/eq.

**4.** The resin composition according to claim 1 or 2, wherein the number average molecular weight of the compound (B) is

from 100 to 400, and the number of polymerizable carbon-carbon unsaturated double bonds in one molecule of the compound (B) is 1 or 2.

**5.** The resin composition according to claim 1 or 2, wherein the polymerizable carbon-carbon unsaturated double bond in the compound (B) is at least one selected from the group consisting of a vinyl group, a (meth)allyl group, a (meth) acryloyl group, a vinylene group, and a maleimide group.

**6.** The resin composition according to claim 1 or 2, wherein the compound (B) includes at least one selected from the group consisting of divinylbenzene, acenaphthylene, dicyclopentadiene type bifunctional (meth)acrylate, 1,2-bis(4-vinylphenyl)ethane, 4-tert-butylstyrene, and 4-methylstyrene.

**7.** The resin composition according to claim 1 or 2, wherein the compound (C) is a compound having a number average molecular weight of more than 400 and includes at least one selected from the group consisting of a maleimide compound, a polymer having a structural unit represented by Formula (V), a polyphenylene ether compound having a carbon-carbon unsaturated double bond at a terminal, an epoxy compound, a phenolic compound, a benzoxazine compound, and a cyanate ester compound,

[Chem.4]

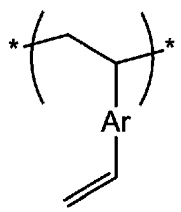

(V)

(where Ar represents an aromatic hydrocarbon linking group; and * represents a bonding position.)

**8.** The resin composition according to claim 1 or 2, wherein the compound (C) is a compound having a number average molecular weight of more than 400 and includes at least one selected from the group consisting of a maleimide compound, a polymer having a structural unit represented by Formula (V), a polyphenylene ether compound having a carbon-carbon unsaturated double bond at a terminal, an epoxy compound, a phenolic compound, a benzoxazine compound, a cyanate ester compound, and a polyfunctional (meth)acrylate compound other than the polyphenylene ether compound having a carbon-carbon unsaturated double bond at a terminal,

[Chem.5]

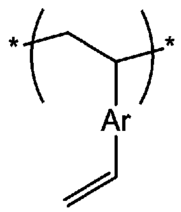

(V)

(where Ar represents an aromatic hydrocarbon linking group; and and * represents a bonding position.)

**9.** The resin composition according to claims 1 or 2, wherein the compound (C) is a compound having a number average molecular weight of more than 400 and includes at least one selected from the group consisting of a compound represented by Formula (M0), a compound represented by Formula (M1), a compound represented by Formula (M3), a compound represented by Formula (M4), a compound represented by Formula (M5), a polymer having a structural unit represented by Formula (V), and a compound represented by Formula (OP):

[Chem.6]

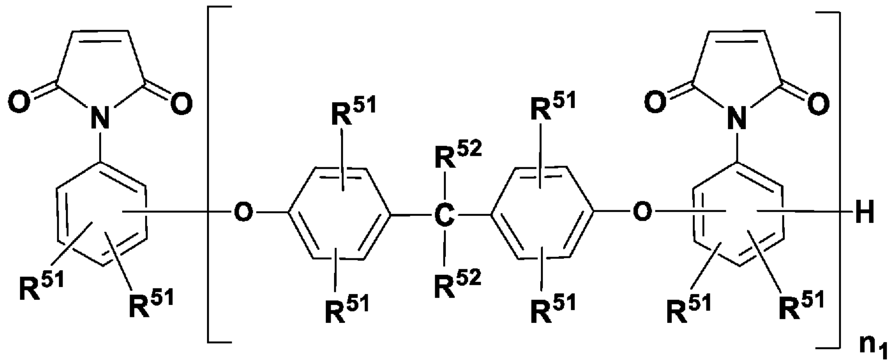

(M0)

(where each $R^{51}$ independently represents a hydrogen atom, an alkyl group having from 1 to 8 carbon atoms, or a phenyl group; each $R^{52}$ independently represents a hydrogen atom or a methyl group; and $n_1$ represents an integer of 1 or more.)

[Chem.7]

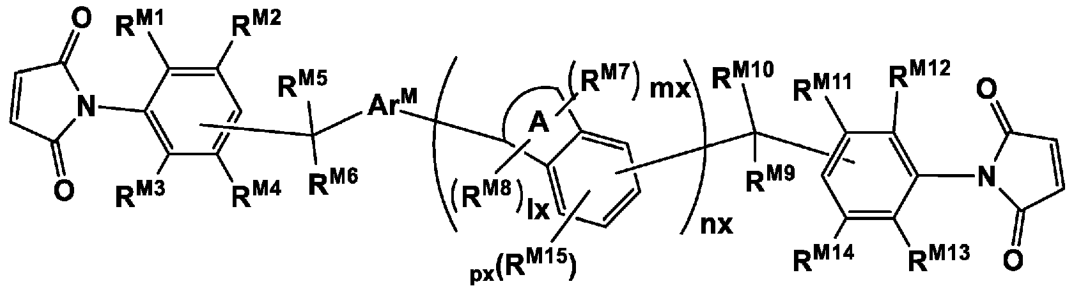

(M1)

(where $R^{M1}$, $R^{M2}$, $R^{M3}$, and $R^{M4}$ each independently represent a hydrogen atom or an organic group, $R^{M5}$ and $R^{M6}$ each independently represent a hydrogen atom or an alkyl group, $Ar^M$ represents a divalent aromatic group, A is a four- to six-membered alicyclic group, $R^{M7}$ and $R^{M8}$ are each independently an alkyl group, mx is 1 or 2, and lx is 0 or 1, $R^{M9}$ and $R^{M10}$ each independently represent a hydrogen atom or an alkyl group, $R^{M11}$, $R^{M12}$, $R^{M13}$, and $R^{M14}$ each independently represent a hydrogen atom or an organic group, each $R^{M15}$ independently represents an alkyl group having from 1 to 10 carbon atoms, an alkyloxy group having from 1 to 10 carbon atoms, an alkylthio group having from 1 to 10 carbon atoms, a cycloalkyl group having from 3 to 10 carbon atoms, an aryl group having from 6 to 10 carbon atoms, an aryloxy group having from 6 to 10 carbon atoms, an arylthio group having from 6 to 10 carbon atoms, a halogen atom, a hydroxyl group, or a mercapto group, px represents an integer of from 0 to 3, nx represents an integer of from 1 to 20.)

[Chem.8]

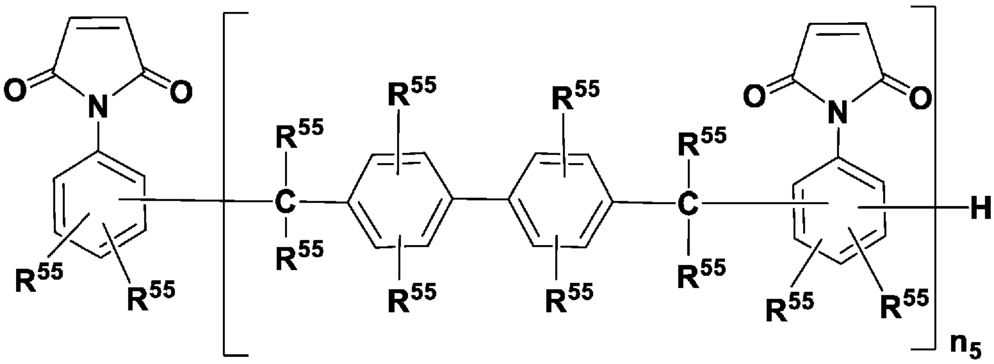

(M3)

(where each $R^{55}$ independently represents a hydrogen atom, an alkyl group having from 1 to 8 carbon atoms, or a

phenyl group; and $n_5$ represents an integer of 1 or more and 10 or less.)

[Chem.9]

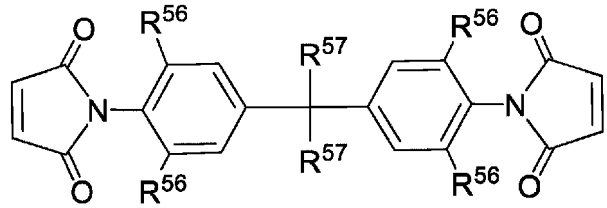

(M4)

(where each $R^{56}$ independently represents a hydrogen atom, a methyl group, or an ethyl group, and each $R^{57}$ independently represents a hydrogen atom or a methyl group.)

[Chem.10]

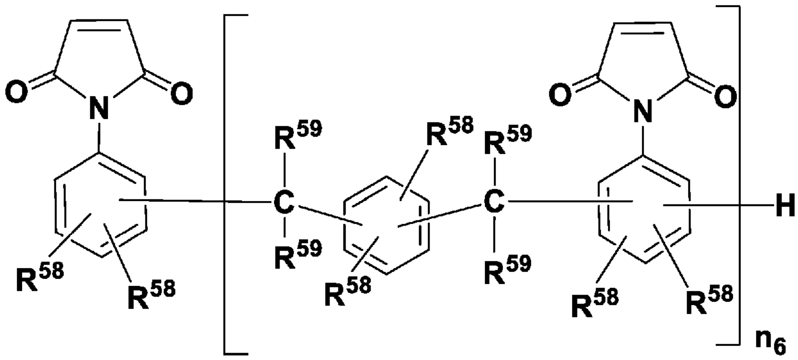

(M5)

(where each $R^{58}$ independently represents a hydrogen atom, an alkyl group having from 1 to 8 carbon atoms, or a phenyl group; each $R^{59}$ independently represents a hydrogen atom or a methyl group; and $n_6$ represents an integer of 1 or more.)

[Chem.11]

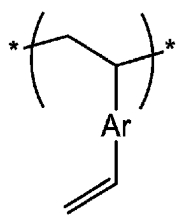

(V)

(where Ar represents an aromatic hydrocarbon linking group, and * represents a bonding position.)

[Chem.12]

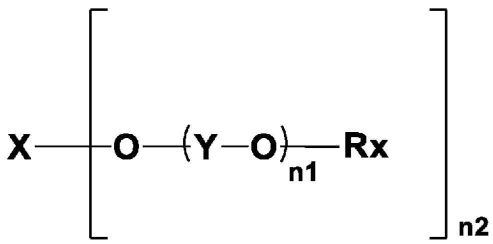

(OP)

(where X represents an aromatic group; $-(Y-O)_{n1}-$ represents a polyphenylene ether structure; n1 represents an

integer of from 1 to 100; n2 represents an integer of from 1 to 4; and Rx is a group represented by Formula (Rx-1) or Formula (Rx-2).)

[Chem.13]

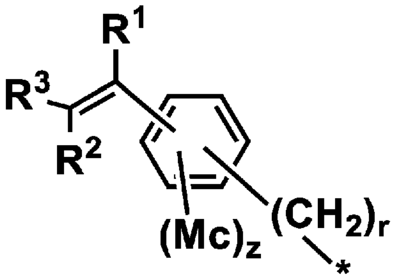

(Rx-1)

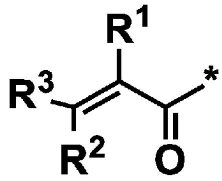

(Rx-2)

(where $R^1$, $R^2$, and $R^3$ each independently represent a hydrogen atom, an alkyl group, an alkenyl group, or an alkynyl group, * is a bonding position for an oxygen atom, each Mc independently represents a hydrocarbon group having from 1 to 12 carbon atoms, z represents an integer of from 0 to 4, and r represents an integer of from 0 to 6.)

**10.** The resin composition according to claim 1 or 2, wherein with respect to 100 parts by mass of the resin (A), from 5 to 500 parts by mass of the compound (B) and from 10 to 1000 parts by mass of the compound (C) are included.

**11.** The resin composition according to claim 1, wherein the resin (A) includes a resin represented by Formula (T1-1),

an equivalent of the polymerizable carbon-carbon unsaturated double bond of the compound (B) is from 50 to 400 g/eq.,
the number average molecular weight of the compound (B) is from 100 to 400,
the number of polymerizable carbon-carbon unsaturated double bonds in one molecule of the compound (B) is 1 or 2,
the compound (C) is a compound having a number average molecular weight of more than 400 and includes at least one selected from the group consisting of a maleimide compound, a polymer having a structural unit represented by Formula (V), a polyphenylene ether compound having a carbon-carbon unsaturated double bond at a terminal, an epoxy compound, a phenolic compound, a benzoxazine compound, and a cyanate ester compound, and
with respect to 100 parts by mass of the resin (A), from 5 to 500 parts by mass of the compound (B) and from 10 to 1000 parts by mass of the compound (C) are included,

[Chem.14]

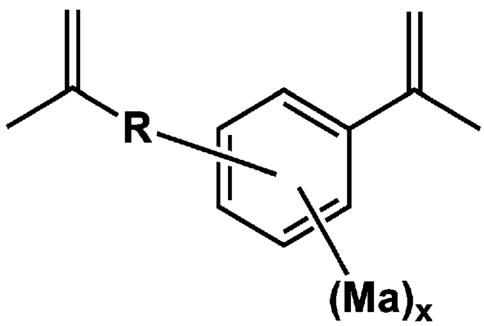

(T1-1)

(where R is a group including a structural unit represented by Formula (Tx), each Ma independently represents a hydrocarbon group having from 1 to 12 carbon atoms, each carbon atom being optionally substituted with a halogen atom, and x is an integer of from 0 to 4.)

[Chem.15]

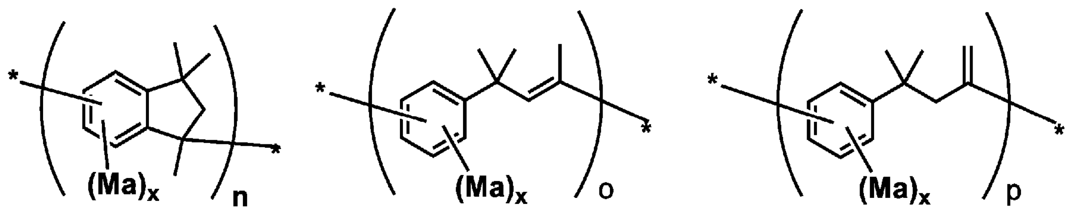

(Tx)

(a) (b) (c)

(where n, o, and p are average numbers of repeating units, n represents a number of more than 0 and 20 or less, o and p each independently represent a number of from 0 to 20, and $1.0 \leq n + o + p \leq 20.0$, each Ma independently represents a hydrocarbon group having from 1 to 12 carbon atoms, each carbon atom being optionally substituted with a halogen atom, x represents an integer of from 0 to 4, the structural units (a), (b), and (c) are each bonded at * to the structural unit (a), (b), or (c), or an additional group, and structural units are optionally randomly bonded.)

[Chem.16]

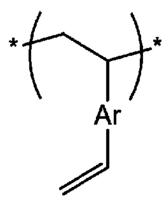

(V)

(where Ar represents an aromatic hydrocarbon linking group; and and * represents a bonding position.)

**12.** The resin composition according to claim 11, wherein the compound (B) includes at least one selected from the group consisting of divinylbenzene, acenaphthylene, dicyclopentadiene type bifunctional (meth)acrylate, 1,2-bis(4-vinylphenyl)ethane, 4-tert-butylstyrene, and 4-methylstyrene.

**13.** The resin composition according to claim 11, wherein the compound (C) is a compound having a number average molecular weight of more than 400 and includes at least one selected from the group consisting of a compound represented by Formula (M0), a compound represented by Formula (M1), a compound represented by Formula (M3), a compound represented by Formula (M4), a compound represented by Formula (M5), a polymer having a structural unit represented by Formula (V), and a compound represented by Formula (OP):

[Chem.17]

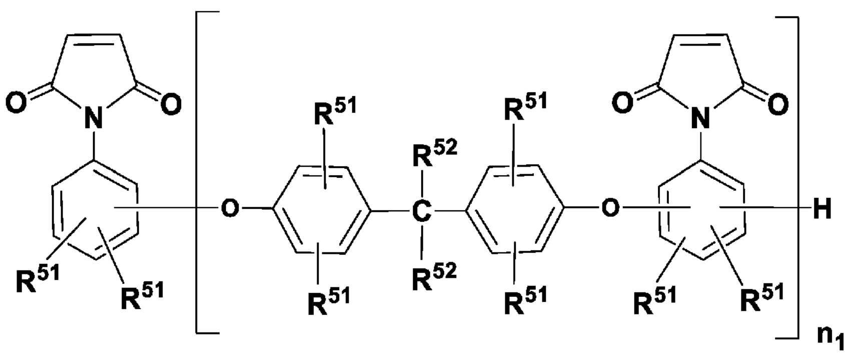

(M0)

(where each $R^{51}$ independently represents a hydrogen atom, an alkyl group having from 1 to 8 carbon atoms, or a phenyl group; each $R^{52}$ independently represents a hydrogen atom or a methyl group; and $n_1$ represents an integer of 1 or more.)

[Chem.18]

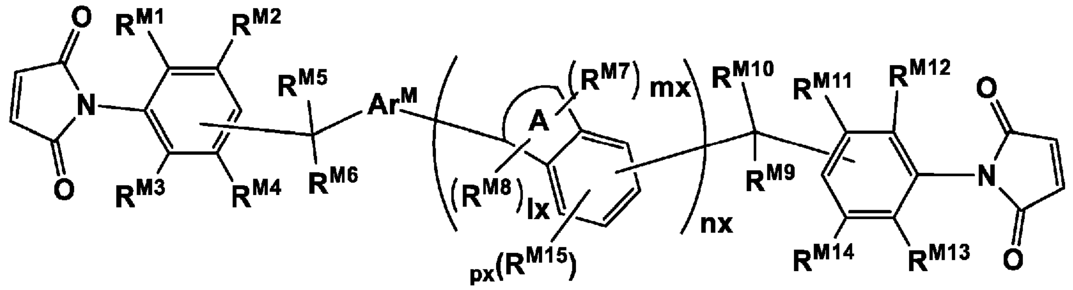

(M1)

(where $R^{M1}$, $R^{M2}$, $R^{M3}$, and $R^{M4}$ each independently represent a hydrogen atom or an organic group, $R^{M5}$ and $R^{M6}$ each independently represent a hydrogen atom or an alkyl group, $Ar^M$ represents a divalent aromatic group, A is a four- to six-membered alicyclic group, $R^{M7}$ and $R^{M8}$ are each independently an alkyl group, mx is 1 or 2, and lx is 0 or 1, $R^{M9}$ and $R^{M10}$ each independently represent a hydrogen atom or an alkyl group, $R^{M11}$, $R^{M12}$, $R^{M13}$, and $R^{M14}$ each independently represent a hydrogen atom or an organic group, each $R^{M15}$ independently represents an alkyl group having from 1 to 10 carbon atoms, an alkyloxy group having from 1 to 10 carbon atoms, an alkylthio group having from 1 to 10 carbon atoms, a cycloalkyl group having from 3 to 10 carbon atoms, an aryl group having from 6 to 10 carbon atoms, an aryloxy group having from 6 to 10 carbon atoms, an arylthio group having from 6 to 10 carbon atoms, a halogen atom, a hydroxyl group, or a mercapto group, px represents an integer of from 0 to 3, and nx represents an integer of from 1 to 20.)

[Chem.19]

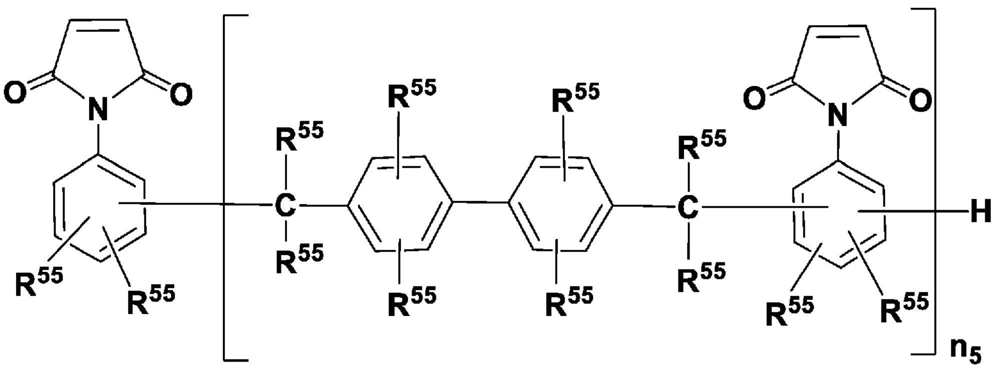

(M3)

(where each $R^{55}$ independently represents a hydrogen atom, an alkyl group having from 1 to 8 carbon atoms, or a phenyl group; and $n_5$ represents an integer of 1 or more and 10 or less.)

[Chem.20]

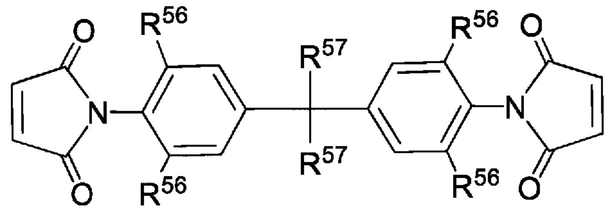

(M4)

(where each $R^{56}$ independently represents a hydrogen atom, a methyl group, or an ethyl group, and each $R^{57}$ independently represents a hydrogen atom or a methyl group.)

[Chem.21]

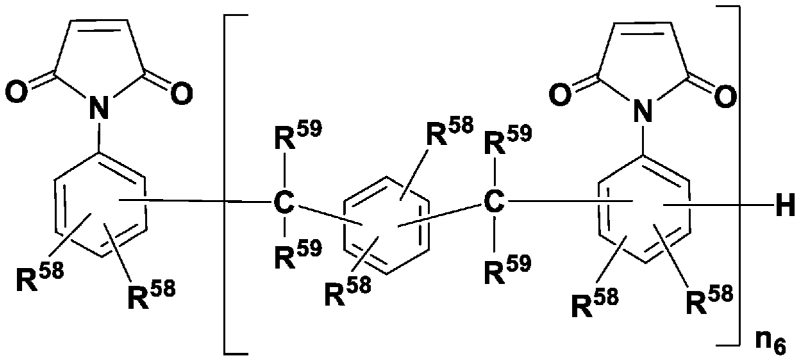

(M5)

(where each $R^{58}$ independently represents a hydrogen atom, an alkyl group having from 1 to 8 carbon atoms, or a phenyl group; each $R^{59}$ independently represents a hydrogen atom or a methyl group; and $n_6$ represents an integer of 1 or more.)

[Chem.22]

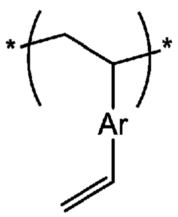

(V)

(where Ar represents an aromatic hydrocarbon linking group, and * represents a bonding position.)

[Chem.23]

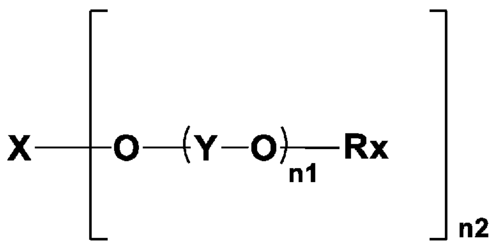

(OP)

(where X represents an aromatic group; $-(Y-O)_{n1}-$ represents a polyphenylene ether structure; n1 represents an integer of from 1 to 100; n2 represents an integer of from 1 to 4; and Rx is a group represented by Formula (Rx-1) or Formula (Rx-2).)

[Chem.24]

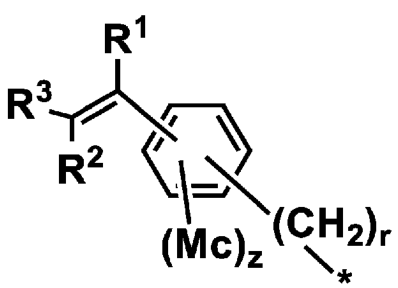

(Rx-1)

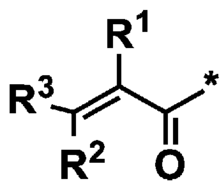

(Rx-2)

(where $R^1$, $R^2$, and $R^3$ each independently represent a hydrogen atom, an alkyl group, an alkenyl group, or an alkynyl group, * is a bonding position for an oxygen atom, each Mc independently represents a hydrocarbon group having from 1 to 12 carbon atoms, z represents an integer of from 0 to 4, and r represents an integer of from 0 to 6.)

**14.** The resin composition according to claim 1, 2, 11, 12, or 13, further comprising an elastomer.

**15.** The resin composition according to claim 1, 2, 11, 12, or 13, further comprising a flame retardant.

**16.** The resin composition according to claim 1, 2, 11, 12, or 13, further comprising a filler.

**17.** The resin composition according to claim 16, wherein a content of the filler is from 10 to 1600 parts by mass with respect to 100 parts by mass of a resin solid content in the resin composition.

**18.** The resin composition according to claim 1, 2, 11, 12, or 13, further comprising a curing accelerator.

**19.** The resin composition according to claim 18, wherein a content of the curing accelerator is from 0.1 to 0.8 parts by mass with respect to 100 parts by mass of a resin solid content in the resin composition.

**20.** A cured product of the resin composition described in claim 1, 2, 11, 12, or 13.

**21.** A prepreg formed from:

a substrate; and
the resin composition described in claim 1, 2, 11, 12, or 13.

**22.** A metal foil-clad laminate comprising:

at least one layer formed from the prepreg described in claim 21; and
a metal foil disposed on one surface or both surfaces of the layer formed from the prepreg.

**23.** A resin composite sheet comprising:

a support; and
a layer disposed on a surface of the support, the layer being formed from the resin composition described in claim 1, 2, 11, 12, or 13.

**24.** A printed wiring board comprising:

an insulating layer; and
a conductor layer disposed on a surface of the insulating layer,
wherein the insulating layer includes a layer formed from the resin composition described in claim 1, 2, 11, 12, or 13.

**25.** A semiconductor device comprising the printed wiring board described in claim 24.

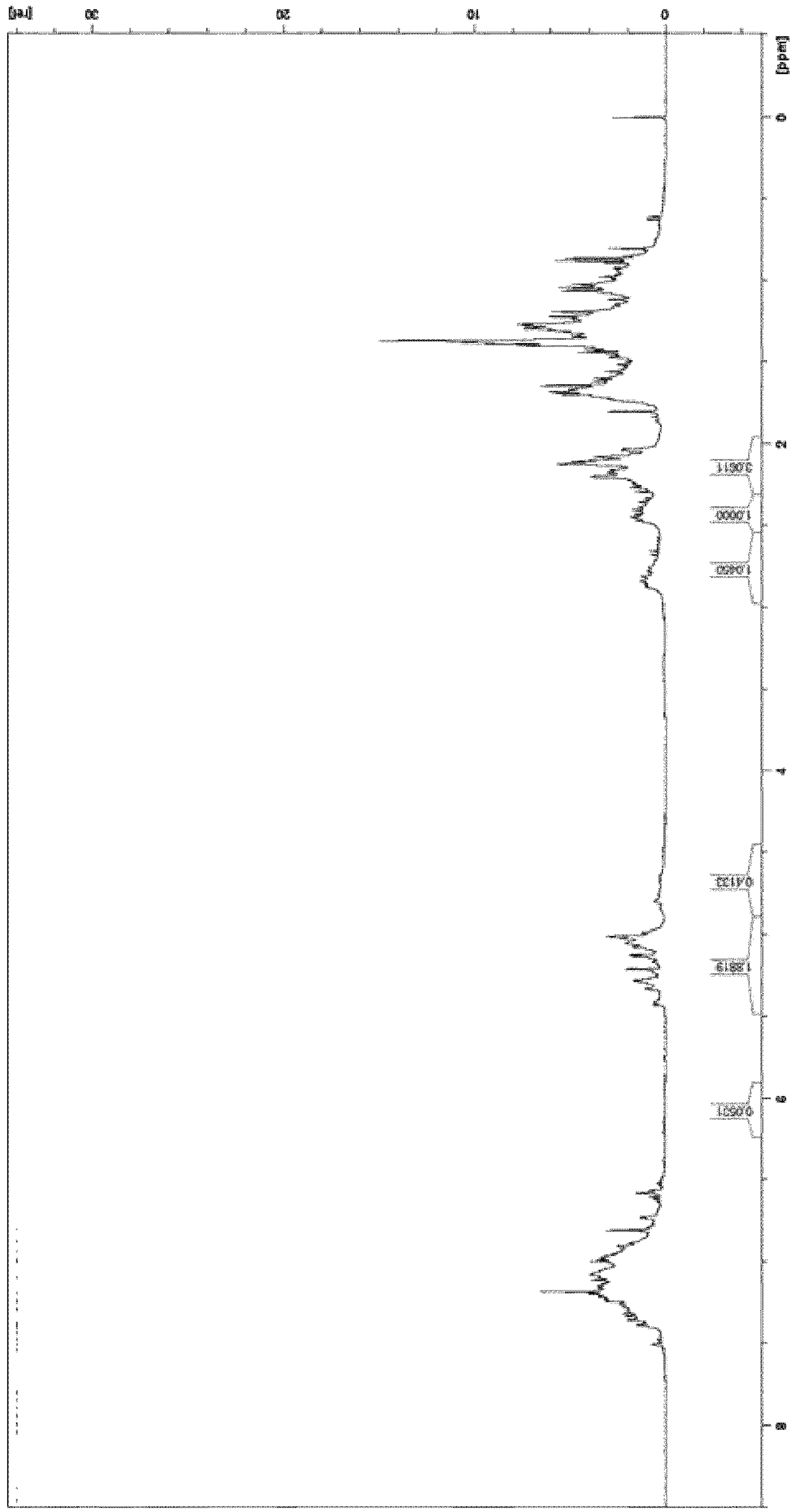

FIG. 1

## INTERNATIONAL SEARCH REPORT

International application No.
**PCT/JP2024/032726**

**A. CLASSIFICATION OF SUBJECT MATTER**

***C08F 290/06***(2006.01)i; ***B32B 15/08***(2006.01)i; ***B32B 27/30***(2006.01)i; ***C08F 257/00***(2006.01)i; ***C08G 65/48***(2006.01)i; ***C08J 5/24***(2006.01)i; ***C08L 25/02***(2006.01)i; ***C08L 101/00***(2006.01)i; ***H05K 1/03***(2006.01)i
FI: C08F290/06; B32B15/08 Q; B32B27/30 Z; C08F257/00; C08G65/48; C08J5/24 CEZ; C08L25/02; C08L101/00; H05K1/03 610H; H05K1/03 630H

According to International Patent Classification (IPC) or to both national classification and IPC

**B. FIELDS SEARCHED**

Minimum documentation searched (classification system followed by classification symbols)

C08F290/06; B32B15/08; B32B27/30; C08F257/00; C08G65/48; C08J5/24; C08L25/02; C08L101/00; H05K1/03

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| X | JP 2023-87627 A (DIC CORPORATION) 23 June 2023 (2023-06-23) claims, paragraphs [0062]-[0080], [0088]-[0091], [0094], table 1, examples 6-9 | 1-5, 7-8, 10-11, 14-25 |
| Y | | 9, 13 |
| A | | 6, 12 |
| Y | JP 2021-143333 A (NIPPON KAYAKU KABUSHIKI KAISHA) 24 September 2021 (2021-09-24) claims, paragraphs [0001], [0008], [0068], table 1, example 5 | 9, 13 |
| A | JP 59-145207 A (MITSUI TOATSU CHEMICALS, INC.) 20 August 1984 (1984-08-20) entire text | 1-25 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **19 November 2024** | **26 November 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | <br>Telephone No. |

Form PCT/ISA/210 (second sheet) (July 2022)

**INTERNATIONAL SEARCH REPORT**
**Information on patent family members**

International application No.
**PCT/JP2024/032726**

| Patent document cited in search report | Publication date (day/month/year) | Patent family member(s) | Publication date (day/month/year) |
|---|---|---|---|
| JP 2023-87627 A | 23 June 2023 | (Family: none) | |
| JP 2021-143333 A | 24 September 2021 | (Family: none) | |
| JP 59-145207 A | 20 August 1984 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2021143333 A
- WO 2023176766 A
- WO 2023176763 A
- WO 2023176765 A
- JP 2023104785 A
- JP 2024007493 A
- JP 2019194312 A
- WO 2020217679 A
- WO 2020262577 A
- JP 7160151 B
- WO 2017115813 A
- JP 2018039995 A
- JP 2018168347 A
- JP 2006070136 A
- JP 2006089683 A
- JP 2008248001 A
- JP 2006028111 A
- JP 2018131519 A
- WO 2019138992 A
- WO 2022054303 A
- JP 2024110099 A
- JP 2022180443 A
- JP 2022180444 A
- JP 2023009587 W
- JP 6951829 B
- WO 2022210095 A
- JP 6962507 B
- JP 2022085610 A
- WO 2022014599 A
- WO 2021100658 A
- JP 2024086554 A
- WO 2017126469 A
- WO 2019230945 A
- WO 2023027060 A
- WO 2021172317 A
- JP 2021021027 A